# EUROPEAN PATENT SPECIFICATION

(11) **EP 4 130 009 B1**
(45) Date of publication and mention of the grant of the patent: **27.08.2025**
(21) Application number: 21774403.6
(22) Date of filing: 25.02.2021
(51) Int. Cl.: C09K 11/06, C07F 15/06, C07F 1/08, C07F 15/04, F21Y 115/10, G02B 5/20, F21V 9/30, F21V 9/38, G02F 1/13357, H05B 33/12, H05B 33/14, C07F 5/02, C08K 5/098, G02B 5/22, H10K 59/38, H10K 85/30, H10K 85/60, H10H 20/851

(54) **COLOR CONVERSION COMPOSITION, COLOR CONVERSION FILM, LIGHT SOURCE UNIT, DISPLAY, AND LIGHTING INCLUDING SAME, AND COMPOUND**
FARBUMWANDLUNGSZUSAMMENSETZUNG, FARBUMWANDLUNGSFOLIE, LICHTQUELLENEINHEIT, ANZEIGE UND BELEUCHTUNG DAMIT SOWIE VERBINDUNG
COMPOSITION DE CONVERSION DE COULEUR, FILM DE CONVERSION DE COULEUR, UNITÉ DE SOURCE DE LUMIÈRE, DISPOSITIF D'AFFICHAGE, ÉCLAIRAGE LA COMPRENANT ET COMPOSÉ

(30) Priority: 23.03.2020 JP 2020050593; 09.09.2020 JP 2020151089; 11.12.2020 JP 2020205613
(43) Date of publication of application: 08.02.2023
(73) Proprietor: Toray Industries, Inc., Tokyo 103-8666 (JP)
(72) Inventor: KANZAKI, Tatsuya, Otsu-shi, Shiga 520-8558 (JP); KOBAYASHI, Kazuki, Otsu-shi, Shiga 520-8558 (JP); TANAKA, Daisaku, Otsu-shi, Shiga 520-8558 (JP); IZUMI, Nanako, Otsu-shi, Shiga 520-8558 (JP); KITAMURA, Manami, Otsu-shi, Shiga 520-8558 (JP)
(74) Representative: Hoefer & Partner Patentanwälte mbB
(86) International application number: PCT/JP2021/007013
(87) International publication number: WO 2021/192795

(56) References cited:
- EP-A1- 2 578 075
- WO-A1-2011/149028
- WO-A1-2015/186359
- WO-A1-2017/014068
- WO-A1-2017/014068
- WO-A1-2017/033771
- CN-A- 110 407 859
- CN-A- 110 407 859
- CN-A- 110 627 822
- CN-A- 111 018 921
- JP-A- 2008 177 318
- JP-A- H0 425 493
- JP-A- H0 425 493
- JP-A- H0 443 078
- JP-A- H0 443 078
- JP-A- H02 121 944
- JP-A- H04 267 193
- JP-A- H04 267 193
- JP-A- H06 289 529
- JP-A- H06 289 529
- ZHANG YUEWEI ET AL: "Multi?Resonance Induced Thermally Activated Delayed Fluorophores for Narrowband Green OLEDs", vol. 58, no. 47, 18 November 2019 (2019-11-18), Hoboken, USA, pages 16912 - 16917, XP055793335, ISSN: 1433-7851, Retrieved from the Internet <URL:https://onlinelibrary.wiley.com/doi/full-xml/10.1002/anie.201911266> DOI: 10.1002/anie.201911266
- ALMEIDA JANAINA DO COUTO ET AL: "Copper(II) complexes with [beta]-diketones and N-donor heterocyclic ligands: Crystal structure, spectral properties, and cytotoxic activity", POLYHEDRON, vol. 89, 1 March 2015 (2015-03-01), GB, pages 1 - 8, XP093097035, ISSN: 0277-5387, DOI: 10.1016/j.poly.2014.12.026
- ZHANC, YUEWEI ET AL.: "Multi-Resonance Induced Thermally Activated Delayed Fluorophores for Narrowband Green OLEDs", ANGEW. CHEM. INT. ED., vol. 58, 25 September 2019 (2019-09-25), pages 16912 - 16917, XP055793335

## Description

### Technical Field

The present invention relates to a color conversion composition, a color conversion film, a light source unit, a display, and a lighting including the same, and a compound.

### Background Art

The multi-coloring technology by a color conversion system is being vigorously studied on its application to a liquid crystal display, an organic EL display, lighting, and the like. Color conversion represents to convert light emitted from a light emitter into light having a longer wavelength, and includes converting, for example, blue emission into green or red emission.

A composition having this color conversion function is formed into a film and combined, for example, with a blue light source, and three primary colors of blue, green, and red can thereby be obtained from the blue light source, i.e., white light can be obtained. A white light source obtained by combining a blue light source with a film having a color conversion function is used as a backlight unit and combined with a liquid crystal driving portion and a color filter, whereby a full-color display can be manufactured. A white light source obtained by combining a blue light source and a film having a color conversion function can be directly used as a white light source of a LED lighting, or the like.

The problem to be solved in a liquid crystal display utilizing a color conversion system includes improvement of color reproducibility and durability. For improving the color reproducibility, it is effective to make narrow the half-value width of each emission spectrum of blue, green and red of a backlight unit to thereby increase the color purity of each of blue, green and red colors. As a means to solve this task, for example, color conversion materials containing a pyrromethene compound have been proposed (see, for example, Patent Literatures 1 and 2). In addition, a technology comprising adding a light stabilizer has been proposed as a technology to improve the durability (see, for example, Patent Literature 3), but still resulted in insufficient durability. Furthermore, since the stabilizer absorbs visible light, the technology also has provided poor luminance. Therefore, as a technology to improve the color reproduction and durability, a color conversion composition for converting incident light into light having longer wavelength than the incident light, comprising (A) at least one luminescent material, (B) a binder resin, and (C) at least one of a tertiary amine, a catechol derivative, and a nickel compound has been proposed (see, for example, Patent Literature 4).
Patent Literature 5 teaches a wavelength conversion film, which is capable of maintaining an optical wavelength converting function for a long term as compared with conventional wavelength conversion films. The wavelength conversion film comprises a single layered film consisting of a resin composition containing a thermoplastic resin, a wavelength converting material and a specific nickel(II) dialkyldithiocarbamate, or a laminated film having a wavelength converting layer consisting of the resin composition, wherein the alkyl group of the specific nickel(II) dialkyldithiocarbamate is an ethyl group or a butyl group, and the content of the specific nickel(II) dialkyldithiocarbamate is from 20 to 250 parts by mass per 100 parts by mass of the wavelength converting material.

### Citation List

### Patent Literature

Patent Literature 1: JP 2010-61824 A
Patent Literature 2: JP 2014-136771 A
Patent Literature 3: JP 2019-50381 A
Patent Literature 4: WO 2017/014068
Patent Literature 5: EP 2578075 A1

### Summary of Invention

### Technical Problem

The technology described in Patent Literature 4 enables obtaining a color conversion composition having excellent color reproduction, and excellent durability due to less deterioration in the luminance even after long-term continuous use. However, in response to recent demands for further miniaturization and higher definition, it has been found that there is a new problem of slight changes in chromaticity after long-term use.

Accordingly, an object of the present invention is to provide a color conversion composition showing excellent chromaticity durability.

### Solution to Problem

The present invention, which is defined in the appended claims, is directed to a color conversion composition comprising the following components (A), (B), and (C):
Component (A): a luminescent material,
Component (B): a binder resin, and
Component (C): a salt of an organic acid and at least one transition metal selected from the group consisting of Sc, V, Mn, Fe, Co, Cu, Y, Zr, Mo, Ag, and lanthanoids,
wherein the organic acid constituting the component (C) is an acid having an ethylhexyl group and/or ethylhexanoic acid or wherein the organic acid constituting the component (C) is a β-diketone.

### Advantageous Effects of Invention

The color conversion composition of the present invention and the color conversion film using the same can improve the chromaticity durability.

### Brief Description of Drawings

Fig. 1 is a schematic cross-sectional view illustrating one example of the color conversion film of the present invention.
Fig. 2 is a schematic cross-sectional view illustrating one example of the color conversion film of the present invention.
Fig. 3 is a schematic cross-sectional view illustrating one example of the color conversion film of the present invention.
Fig. 4 is a schematic cross-sectional view illustrating one example of the color conversion film of the present invention.

### Description of Embodiments

The embodiments of the present invention are specifically described below, but the present invention is not limited to the following embodiments and can be implemented by making various modifications according to the purpose or usage.

### <Component (A): Luminescent Material>

The color conversion composition of the present invention contains at least one luminescent material. The luminescent material as used in the present invention refers to a material capable of, when irradiated with some kind of light, emitting light having a wavelength different from that of the irradiation light.

Examples of the luminescent material include inorganic fluorescent substance, fluorescent pigment, fluorescent dye, and quantum dot. Two or more of them may be contained. In order to achieve high-efficiency color conversion, a material exhibiting light emission characteristics with high quantum yield is preferred, which is preferably a quantum dot or an organic luminescent material, and more preferably an organic luminescent material.

Suitable examples of the organic luminescent material include, but are not limited to:
a fused aryl ring-containing compound and a derivative thereof, such as naphthalene, anthracene, phenanthrene, pyrene, chrysene, naphthacene, triphenylene, perylene, fluoranthene, fluorene and indene;
a heteroaryl ring-containing compound and a derivative thereof, such as furan, pyrrole, thiophene, silole, 9-silafluorene, 9,9'-spirobisilafluorene, benzothiophene, benzofuran, indole, dibenzothiophene, dibenzofuran, imidazopyridine, phenanthroline, pyridine, pyrazine, naphthyridine, quinoxaline and pyrrolopyridine;
a borane derivative;
a stilbene derivative such as 1,4-distyrylbenzene, 4,4'-bis(2-(4-diphenylaminophenyl)ethenyl)biphenyl and 4,4'-bis(N-(stilben-4-yl)-N-phenylamino)stilbene;
an aromatic acetylene derivative, a tetraphenylbutadiene derivative, an aldazine derivative, a pyrromethene derivative, a diketopyrrolo[3,4-c]pyrrole derivative;
a coumarin derivative such as coumarin 6, coumarin 7 and coumarin 153;
an azole derivative and a metal complex thereof, such as imidazole, thiazole, thiadiazole, carbazole, oxazole, oxadiazole and triazole;
a cyanine-based compound such as indocyanine green;
a xanthene-based compound and a thioxanthene-based compound, such as fluorescein, eosin and rhodamine;
a polyphenylene-based compound, a naphthalimide derivative, a phthalocyanine derivative and a metal complex thereof, and a porphyrin derivative and a metal complex thereof;
an oxazine-based compound such as Nile red and Nile blue;
a helicene-based compound;
an aromatic amine derivative such as N,N'-diphenyl-N,N'-di(3-methylphenyl)-4,4'-diphenyl-1,1'-diamine; and
an organic metal complex compound such as iridium (Ir), ruthenium (Ru), rhodium (Rh), palladium (Pd), platinum (Pt), osmium (Os) and rhenium (Re).

The organic luminescent material may be a fluorescent material or a phosphorescent material, but in order to achieve high color purity, a fluorescent material is preferred.

Among them, a pyrromethene derivative may be suitably used, because this gives a high fluorescence quantum yield and exhibits better chromaticity durability. A compound represented by Formula (1) is more preferred: 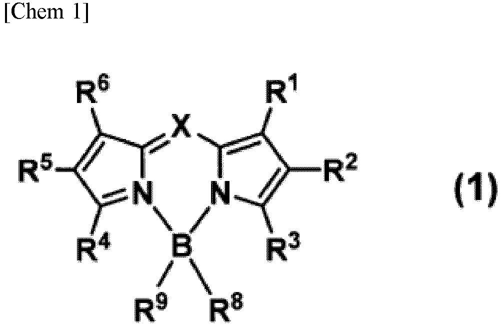 wherein,
X is C-R⁷ or N; and
each of R¹ to R⁹, which may be the same as or different from one another, is selected from hydrogen, an alkyl group, a cycloalkyl group, a heterocyclic group, an alkenyl group, a cycloalkenyl group, an alkynyl group, a hydroxyl group, a thiol group, an alkoxy group, an alkylthio group, an aryl ether group, an aryl thioether group, an aryl group, a heteroaryl group, a halogen, a cyano group, an aldehyde group, a carbonyl group, a carboxyl group, an oxycarbonyl group, a carbamoyl group, an amino group, a nitro group, a silyl group, a siloxanyl group, a boryl group, a phosphine oxide group, and a fused ring and an aliphatic ring each formed between adjacent substituents.

In all of the groups above, hydrogen may be deuterium. The same applies to the compounds described below or a partial structure thereof.

In the following description, for example, a substituted or unsubstituted aryl group having a carbon number of 6 to 40 means that the number of carbons is from 6 to 40 including the number of carbons contained in a substituent substituted on the aryl group, and the same applies to other substituents of which carbon number is specified.

In all of the groups above, when the group is substituted, the substituent is preferably an alkyl group, a cycloalkyl group, a heterocyclic group, an alkenyl group a cycloalkenyl group, an alkynyl group, a hydroxyl group, a thiol group, an alkoxy group, an alkylthio group, an aryl ether group, an aryl thioether group, an aryl group, a heteroaryl group, a halogen, a cyano group, an aldehyde group, a carbonyl group, a carboxyl group, an oxycarbonyl group, a carbamoyl group, an amino group, a nitro group, a silyl group, a siloxanyl group, a boryl group or a phosphine oxide group, more preferably a substituent that is specifically recited as a preferable substituent in the description of each substituent. These substituents may be further substituted with the above-described substituent.

The term "unsubstituted" in the "substituted or unsubstituted" means that a hydrogen atom or a deuterium atom is substituted. The same applies to the "substituted or unsubstituted" in the compounds described below or a partial structure thereof.

The alkyl group represents, for example, a saturated aliphatic hydrocarbon group such as methyl group, ethyl group, n-propyl group, isopropyl group, n-butyl group, sec-butyl group and tert-butyl group, which may or may not have a substituent. The additional substituent in the case of being substituted is not particularly limited and includes, for example, an alkyl group, halogen, an aryl group, and a heteroaryl group, and this is a common feature in the following description. The carbon number of the alkyl group is not particularly limited but in view of easy availability and cost, is preferably from 1 to 20, and more preferably from 1 to 8.

The cycloalkyl group represents, for example, a saturated alicyclic hydrocarbon group such as cyclopropyl group, cyclohexyl group, norbornyl group and adamantyl group, which may or may not have a substituent. The carbon number of the alkyl group moiety is not particularly limited but is preferably from 3 to 20.

The heterocyclic group represents, for example, an aliphatic ring having an atom other than carbon in the ring, such as pyrane ring, piperidine ring and cyclic amide, which may or may not have a substituent. The carbon number of the heterocyclic group is not particularly limited but is preferably from 2 to 20.

The alkenyl group represents, for example, an unsaturated aliphatic hydrocarbon group containing a double bond, such as vinyl group, allyl group and butadienyl group, which may or may not have a substituent. The carbon number of the alkenyl group is not particularly limited but is preferably from 2 to 20.

The cycloalkenyl group represents, for example, an unsaturated alicyclic hydrocarbon group containing a double bond, such as cyclopentenyl group, cyclopentadienyl group and cyclohexenyl group, which may or may not have a substituent. The carbon number of the cycloalkenyl group is not particularly limited but is preferably from 3 to 20.

The alkynyl group represents, for example, an unsaturated aliphatic hydrocarbon group containing a triple bond, such as ethynyl group, which may or may not have a substituent. The carbon number of the alkynyl group is not particularly limited but is preferably from 2 to 20.

The alkoxy group represents, for example, a functional group to which an aliphatic hydrocarbon group is bonded through an ether bond, such as methoxy group, ethoxy group and propoxy group, and the aliphatic hydrocarbon group may or may not have a substituent. The carbon number of the alkoxy group is not particularly limited but is preferably from 1 to 20.

The alkylthio group is a group formed by substituting an oxygen atom of an ether bond of an alkoxy group with a sulfur atom. The hydrocarbon group of the alkylthio group may or may not have a substituent. The carbon number of the alkylthio group is not particularly limited but is preferably from 1 to 20.

The aryl ether group represents, for example, a functional group to which an aromatic hydrocarbon group is bonded through an ether bond, such as phenoxy group, and the aromatic hydrocarbon group may or may not have a substituent. The carbon number of the aryl ether group is not particularly limited but is preferably from 6 to 40.

The aryl thioether group is a group formed by substituting an oxygen atom of an ether bond of an aryl ether group with a sulfur atom. The aromatic hydrocarbon group in the aryl ether group may or may not have a substituent. The carbon number of the aryl ether group is not particularly limited but is preferably from 6 to 40.

The aryl group represents, for example, an aromatic hydrocarbon group such as phenyl group, biphenyl group, terphenyl group, naphthyl group, fluorenyl group, benzofluorenyl group, dibenzofluorenyl group, phenanthryl group, anthracenyl group, benzophenanthryl group, benzoanthracenyl group, chrysenyl group, pyrenyl group, fluoranthenyl group, triphenylenyl group, benzofluoranthenyl group, dibenzoanthracenyl group, perylenyl group and helicenyl group. Among these, a phenyl group, a biphenyl group, a terphenyl group, a naphthyl group, a fluorenyl group, a phenanthryl group, an anthracenyl group, a pyrenyl group, a fluoranthenyl group, and a triphenylenyl group are preferred. The aryl group may or may not have a substituent. The carbon number of the aryl group is not particularly limited but is preferably from 6 to 40, more preferably from 6 to 30.

In the case where R¹ to R⁹ are a substituted or unsubstituted aryl group, the aryl group is preferably a phenyl group, a biphenyl group, a terphenyl group, a naphthyl group, a fluorenyl group, a phenanthryl group, or an anthracenyl group, more preferably a phenyl group, a biphenyl group, a terphenyl group, or a naphthyl group, still more preferably a phenyl group, a biphenyl group, or a terphenyl group, and yet still more preferably a phenyl group.

In the case where each substituent is further substituted with an aryl group, the aryl group is preferably a phenyl group, a biphenyl group, a terphenyl group, a naphthyl group, a fluorenyl group, a phenanthryl group, or an anthracenyl group, more preferably a phenyl group, a biphenyl group, a terphenyl group, or a naphthyl group, and still more preferably a phenyl group.

The heteroaryl group indicates, for example, a cyclic aromatic group having one or a plurality of atoms other than carbon in the ring, such as pyridyl group, furanyl group, thiophenyl group, quinolinyl group, isoquinolinyl group, pyrazinyl group, pyrimidyl group, pyridazinyl group, triazinyl group, naphthylidinyl group, cinnolinyl group, phthaladinyl group, quinoxalinyl group, quinazolinyl group, benzofuranyl group, benzothiophenyl group, indolyl group, dibenzofuranyl group, dibenzothiophenyl group, carbazolyl group, benzocarbazolyl group, carbolinyl group, indolocarbazolyl group, benzofurocarbazolyl group, benzothienocarbazolyl group, dihydroindenocarbazolyl group, benzoquinolinyl group, acridinyl group, dibenzoacridinyl group, benzimidazolyl group, imidazopyridyl group, benzoxazolyl group, benzothiazolyl group and phenanthrolinyl group. Here, the naphthylidinyl group indicates any of 1,5-naphthylidinyl group, 1,6-naphthylidinyl group, 1,7-naphthylidinyl group, 1,8-naphthylidinyl group, 2,6-naphthylidinyl group, and 2,7-naphthylidinyl group. The heteroaryl group may or may not have a substituent. The carbon number of the heteroaryl group is not particularly limited but is preferably from 2 to 40, more preferably from 2 to 30.

In the case where R¹ to R⁹ are a substituted or unsubstituted heteroaryl group, the heteroaryl group is preferably a pyridyl group, a furanyl group, a thiophenyl group, a quinolinyl group, a pyrimidyl group, a triazinyl group, a benzofuranyl group, a benzothiophenyl group, an indolyl group, a dibenzofuranyl group, a dibenzothiophenyl group, a carbazolyl group, a benzimidazolyl group, an imidazopyridyl group, a benzoxazolyl group, a benzothiazolyl group, or a phenanthrolinyl group, more preferably a pyridyl group, a furanyl group, a thiophenyl group, or a quinolinyl group, and still more preferably a pyridyl group.

In the case where each substituent is further substituted with a heteroaryl group, the heteroaryl group is preferably a pyridyl group, a furanyl group, a thiophenyl group, a quinolinyl group, a pyrimidyl group, a triazinyl group, a benzofuranyl group, a benzothiophenyl group, an indolyl group, a dibenzofuranyl group, a dibenzothiophenyl group, a carbazolyl group, a benzimidazolyl group, an imidazopyridyl group, a benzoxazolyl group, a benzothiazolyl group, or a phenanthrolinyl group, more preferably a pyridyl group, a furanyl group, a thiophenyl group, or a quinolinyl group, and still more preferably a pyridyl group.

Halogen represents an atom selected from fluorine, chlorine, bromine and iodine.

The carbonyl group, carboxyl group, oxycarbonyl group and carbamoyl group may or may not have a substituent. The substituent includes, for example, an alkyl group, a cycloalkyl group, an aryl group, and a heteroaryl group, and these may be further substituted.

The amino group is a substituted or unsubstituted amino group. The substituent in the case of being substituted includes, for example, an aryl group, a heteroaryl group, a linear alkyl group, and a branched alkyl group. For the aryl group and heteroaryl group, a phenyl group, a naphthyl group, a pyridyl group, and a quinolinyl group are preferred. These substituents may be further substituted. The carbon number is not particularly limited but is preferably from 2 to 50, more preferably from 6 to 40, still more preferably from 6 to 30.

The silyl group represents, for example, an alkylsilyl group such as trimethylsilyl group, triethylsilyl group, tert-butyldimethylsilyl group, propyldimethylsilyl group and vinyldimethylsilyl group, or an arylsilyl group such as phenyldimethylsilyl group, tertbutyldiphenylsilyl group, triphenylsilyl group and trinaphthylsilyl group. The substituent on silicon may be further substituted. The carbon number of the silyl group is not particularly limited but is preferably from 1 to 30.

The siloxanyl group represents a silicon compound group via an ether bond, such as trimethylsiloxanyl group. The substituent on silicon may be further substituted.

The boryl group is a substituted or unsubstituted boryl group. The substituent in the case of being substituted includes, for example, an aryl group, a heteroaryl group, a linear alkyl group, a branched alkyl group, an aryl ether group, an alkoxy group, and a hydroxyl group, and among these, an aryl group and an aryl ether group are preferred.

The phosphine oxide group is a group represented by -P(=O)R¹⁰R¹¹. R¹⁰ and R¹¹ are selected from the same group as those for R¹ to R⁹.

Arbitrary adjacent two substituents (for example, R¹ and R² in Formula (1)) may be bonded each other to form a conjugated or non-conjugated fused ring. As the element constituting the fused ring, the ring may contain an atom selected from nitrogen, oxygen, sulfur, phosphorus and silicon, in addition to carbon. The fused ring may be further fused with another ring.

The compound represented by Formula (1) exhibits a high fluorescence quantum yield and provides an emission spectrum with the peak half-value width being small, so that efficient color conversion and high color purity can be achieved, and the chromaticity durability can be further improved.

Furthermore, various properties and physical properties such as luminous efficiency, color purity, thermal stability, light stability and dispersibility can be adjusted by introducing an appropriate substituent into an appropriate position of the compound represented by Formula (1). For example, compared with the case where all of R¹, R³, R⁴ and R⁶ are hydrogen, when at least one of R¹, R³, R⁴ and R⁶ is a substituted or unsubstituted alkyl group, a substituted or unsubstituted aryl group, or a substituted or unsubstituted heteroaryl group, better thermal stability and light stability are exhibited.

Preferred examples of R¹, R³, R⁴ and R⁶ are methyl group, ethyl group, isopropyl group, tert-butyl group, phenyl group, biphenyl group, terphenyl group, naphthyl group, pyridyl group, and quinolinyl group. Each of R¹, R³, R⁴ and R⁶ may be the same as or different from one another.

Each of R² and R⁵ is preferably hydrogen, an alkyl group, a carbonyl group, an oxycarbonyl group or an aryl but is preferably an alkyl group or hydrogen in view of thermal stability, and more preferably hydrogen in that a narrow half-value width is readily obtained in the emission spectrum.

Each of R⁸ and R⁹ is preferably an alkyl group, an aryl group, a heteroaryl group, fluorine, a fluorine-containing alkyl group, a fluorine-containing heteroaryl group, or a fluorine-containing aryl group. For the reason that the compound is stable against excitation light and a higher fluorescence quantum yield is obtained, each substituent is more preferably fluorine or a fluorine-containing aryl group. When R⁸ and R⁹ each are fluorine or a fluorine-containing aryl group, the electron-donating properties of the compound represented by Formula (1) are weaken, so that the electronic interaction with the component (C) can be prevented, providing high fluorescence quantum yield.

In order to prevent reduction of the quantum yield of the component (A) due to the component (C), at least one of R¹ to R⁷ is preferably an appropriately bulky substituent. The color conversion composition of the present invention contains the component (A) and component (C) in the same layer, and thus the component (A) and component (C) can collide with each other due to thermal diffusion. When the component (C) and an excited luminescent material collide with each other, excitation energy of the luminescent material may be transferred to the component (C) molecule, and the excited luminescent material may be deactivated, resulting in reduction of the quantum yield of the component (A). In the present invention, when at least one of R¹ to R⁷ is an appropriately bulky substituent, such reduction of the quantum yield of the component (A) can be prevented. At least one of R², R⁵, and R⁷ is more preferably an appropriately bulky substituent, and all R², R⁵, and R⁷ are particularly preferably appropriately bulky substituents.

The appropriately bulky substituent for R² and R⁵ may be, for example, an alkyl group, a cycloalkyl group, a heterocyclic group, an alkenyl group, a cycloalkenyl group, an alkynyl group, an alkoxy group, an alkylthio group, an aryl ether group, an aryl thioether group, an aryl group, a heteroaryl group, a carbonyl group, a carboxyl group, an oxycarbonyl group, an ester group, a carbamoyl group, an amino group, a nitro group, a silyl group, a siloxanyl group, a boryl group, or a phosphine oxide group. Among them, an alkyl group, a cycloalkyl group, an aryl group, and an ester group are more preferable.

A preferred example of the appropriately bulky substituent for R⁷ is the structure represented by the following Formula (2): 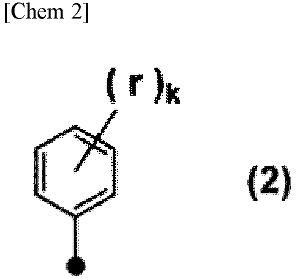 wherein,
r is selected from the group consisting of hydrogen, an alkyl group, a cycloalkyl group, a heterocyclic group, an alkenyl group, a cycloalkenyl group, an alkynyl group, a hydroxyl group, a thiol group, an alkoxy group, an alkylthio group, an aryl ether group, an aryl thioether group, an aryl group, a heteroaryl group, a halogen, a cyano group, an aldehyde group, a carbonyl group, a carboxyl group, an oxycarbonyl group, a carbamoyl group, an amino group, a nitro group, a silyl group, a siloxanyl group, a boryl group, and a phosphine oxide group;
k is an integer of 1 to 3; and
when k is 2 or more, r may be the same as or different from one another.
r is preferably a substituted or unsubstituted aryl group. Especially among aryl groups, preferable examples include a phenyl group and a naphthyl group. In the case where r is an aryl group, k in Formula (2) is preferably 1 or 2, and in view of further preventing reduction of the fluorescence quantum yield of the component (A) due to the component (C), k is more preferably 2. Furthermore, at least one r is preferably substituted with an alkyl group or an aryl group. In this case, particularly preferable examples of the alkyl group include a methyl group, an ethyl group, and a tert-butyl group. When r is an aryl group, r is preferably a phenyl group or a naphthyl group. The aryl group may further be substituted with an alkyl group, a heterocyclic group, an alkenyl group, a hydroxy group, an alkoxy group, an aryl ether group, an aryl group, a heteroaryl group, halogen, a cyano group, a carboxyl group, an ester group, an oxycarbonyl group, or an alkoxy group.

In addition, from the viewpoint of controlling the fluorescence wavelength or absorption wavelength or increasing the compatibility with a solvent, r is preferably a substituted or unsubstituted alkyl group, a substituted or unsubstituted alkoxy group, or halogen, more preferably a methyl group, an ethyl group, a tert-butyl group or a methoxy group. In view of dispersibility, a tert-butyl group or a methoxy group is particularly preferred, and can prevent quenching due to aggregation of molecules to each other.

In another embodiment of the compound represented by Formula (1), at least one of R¹ to R⁷ is preferably an electron withdrawing group. In particular, it is preferred that (1) at least one of R¹ to R⁶ is an electron withdrawing group, (2) R⁷ is an electron withdrawing group, or (3) at least one of R¹ to R⁶ is an electron withdrawing group and R⁷ is an electron withdrawing group. Introduction of an electron withdrawing group into a pyrromethene skeleton makes it possible to greatly decrease the electron density of the pyrromethene skeleton and to reduce the reaction rate with singlet oxygen. This makes the reaction rate at which the component (A) is deactivated by the component (C) faster than the reaction rate at which the component (A) is oxidized by singlet oxygen, so that the effect of improving the chromaticity durability by the component (C) is more significant.

The electron withdrawing group, otherwise called an electron-accepting group, is, in the organic electron theory, an atomic group that draws electrons by an induction effect or a resonance effect from an atomic group on which the group is substituted. The electron withdrawing group includes a group in which the value of a substituent constant (σp (para)) of Hammett's rule is positive. The substituent constant (σp (para)) of Hammett's rule can be quoted from KAGAKU BINRAN (Chemical Handbook), Basic Edition, 5th rev., (page: II-380).

A phenyl group takes a positive value in some examples, but a phenyl group is not encompassed by the electron withdrawing group of the present application.

Examples of the electron withdrawing group include -F (σp: +0.20), -Cl (σp: +0.28), -Br (σp: +0.30), -I (σp: +0.30), -CO₂R¹² (σp: +0.45 when R¹² is an ethyl group), -CONH₂ (σp: +0.38), -COR¹² (σp: +0.49 when R¹² is a methyl group), -CF₃ (σp: +0.51), -SO₂R¹² (σp: +0.69 when R¹² is a methyl group), and -NO₂ (σp: +0.81). Each R¹² independently represents a hydrogen atom, a substituted or unsubstituted aromatic hydrocarbon group having a ring-forming carbon number of 6 to 30, a substituted or unsubstituted heterocyclic group having a ring-forming carbon number of 5 to 30, a substituted or unsubstituted alkyl group having a carbon number of 1 to 30, or a substituted or unsubstituted cycloalkyl group having a carbon number of 1 to 30. Specific examples of each of these groups include the same examples as above.

The electron withdrawing group is preferably fluorine, a fluorine-containing aryl group, a fluorine-containing heteroaryl group, a fluorine-containing alkyl group, a substituted or unsubstituted acyl group, a substituted or unsubstituted ester group, a substituted or unsubstituted amide group, a substituted or unsubstituted sulfonyl group, or a cyano group, because such a group is less likely to be chemically decomposed.

The electron withdrawing group is more preferably a fluorine-containing alkyl group, a substituted or unsubstituted acyl group, a substituted or unsubstituted ester group, or a cyano group, because concentration quenching is prevented and this leads to an effect of enhancing the emission quantum yield. Among others, a substituted or unsubstituted ester group is preferred.

Examples of the compound represented by Formula (1) are illustrated below, but the present invention is not limited thereto.

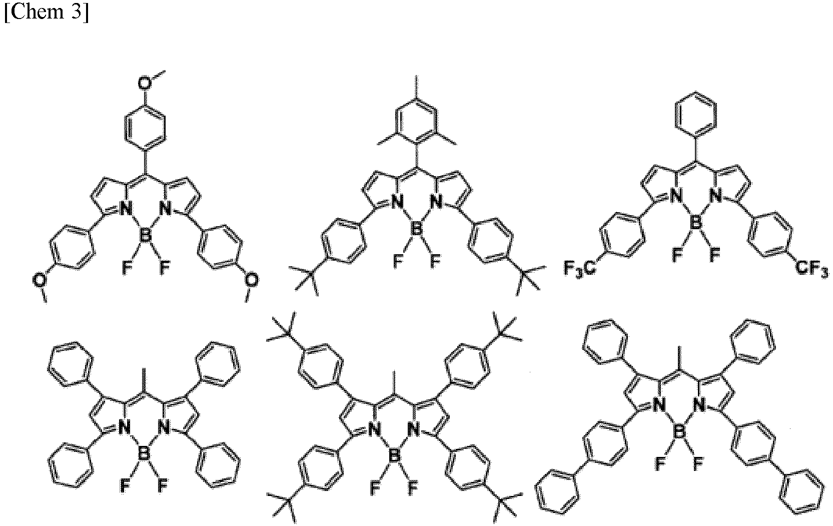

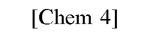

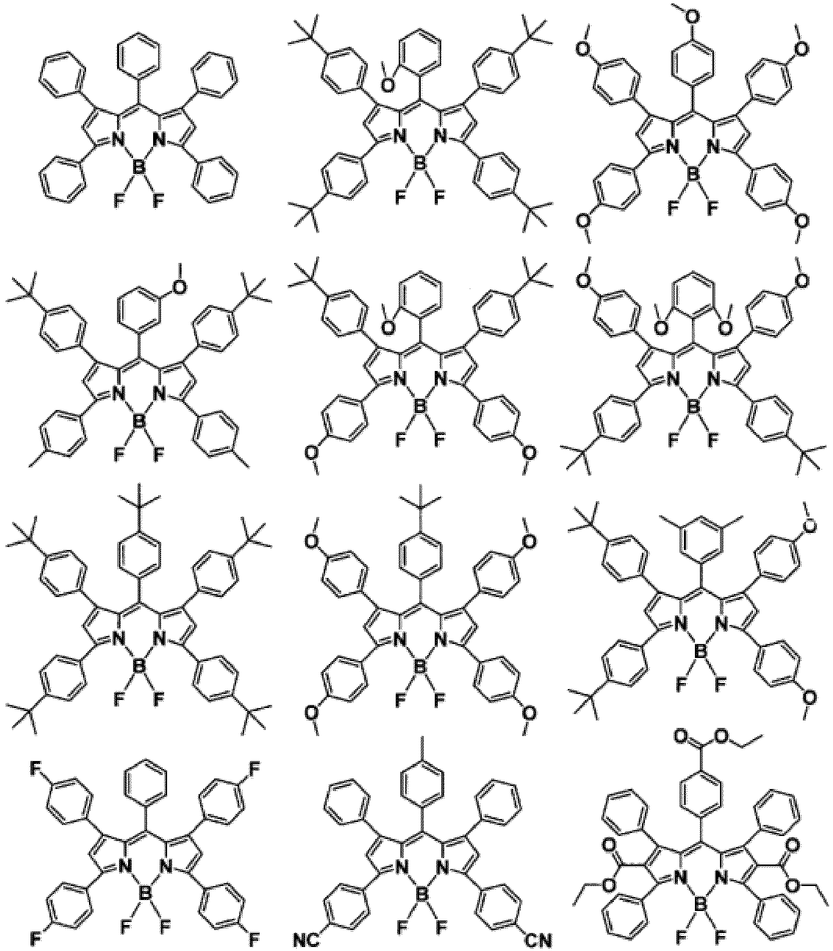

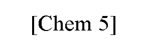

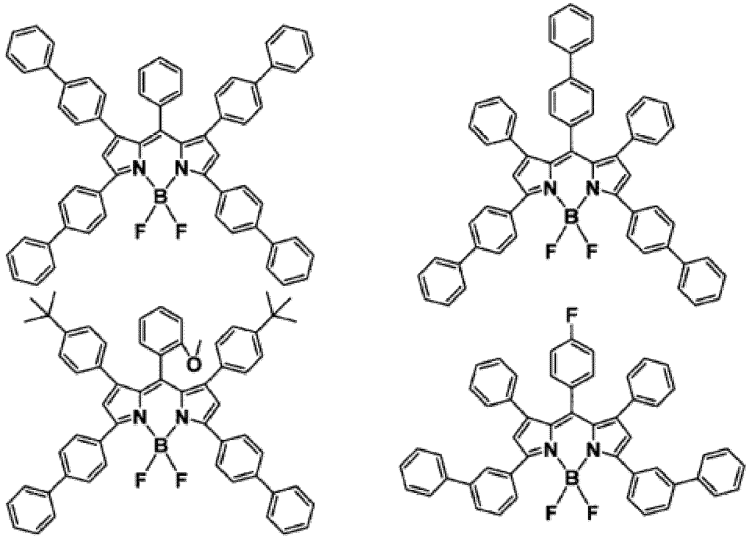

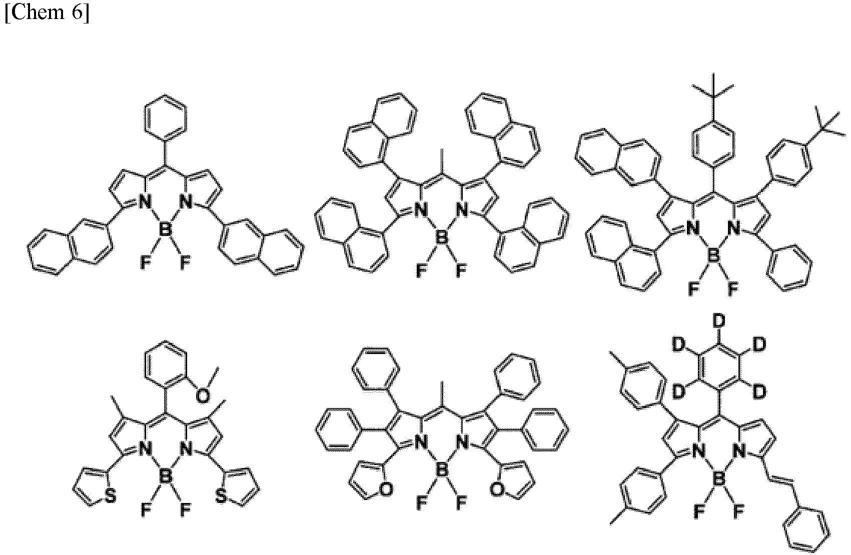

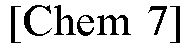

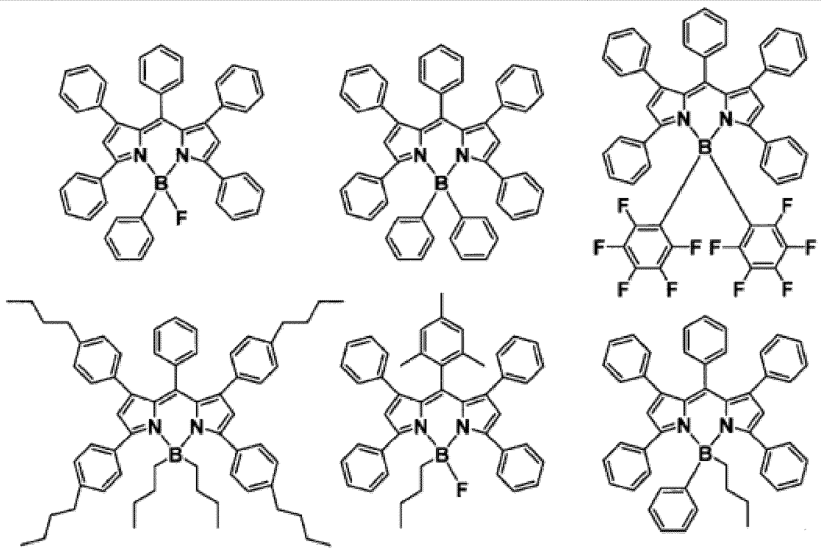

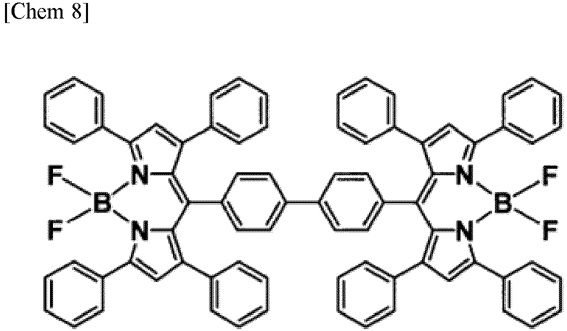

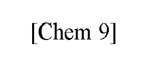

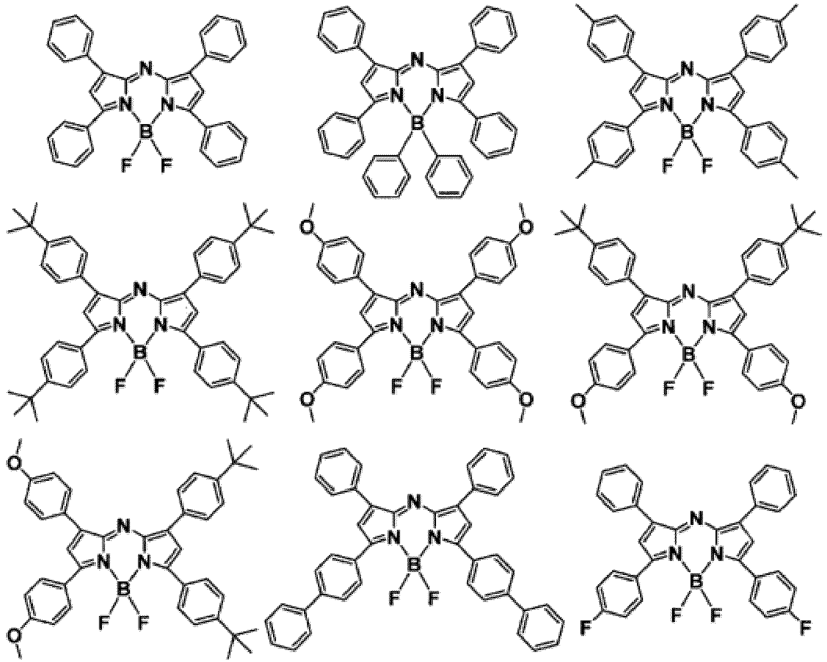

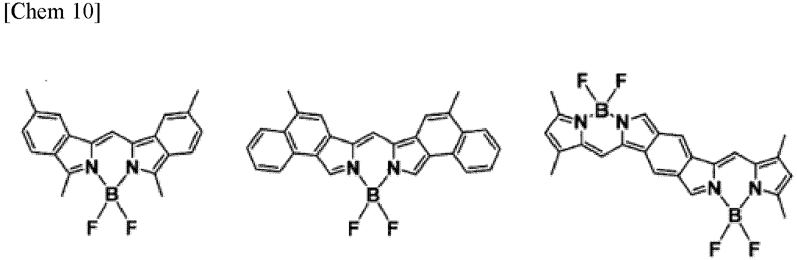

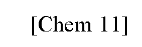

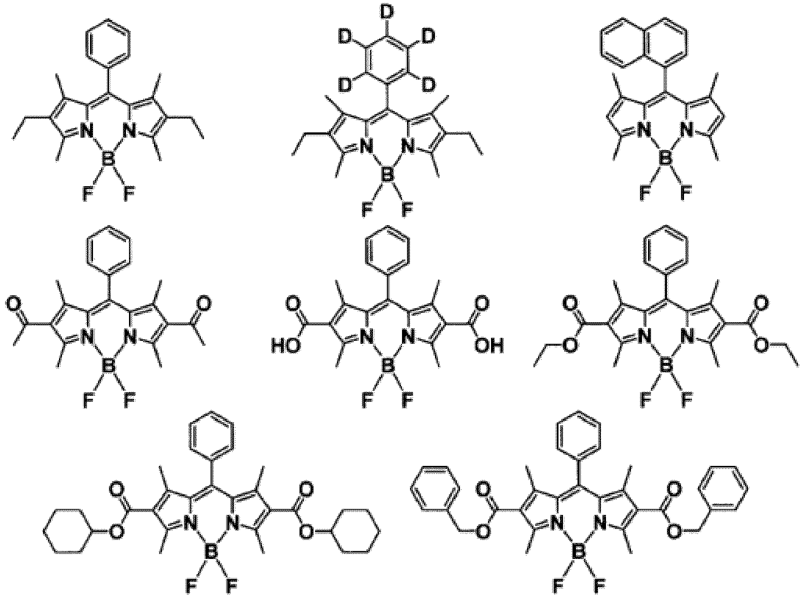

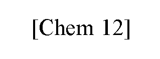

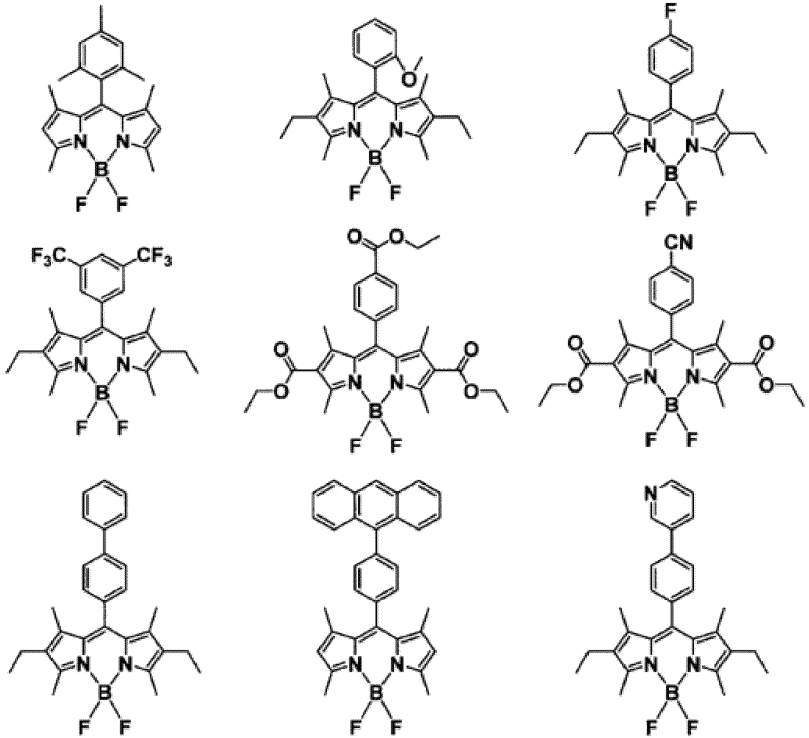

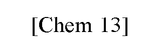

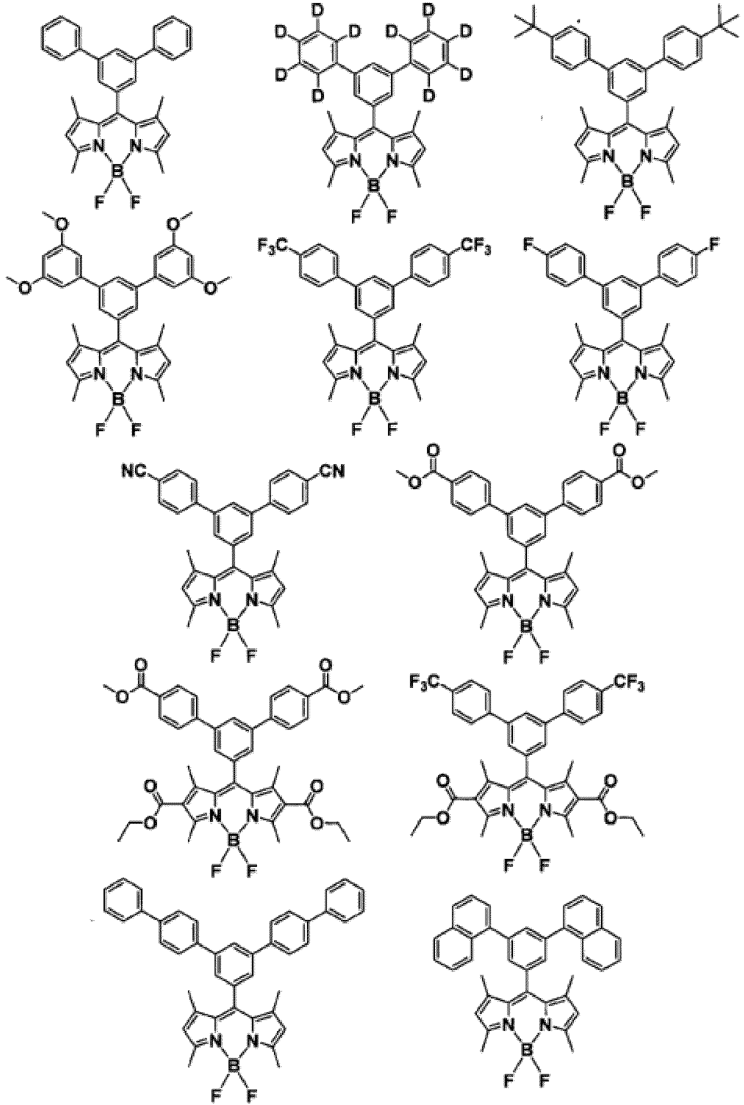

The compound represented by Formula (1) can be produced by the method described, for example, in JP-T-8-509471 or JP-A-2000-208262. More specifically, a target pyrromethene-based metal complex is obtained by reacting a pyrromethene compound with a metal salt in the co-presence of a base.

As to the synthesis of a pyrromethene-boron fluoride complex, the compound can be produced by referring to the method described in J. Org. Chem., Vol. 64, No. 21, pp. 7813-7819 (1999), Angew. Chem., Int. Ed. Engl., Vol. 36, pp. 1333-1335 (1997), or the like. The method includes, but is not limited to, for example, a method of heating compounds represented by the following Formulae (3) and (4) in 1,2-dichloroethane in the presence of phosphorus oxychloride, followed by reaction with a compound represented by the following Formula (5) in 1,2-dichloroethane in the presence of triethylamine. In the formulae, R¹ to R⁹ are the same as above. J represents halogen.

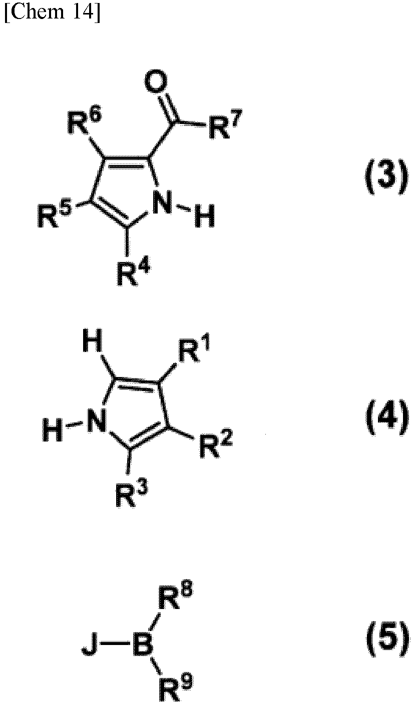

Furthermore, methods for introducing an aryl group or a heteroaryl group includes, but are not limited to, a method of producing a carbon-carbon bond by using a coupling reaction of a halogenated derivative with a boronic acid or a boronic ester derivative. Similarly, methods for introducing an amino group or a carbazolyl group includes, but are not limited to, a method of producing a carbon-nitrogen bond by using a coupling reaction of a halogenated derivative with an amine or carbazole derivative in the presence of a metal catalyst such as palladium.

The color conversion composition of the present invention may appropriately contain another compound, if desired, other than the compound represented by Formula (1). For example, the composition may contain an assist dopant such as rubrene to further enhance the energy transfer efficiency from excitation light to the compound represented by Formula (1). In the case of intending to add an emission color other than the emission color of the compound represented by Formula (1), the above-described organic luminescent material, or a known luminescent material such as an inorganic fluorescent substance, a fluorescent pigment, a fluorescent dye, or a quantum dot may be added.

Examples of the organic luminescent material other than the compound represented by Formula (1) are illustrated below, but the present invention is not limited thereto.

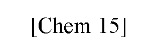

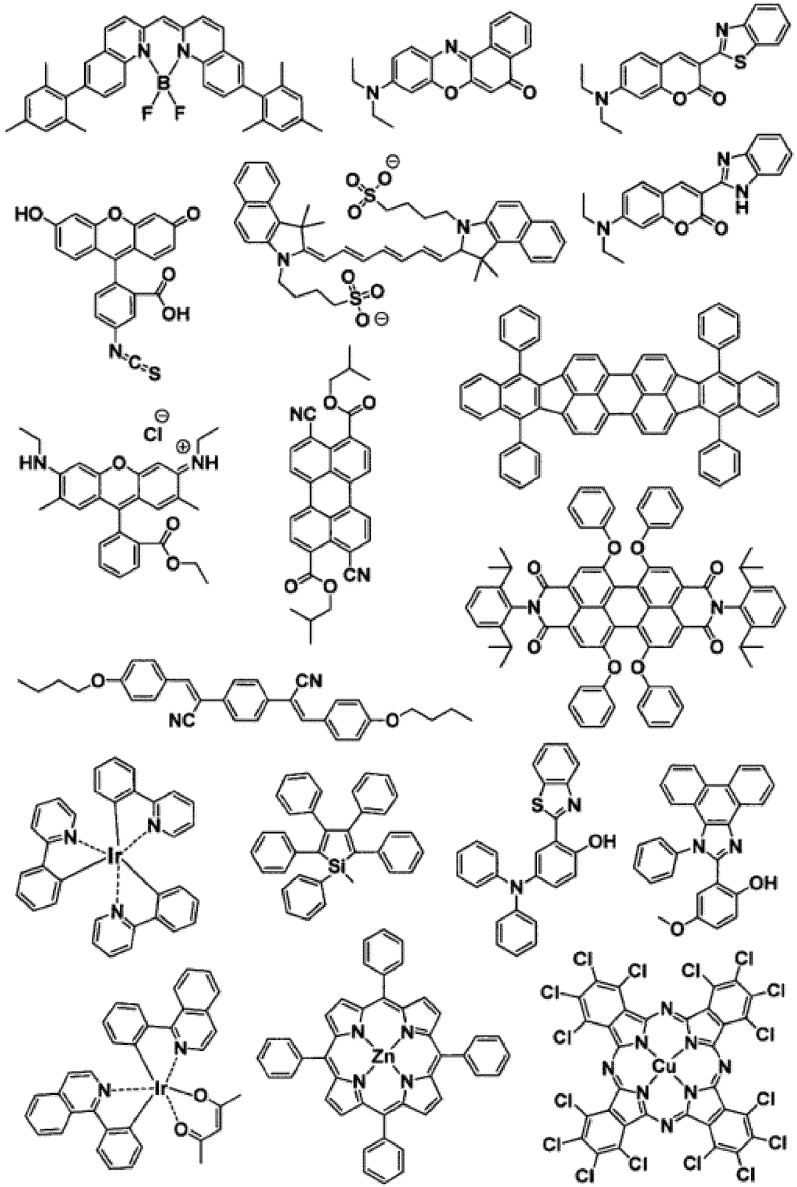

The color conversion composition of the present invention preferably contains a luminescent material emitting light having a peak wavelength observed in the region of 500 to 580 nm by use of excitation light having a wavelength of 430 to 500 nm (hereinafter, referred to as "luminescent material (a)"). Hereinafter, emission of light having a peak wavelength observed in the region of 500 to 580 nm is referred to as "green emission". In general, excitation light having lager energy is more likely to cause decomposition of a material, but the excitation energy of excitation light having a wavelength of 430 to 500 nm is relatively small, and green emission having a good color purity is therefore obtained without causing decomposition of a luminescent material in the color conversion composition.

The color conversion composition of the present invention preferably contains (a) a luminescent material emitting light having a peak wavelength of 500 to 580 nm by use of excitation light having a wavelength of 430 to 500 nm and (b) a luminescent material emitting light having a peak wavelength observed in the region of 580 to 750 nm upon excitation by one or both of excitation light having a wavelength of 430 to 500 nm and luminescence from the luminescent material (a) (hereinafter, referred to as "luminescent material (b)"). Hereinafter, emission of light having a peak wavelength observed in the region of 580 to 750 nm is referred to as "red emission".

Part of the excitation light having a wavelength of 430 to 500 nm partially transmits through the color conversion film of the present invention, and thus in the case of using a blue LED having a sharp emission peak, each of blue, green and red colors exhibits an emission spectrum in a sharp profile, making it possible to obtain white light with good color purity. As a result, particularly in a display, more vivid colors and a larger color gamut can be efficiently produced. In the lighting applications, compared with a currently prevailing white LED fabricated by combining a blue LED and a yellow phosphor, the light emission characteristics particularly in the green and red regions are improved, and the color rendering properties are thereby enhanced to provide a preferable white light source.

The luminescent material (a) may be, for example, a coumarin derivative such as coumarin 6, coumarin 7 or coumarin 153, a cyanine derivative such as indocyanine green, a fluorescein derivative such as fluorescein, fluorescein isothiocyanate or carboxyfluorescein diacetate, a phthalocyanine derivative such as phthalocyanine green, a perylene derivative such as diisobutyl-4,10-dicyanoperylene-3,9-dicarboxylate, a pyrromethene derivative, a stilbene derivative, an oxazine derivative, a naphthalimide derivative, a pyrazine derivative, a benzimidazole derivative, a benzoxazole derivative, a benzothiazole derivative, an imidazopyridine derivative, an azole derivative, a compound having a fused aryl ring, such as anthracene, or a derivative thereof, an aromatic amine derivative, or an organic metal complex compound. Two or more of them may be contained.

Among these compounds, a pyrromethene derivative gives a high fluorescence quantum yield, has good color-purity durability, and is therefore a particularly suitable compound. Especially, a compound represented by Formula (1) exhibits light emission with high color purity and is thus preferred.

The luminescent material (b) may be, for example, a cyanine derivative such as 4-dicyanomethylene-2-methyl-6-(p-dimethylaminostyryl)-4H-pyrane, a rhodamine derivative such as rhodamine B, rhodamine 6G, rhodamine 101 and sulforhodamine 101, a pyridine derivative such as 1-ethyl-2-(4-(p-dimethylaminophenyl)-1,3-butadienyl)-pyridinium-perchlorate, a perylene derivative such as N,N'-bis(2,6-diisopropylphenyl)-1,6,7,12-tetraphenoxyperylene-3,4:9,10-bisdicarboimide, a porphyrin derivative, a pyrromethene derivative, an oxazine derivative, a pyrazine derivative, a compound having a fused aryl ring, such as naphthacene or dibenzodiindenoperylene, or a derivative thereof, or an organic metal complex compound. Two or more of them may be contained.

Among these compounds, a pyrromethene derivative gives a high fluorescence quantum yield, has good color-purity durability, and is therefore a particularly suitable compound. Especially, a compound represented by Formula (1) exhibits light emission with high color purity and is thus preferred.

As the organic luminescent material, a compound that emits delayed fluorescence can also suitably be used. Compounds that emit delayed fluorescence are explained in "State-of-the-Art Organic Light-Emitting Diodes," pages 87-103 (Edited by Chihaya Adachi and Hiroshi Fujimoto, published by CMC Publishing Co. Ltd.). The literature illustrates that by bringing the energy levels of the excited singlet and excited triplet states of a luminescent material into close proximity, the reverse energy transfer from the excited triplet state to the excited singlet state, which normally has a low transition probability, occurs with high efficiency, resulting in thermally activated delayed fluorescence (TADF). Further, the mechanism of generation of delayed fluorescence is illustrated in Figure 5 in the literature. The delayed fluorescence emission can be determined by transient photo luminescence (PL) measurement.

In general, fluorescence is emitted from the singlet excited state generated after photoexcitation of the luminescent material, but no fluorescence is emitted from the triplet excited state of the luminescent material generated by intersystem crossing, due to thermal deactivation under room temperature conditions. As described above, compounds that emit delayed fluorescence, even after photoexcitation to the singlet excited state and formation of triplet excited state by intersystem crossing, are rapidly converted to the singlet excited state and then emit fluorescence. Therefore, the triplet excited state, which could not contribute to light emission in usual fluorescent materials, can contribute to fluorescence emission. That is, delayed fluorescence is preferable because highly efficient light emission can be achieved. It can also be expected that compounds that emits delayed fluorescence are rapidly converted from the triplet excited state to the singlet excited state, and thus are unlikely to generate singlet oxygen, resulting in improved durability. The triplet excited state of luminescent materials and generation of singlet oxygen, as well as their relationship with durability are described in detail in a section <Component (C): Salt of Transition Metal and Organic Acid>.

For compounds that emits delayed fluorescence, it is required to bring the energy levels of the excited singlet and excited triplet states into close proximity. A molecular design is effective for achieving this, in which an electron-donating skeleton and an electron-accepting skeleton are combined in the same molecule, and the highest occupied molecular orbital (HOMO) and the lowest unoccupied molecular orbital (LUMO) are separated in the molecule. The electron-donating skeleton and the electron-accepting skeleton may be combined directly or via a linking group. In the latter case, the linking group is preferably a skeleton comprising aromatic hydrocarbon.

Examples of the electron-donating skeleton include skeletons having a nitrogen atom of amine. Especially, skeletons containing diarylamine or triarylamine, skeletons containing carbazole, skeletons containing benzocarbazole, skeletons containing indolocarbazole, skeletons containing phenoxazine, and skeletons containing phenothiazine are preferable. Among them, skeletons containing carbazole, skeletons containing benzocarbazole, skeletons containing indolocarbazole, and skeletons containing phenoxazine are more preferable, and skeletons containing carbazole and skeletons containing phenoxazine are still more preferable.

On the other hand, the electron-accepting skeleton may be, in general, a skeleton containing an electron-attracting substituent. Especially, for example, skeletons containing a heteroaryl group having a partial structure with carbon and nitrogen atoms double bonded to each other, skeletons containing a fluorinated substituent, skeletons containing a cyano group, skeletons containing a carbonyl group, skeletons containing sulfoxide or disulfoxide, and skeletons containing a phosphine oxide group are preferable. Among them, skeletons containing a heteroaryl group having a partial structure with carbon and nitrogen atoms double bonded to each other, skeletons containing a fluorinated substituent, and skeletons containing a cyano group are more preferable in view of stability of the compound.

Among the skeletons containing a heteroaryl group having a partial structure with carbon and nitrogen atoms double bonded to each other, specifically, skeletons containing pyridine, pyrimidine, pyrazine, triazine, quinoline, quinoxaline, quinazoline, or phenanthroline are preferable; especially, skeletons containing pyrimidine, triazine, quinoxaline, or quinazoline are more preferable; and skeletons containing triazine are still more preferable.

Among the skeletons containing a fluorinated substituent, skeletons containing a fluorinated aryl group or a fluoroalkyl group are more preferable. As the skeletons containing a fluorinated aryl group, fluorinated benzene rings are preferable, and specifically, skeletons containing fluorobenzene, difluorobenzene, trifluorobenzene, tetrafluorobenzene, or pentafluorobenzene are more preferable. As the skeletons containing a fluoroalkyl group, skeletons containing a benzene ring substituted with a trifluoromethyl group are preferable, and especially skeletons containing mono(trifluoromethyl)benzene or bis(trifluoromethyl)benzene are more preferable.

Among skeletons having a cyano group, skeletons containing cyanobenzene, dicyanobenzene, or tricyanobenzene are more preferable.

Non-limiting examples of the compounds in which an electron-donating skeleton and an electron-accepting skeleton as described above are shown below. It is noted that the compounds shown here are known to emit delayed fluorescence according to past literature.

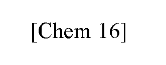

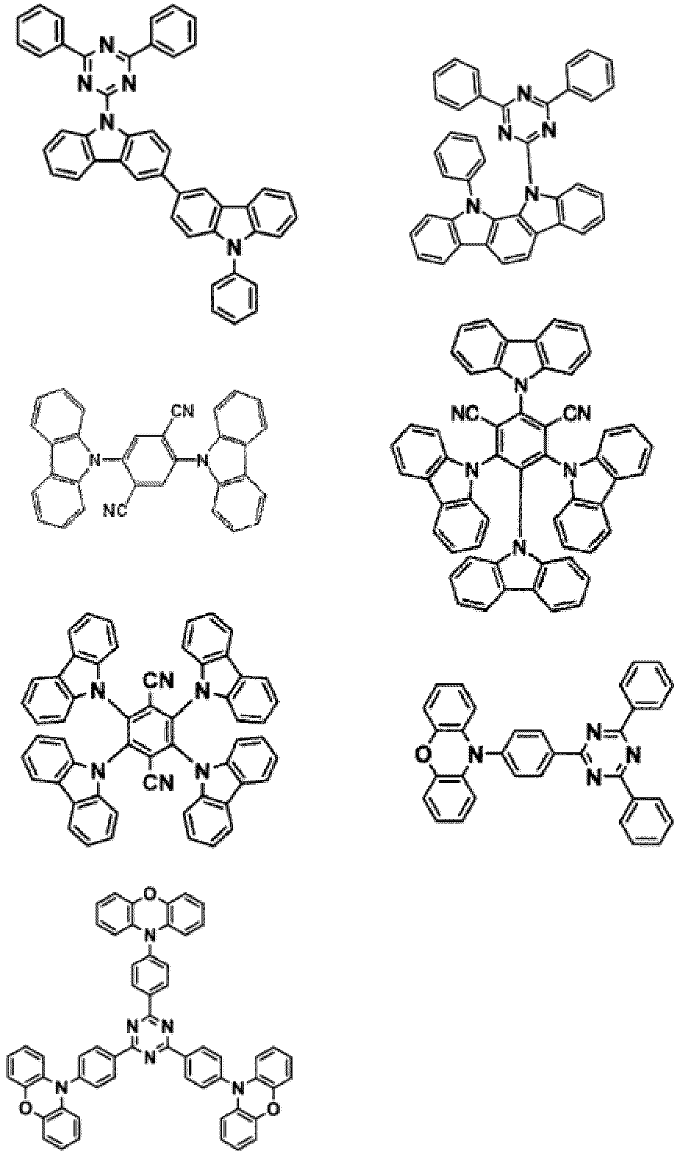

In addition to the compounds in which an electron-donating skeleton and an electron-accepting skeleton are bonded as described above, a compound represented by Formula (11) can also be used more suitably as a compound that emits delayed fluorescence: 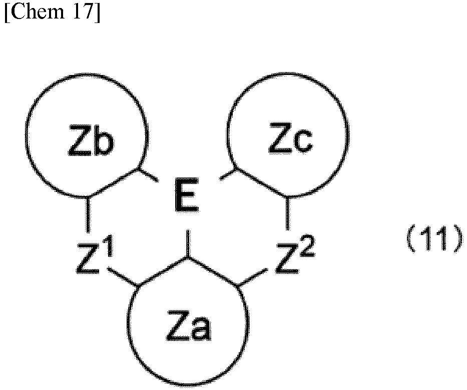 wherein,
each of the ring Za, the ring Zb, and the ring Zc independently is a substituted or unsubstituted aryl ring having a ring-forming carbon number of 6 to 30, or a substituted or unsubstituted heteroaryl ring having a ring-forming carbon number of 6 to 30;
each of Z¹ and Z² independently is an oxygen atom, NRa (a nitrogen atom having a substituent Ra), or a sulfur atom;
when Z¹ is NRa, Ra may or may not be bonded to the ring Za or the ring Zb to form a ring; and when Z² is NRa, Ra may or may not be bonded to the ring Za or the ring Zc to form a ring;
each Ra independently is a substituted or unsubstituted aryl group, a substituted or unsubstituted heteroaryl group, or a substituted or unsubstituted alkyl group;
E is a boron atom, a phosphorus atom, SiRb (a silicon atom having a substituent Rb), P=O, or P=S; and
each Rb independently is a substituted or unsubstituted aryl group, a substituted or unsubstituted heteroaryl group, or a substituted or unsubstituted alkyl group.

In all of the groups above, when the group is substituted, the substituent is an alkyl group, a cycloalkyl group, a heterocyclic group, an alkenyl group, a cycloalkenyl group, an alkynyl group, an aryl group, a heteroaryl group, a hydroxy group, a thiol group, an alkoxy group, an alkylthio group, an aryl ether group, an aryl thioether group, halogen, a cyano group, an aldehyde group, a carbonyl group, a carboxyl group, an oxycarbonyl group, an amide group, a sulfonyl group, a sulfonate group, a sulfonamide group, an amino group, a nitro group, a silyl group, a siloxanyl group, a boryl group, or a phosphine oxide group. These substituents may further be substituted with the above-described substituent.

Examples of the substituted or unsubstituted aryl ring having a ring-forming carbon number of 6 to 30 in the rings Za, Zb, and Zc include aromatic hydrocarbon rings such as benzene rings, naphthalene rings, phenanthrene rings, chrysene rings, and anthracene, pyrene rings. Among them, benzene rings are preferable in view of ensuring the solubility. Examples of the heteroaryl ring having a ring-forming carbon number of 5 to 30 include aromatic heteroaryl ring structures such as pyridine rings, quinoline rings, and phenanthroline rings. In view of raw-material availability and difficulty of synthesis, pyridine rings are preferable.

Ra is preferably a group having a carbon number of 6 to 40 including that of the substituent. Ra is more preferably a substituted or unsubstituted aryl group. Examples of the substituted or unsubstituted aryl group include substituted or unsubstituted phenyl groups, substituted or unsubstituted biphenyl groups, substituted or unsubstituted fluorenyl groups, substituted or unsubstituted naphthyl groups, and substituted or unsubstituted phenanthrenyl groups, and substituted or unsubstituted phenyl groups are more preferable.

Rb is preferably a group having a carbon number of 6 to 40 including that of the substituent. Rb is more preferably a substituted or unsubstituted aryl group or a substituted or unsubstituted alkyl group.

The compound represented by Formula (11) is a molecule, in which an electron-donating nitrogen atom of amine and an electron-accepting boron atom are optimally positioned, enabling HOMO-LUMO separation by the multiple resonance effect, as described in literatures, for example, Adv. Mater. 28, 2777-2781 (2016). In view of clear separation between HOMO and LUMO for bringing the singlet excited state and the triplet excited state into closer proximity and making it easier to emit delayed fluorescence, NRa is preferable, in which E is a boron atom having strong electron-accepting properties, and both Z¹ and Z² are groups having strong electron-donating properties.

In addition, the compound represented by Formula (11) shows an emission spectrum that is sharper than compounds with an electron-donating skeleton and an electron-accepting skeleton combined due to the multiple resonance effect, resulting in light emission with high color purity. That is, the compound represented by Formula (11) is advantageous in improving the color gamut of displays, and thus is preferable. Furthermore, the compound represented by Formula (11) has the rings Za, Zb, and Zc present surrounding the E atom in Formula (11), in which LUMO is mainly localized, and thus the E atom, or most LUMO, can be protected. Thus, the electronic interaction between the compound represented by Formula (11) and the component (C) due to collision can be prevented. This enables holding the high fluorescence quantum yield originally possessed by the compound represented by Formula (4) while allowing the component (C) to exert the effect of improving the durability, and thus is preferable.

Furthermore, a structure in which Ra of Formula (11) is bonded to at least one ring of the ring Za, ring Zb, and ring Zc is more preferable. This is because bonding of Ra to at least one ring of the ring Za, ring Zb, and ring Zc can be expected to further enhance the effect of sterically protecting E in Formula (11) and further improve the effect of preventing reduction of the fluorescence quantum yield. In view of such an effect of sterically protecting E, the compound represented by Formula (11) is further preferably a compound represented by Formula (12).

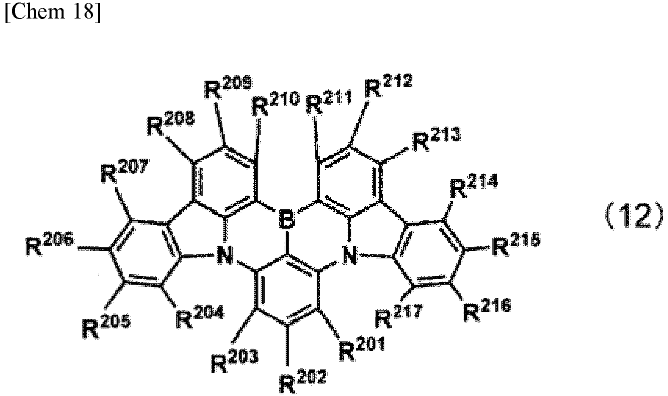

Each of R²⁰¹ to R²¹⁷ independently is hydrogen, deuterium, an alkyl group, a cycloalkyl group, a heterocyclic group, an alkenyl group, a cycloalkenyl group, an alkynyl group, an aryl group, a heteroaryl group, a hydroxy group, a thiol group, an alkoxy group, an alkylthio group, an aryl ether group, an aryl thioether group, halogen, a cyano group, an aldehyde group, a carbonyl group, a carboxyl group, an oxycarbonyl group, an amide group, a sulfonyl group, a sulfonate group, a sulfonamide group, an amino group, a nitro group, a silyl group, a siloxanyl group, a boryl group, or a phosphine oxide group. These substituents may further be substituted with the above-described substituent. Examples of these groups include those illustrated for Formula (1).

Of R²⁰¹ to R²¹⁷, at least one of R²⁰¹ and R²⁰³ is preferably a group containing an electron-donating substituent. Among electron-donating substituents, an alkyl group, a cycloalkyl group, a diarylamino group, a triarylamino-containing group, and a carbazole-containing group are preferable. In view of compound stability and difficulty of synthesis, an alkyl group, a cycloalkyl group, and a carbazole-containing group are more preferable.

To further increase the fluorescence quantum yield, including the delayed fluorescence, of the compound represented by Formula (12), at least one of R²⁰⁶, R²⁰⁹, R²¹², and R²¹⁶ is preferably a group containing an electron-donating substituent. In this case, preferable substituents are the same as R²⁰¹ and R²⁰³.

Similarly, to further increase the fluorescence quantum yield, including the delayed fluorescence, of the compound represented by Formula (12), R²⁰² also is preferably a group containing an electron-accepting substituent. The group containing an electron-accepting substituent may be, in general, an electron-withdrawing skeleton. Especially, for example, skeletons having a heteroaryl group having a partial structure with carbon and nitrogen atoms double bonded to each other, skeletons having a fluorinated substituent, skeletons having a cyano group, skeletons having a carbonyl group, skeletons having sulfoxide or disulfoxide, and skeletons having a phosphine oxide group are preferable. Among them, skeletons containing a heteroaryl group having a partial structure with carbon and nitrogen atoms double bonded to each other, skeletons containing a fluorinated substituent, and skeletons having a cyano group are more preferable in view of stability of the compound.

Among the skeletons containing a heteroaryl group having a partial structure with carbon and nitrogen atoms double bonded to each other, specifically, skeletons containing pyridine, pyrimidine, pyrazine, triazine, quinoline, quinoxaline, quinazoline, or phenanthroline are preferable; especially, skeletons containing pyrimidine, triazine, quinoxaline, or quinazoline are more preferable; and skeletons containing triazine are still more preferable.

Among the skeletons containing a fluorinated substituent, skeletons containing a fluorinated aryl group or a fluoroalkyl group are more preferable. As the skeletons containing a fluorinated aryl group, fluorinated benzene rings are preferable, and specifically, skeletons containing fluorobenzene, difluorobenzene, trifluorobenzene, tetrafluorobenzene, or pentafluorobenzene are more preferable. As the skeletons containing a fluoroalkyl group, skeletons containing a benzene ring substituted with a trifluoromethyl group are preferable, and especially skeletons containing mono(trifluoromethyl)benzene or bis(trifluoromethyl)benzene are more preferable.

Among skeletons having a cyano group, skeletons containing cyanobenzene, dicyanobenzene, or tricyanobenzene are more preferable.

Examples of the compound represented by Formula (11) are illustrated below, but the present invention is not particularly limited thereto.

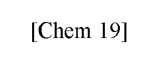

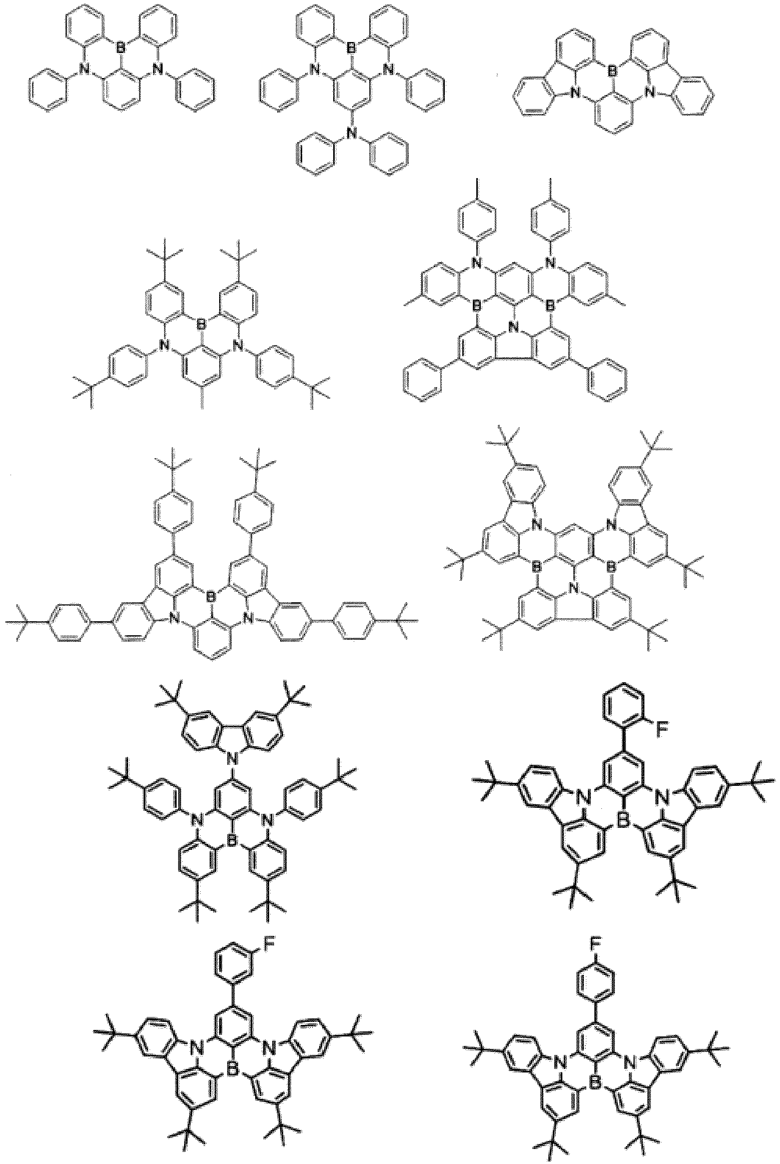

The amount of the component (A) in the color conversion composition of the present invention can be selected depending on the molar extinction coefficient, fluorescence quantum yield, and absorption intensity at the excitation wavelength of the compound and the thickness and transmittance of the film formed. Here, the amount of the component (A) in the case where two or more components (A) are contained means the total amount thereof. The amount of the component (A) is preferably from 1.0 × 10⁻² parts by weight to 5 parts by weight per 100 parts by weight of the component (B).

In the case where the color conversion composition contains both (a) a luminescent material providing green emission and (b) a luminescent material providing red emission, since part of green emission is converted to red emission, the amount wₐ of the luminescent material (a) and the amount w_{b} of the luminescent material (b) preferably have a relationship of wₐ ≥ w_{b}, and the amount ratio wₐ:w_{b} of the materials is preferably from 200:1 to 3:1. Here, wₐ and w_{b} are in percent by weight relative to the weight of the component (B).

### <Component (B): Binder Resin>

The binder resin is preferably a material that forms a continuous phase and has excellent mold processability, transparency, heat resistance, and the like. The binder resin may be, for example, a photocurable resist material having a reactive vinyl group, such as an acrylic, methacrylic, poly(vinyl cinnamate)-based, polyimide-based, or cyclic rubber-based resin, an epoxy resin, a silicone resin (including a cured (crosslinked) organopolysiloxane such as silicone rubber or silicone gel), a urea resin, a fluororesin, a polycarbonate resin, an acrylic resin, a methacryl resin, a polyimide resin, cycloolefin, a polyethylene terephthalate resin, a polypropylene resin, a polystyrene resin, a urethane resin, a melamine resin, a polyvinyl resin, a polyamide resin, a phenol resin, a polyvinyl alcohol resin, a cellulose resin, an aliphatic ester resin, an aromatic ester resin, an aliphatic polyolefin resin, an aromatic polyolefin resin, a hydrogenated styrene-based resin, a resin having a fluorene skeleton in the repeating unit, or a copolymer thereof. Two or more of them may be contained.

Among these resins, an epoxy resin, a silicone resin, an acrylic resin, or an ester resin is preferably used in view of transparency, and an acrylic resin or an ester resin is more preferably used in view of heat resistance.

These resins can be obtained, for example, by a method comprising copolymerizing monomers materials in the presence of a polymerization initiator. A commercially available product can also be used.

The silicone resin may be either a thermosetting silicone resin or a thermoplastic silicone resin. Thermosetting silicone resins are cured at a normal temperature or a temperature from 50 to 200°C, and have excellent transparency, heat resistance, and adhesiveness. The thermosetting silicone resin used may also be commercially available, for example, a silicone sealant for use in general LED. Specific examples thereof include OE-6630A/B and OE-6336A/B produced by DuPont Toray Specialty Materials K.K., and SCR-1012A/B and SCR-1016A/B produced by Shin-Etsu Chemical Co., Ltd. The thermoplastic silicone resin may be commercially available, such as RSN series such as RSN-0805 and RSN-0217 produced by DuPont Toray Specialty Materials K.K.

The binder resin may be, for example, a thermosetting resin, a photocurable resin, or a thermoplastic resin. Among them, a thermoplastic resin has few reactive functional groups, and therefore is unlikely to inhibit the effect of the component (C), or allows the component (C) to more effectively exert the effect in the binder resin, and thus is preferable.

The glass transition temperature (Tg) of the thermoplastic resin is preferably from 50 to 200°C, and more preferably from 100 to 160°C in view of further improving the chromaticity durability. Here, the glass transition temperature of the thermoplastic resin can be measured with a commercially available measuring instrument (for example, a differential scanning calorimeter (trade name: DSC6220, rate of temperature rise: 0.5 °C/min) produced by Seiko Electronic Industry Co. Ltd.).

### <Component (C): Salt of Transition Metal and Organic Acid>

An organic acid salt of a specific transition metal is effectively contained in order to prevent deterioration of the luminescent material, and reduce the change of chromaticity over time and improve the durability. Such a compound has a role of singlet oxygen quencher.

The singlet oxygen quencher is a compound that traps and deactivates singlet oxygen resulting from activation of an oxygen molecule in the ground state due to excitation energy. Co-presence of a singlet oxygen quencher in the composition makes it possible to prevent singlet oxygen from oxidizing and deteriorating the luminescent material.

Next, the mechanisms of generation of singlet oxygen, and of deactivation of singlet oxygen by singlet oxygen quenchers are described in order.

Singlet oxygen is thought to be hardly generated by direct photoexcitation of triplet oxygen in the ground state. This is because the transition from triplet oxygen in the ground state to singlet oxygen in the excited state is spin-forbidden transition, and thus the transition probability is very low. Thus, generation of singlet oxygen in the color conversion composition in the present invention is considered to be caused by dye sensitization.

**In** other words, singlet oxygen is considered to result from exchange of electron and energy between the luminescent material in the triplet excited state and a triplet oxygen molecule in the ground state. The mechanism of generation is considered to be as follows. First, photoexcitation makes a singlet luminescent material in the ground state into the singlet luminescent material in the excited state, and intersystem crossing makes the singlet luminescent material in the excited state into the triplet luminescent material in the excited state. Since the transition from the generated triplet luminescent material in the excited state to the singlet luminescent material in the ground state is spin-forbidden transition, the transition probability is generally low. However, when triplet oxygen in the ground state coexists, excitation from triplet oxygen in the ground state to singlet oxygen in the excited state is accompanied, which lifts the spin-forbidden transition, so that the triplet luminescent material can be rapidly deactivated into the singlet luminescent material in the ground state. This mechanism is called Dexter mechanism (electron exchange mechanism). For proceeding of the Dexter mechanism, electron exchange via superposition of wave function between molecules is required, and thus direct collision between an energy-donating molecule (in this case, triplet dye in the excited state) and an energy-accepting molecule (in this case, triplet oxygen in the ground state) seems to be required.

It is also known that a fluorescent material with higher quantum yield generates more singlet oxygen. In other words, in the case where a fluorescent material with higher fluorescence quantum yield is contained as in the present invention than the case where a non-light emitting adsorption dye is contained, higher amount of singlet oxygen is generated, a singlet oxygen quencher for efficiently trapping singlet oxygen is required.

Next, the mechanisms of deactivation of singlet oxygen by singlet oxygen quenchers is described. The transition from singlet oxygen in the excited state to triplet oxygen in the ground state is spin-forbidden transition, and thus the transition probability is generally low. When a singlet oxygen quencher coexists, similarly to the mechanism of generation of singlet oxygen, a singlet oxygen quencher in the ground state is accompanied with excitation to a triplet quencher in the excited state, which lifts the spin-forbidden transition, so that singlet oxygen can be rapidly deactivated into triplet oxygen in the ground state. Importantly, deactivation of singlet oxygen also proceeds by the Dexter mechanism. This means that singlet oxygen and a singlet oxygen quencher are required to be directly contact with each other. For this, the singlet oxygen quencher molecule is preferably a molecule with small steric hindrance. In order to act as a singlet oxygen quencher, it is preferably excited with a smaller energy than the energy of singlet oxygen. In other words, the present invention has found that an organic acid salt of a specific transition metal acts as a singlet oxygen quencher and improves the chromaticity durability of the luminescent material. It is noted that the transition metal is one or more selected from Sc, V, Mn, Fe, Co, Cu, Y, Zr, Mo, Ag, and lanthanoid, and as a cation forms a salt with an organic acid anion. These organic acid salts of transition metals can efficiently absorb the excitation energy of singlet oxygen, and thus are considered to act effectively as singlet oxygen quenchers.

On the other hand, even use of other metals than them, for example, Ni results in insufficient chromaticity durability. Among the transition metals as described above, Mn, Fe, Co, Cu, Ag, Ce, Pr, Nd, Sm, Eu, Gd, Ho, Er, and Tm are preferable, and Mn, Cu, Ag, Nd, Sm, Eu, and Ho are more preferable, and Cu, Nd, and Sm are still more preferable. The oxidation number of Cu is preferably +2. The oxidation numbers of Nd and Sm are preferably +3.

The color conversion composition of the present invention may comprise two or more components (C) without particular limitation to the combination.

Singlet oxygen that is deactivated by an organic acid salt comprising Sc, V, Mn, Fe, Co, Cu, Y, Zr, Mo, or Ag is considered to have a different energy state from singlet oxygen that is deactivated by an organic acid salt comprising a lanthanoid. It is known that there are two types of energy states for singlet oxygen. One is the Σ state, in which each of the two π*2p orbitals is occupied by one electron. The other is the Δ state, in which only one of the two π*2p orbitals is occupied by two electrons, while the other of the π*2p orbitals is a vacant orbital. In addition, the Δ state has less energy than the Σ state. It is considered that an organic acid salt comprising Sc, V, Mn, Fe, Co, Cu, Y, Zr, Mo, or Ag deactivates singlet oxygen in the Δ state, while an organic acid salt comprising a lanthanoid deactivates singlet oxygen in the Σ state.

Thus, when the color conversion composition of the present invention comprises two or more components (C), it is preferable that the color conversion composition comprises at least a first component (C) and a second component (C), wherein the transition metal constituting the first component (C) is selected from the group consisting of Sc, V, Mn, Fe, Co, Cu, Y, Zr, Mo and Ag, and wherein the transition metal constituting the second component (C) is a lanthanoid. Especially, it is more preferable that the transition metal constituting the first component (C) is Cu, and the transition metal constituting the first component (C) is Nd or Sm.

When the amount of the first component (C) is w1 and the amount of the second component (C) is w2, then w1 ≤ w2 is preferably satisfied. This enables efficient deactivation of both singlet oxygen in the Σ state and singlet oxygen in the Δ state.

In accordance with the present invention, the transition metal as described above is contained as an organic acid salt. The organic acid salt, due to its excellent compatibility with a binder resin, makes it easy for a singlet oxygen quencher to disperse in the binder resin as a single molecule and contact with singlet oxygen. The transition metal and the organic acid may exist as a salt in the binder resin, or may be dissociated to a metal ion and an organic acid ion. This enables effective trapping of singlet oxygen and improvement of the chromaticity durability.

On the other hand, an inorganic acid salt of a transition metal ion, due to the large difference in polarity with a binder resin and the difficulty of compatibility, reduces the probability of contact with singlet oxygen, resulting in insufficient chromaticity durability.

Examples of the organic acid include carboxylic acid, thiocarboxylic acid, dithiocarboxylic acid, sulfonic acid, sulfinic acid, sulfenic acid, sulfamic acid, phenol, alcohols, thiols, carbamic acid, thiocarbamic acid, dithiocarbamic acid, diketone such as acetylacetone, phosphoric acid, thiophosphoric acid, and dithiophosphoric acid. Two or more of them may be contained. Among them, carboxylic acid, sulfonic acid, dithiocarbamic acid, and dithiophosphoric acid are preferable, and carboxylic acid, sulfonic acid, and diketones are more preferable, and carboxylic acid and diketones are still more preferable.

Examples of the carboxylic acid include formic acid, acetic acid, propionic acid, 2-ethylhexanoic acid, octanoic acid, caprylic acid, and benzoic acid. Among them, 2-ethylhexanoic acid is used according to the present invention.

Examples of the sulfonic acid include benzenesulfonic acid, p-toluenesulfonic acid, methanesulfonic acid, camphorsulfonic acid, and bis(2-ethylhexyl)sulfosuccinate. Among them, bis(2-ethylhexyl)sulfosuccinate is used according to the present invention.

Examples of the dithiocarbamic acid include dimethyldithiocarbamic acid, diethyldithiocarbamic acid, dibutyldithiocarbamic acid, dibenzyldithiocarbamic acid, hexamethylenedithiocarbamic acid, and pyrrolidine-N-dithiocarbamic acid. Examples of the dithiophosphoric acid include *O,O*'-diethyldithiophosphoric acid.

Examples of the diketones include α-diketones such as diacetyls, β-diketones such as acetylacetone, and γ-diketones such as 2,5-hexanedione. Among them, β-diketones are used according to the present invention.

As described above, the component (C), in order to act well as a singlet oxygen quencher, is preferably uniformly dispersed in a binder resin that is a component (B) without aggregation. In view of obtaining good solubility in a binder resin, the organic acid preferably has a substituent such as an alkyl group, a cycloalkyl group, a heterocyclic group, an alkenyl group, a cycloalkenyl group, an alkynyl group, a thiol group, an alkoxy group, an alkylthio group, an aryl ether group, an aryl thioether group, an aryl group, a heteroaryl group, halogen, a cyano group, an aldehyde group, a carbonyl group, a carboxyl group, an oxycarbonyl group, a carbamoyl group, an amino group, a nitro group, a silyl group, a siloxanyl group, a boryl group, or a phosphine oxide group. At least some of the hydrogen atoms of these substituents may be further substituted by the substituents described above. Among them, any of a substituted or unsubstituted alkyl group, a substituted or unsubstituted cycloalkyl group, and a substituted or unsubstituted aryl group is preferably contained, and a substituted or unsubstituted alkyl group and/or a substituted or unsubstituted cycloalkyl group is/are more preferably contained.

In order to prevent reduction of the quantum yield of the component (A) due to the component (C), the organic acid preferably has an appropriately bulky substituent. The color conversion composition according to the present invention contains the component (A) and component (C) in the same layer, and thus the component (A) and component (C) can collide with each other due to thermal diffusion. When the component (C) and an excited luminescent material collide with each other, excitation energy of the luminescent material may be transferred to the component (C) molecule, and the excited luminescent material may be deactivated, resulting in reduction of the quantum yield of the component (A).

In the present invention, the organic acid having a bulky substituent can prevent collision of the component (A) and component (C), and thereby prevent reduction of the quantum yield of the component (A). Therefore, the carbon number of a substituted or unsubstituted alkyl group contained in the organic acid is preferably 2 or more, more preferably 4 or more, still more preferably 6 or more, and particularly preferably 7 or more.

The alkyl group contained in the organic acid is a 2-ethylhexyl group. The carbon number of the substituted or unsubstituted cycloalkyl group contained in the organic acid is preferably from 6 to 20, and more preferably, the carbon number is from 6 to 20, and the number of the carbons forming the ring structure of the cycloalkyl group is 6 or more. Specific examples of the cycloalkyl group contained in the organic acid include a cyclohexyl group, a cycloheptyl group, a cyclooctyl group, a norbornyl group, and an adamantyl group. The carbon number of the substituted or unsubstituted aryl group contained in the organic acid is preferably from 6 to 40. Specific examples of the aryl group contained in the organic acid include a phenyl group and a naphthyl group. The appropriately bulky substituent is preferably a substituent having a carbon number of 4 or more, which is preferably a butyl group, a cyclohexyl group, a phenyl group, or a naphthyl group.

According to the present invention, the organic acid is selected from ethylhexanoic acid and derivatives thereof, acids having an ethylhexyl group, and β-diketones.

Among them, β-diketones having a cycloalkyl group are preferable, and β-diketones having at least two cycloalkyl groups are more preferable. When β-diketone has a cycloalkyl group, it is preferably selected from the group consisting of a cyclohexyl group, a *cycloheptyl group, a cyclooctyl group, a norbornyl group, and an adamantyl group.

Examples of the organic acid are shown below, wherein those acids marked with "*" are used according to the present invention.

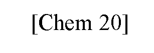

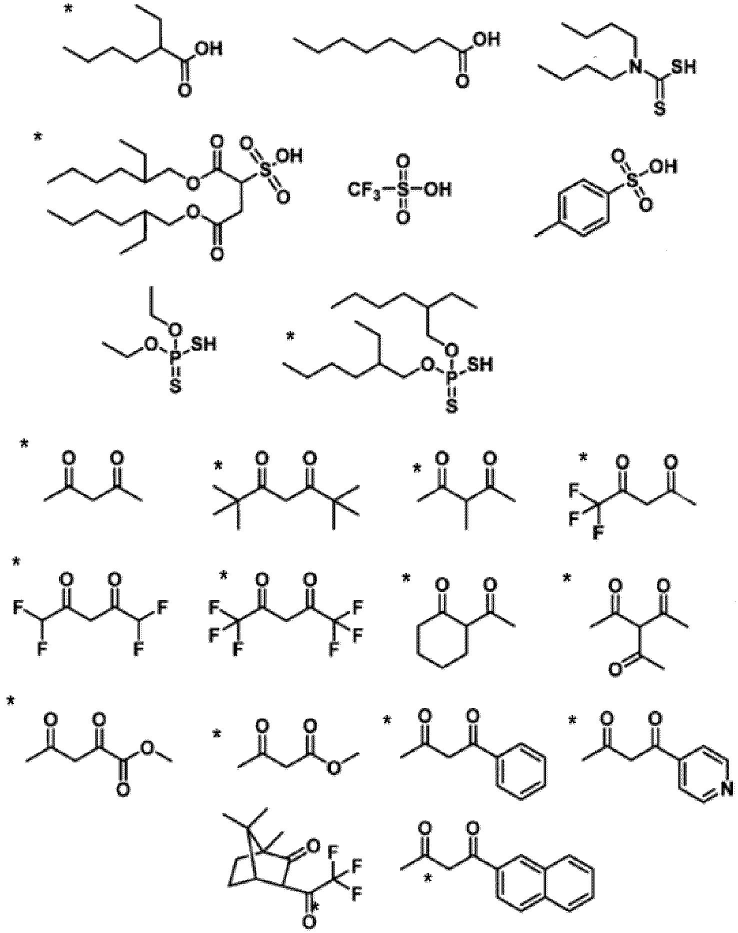

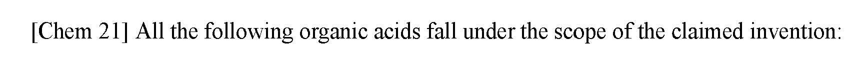

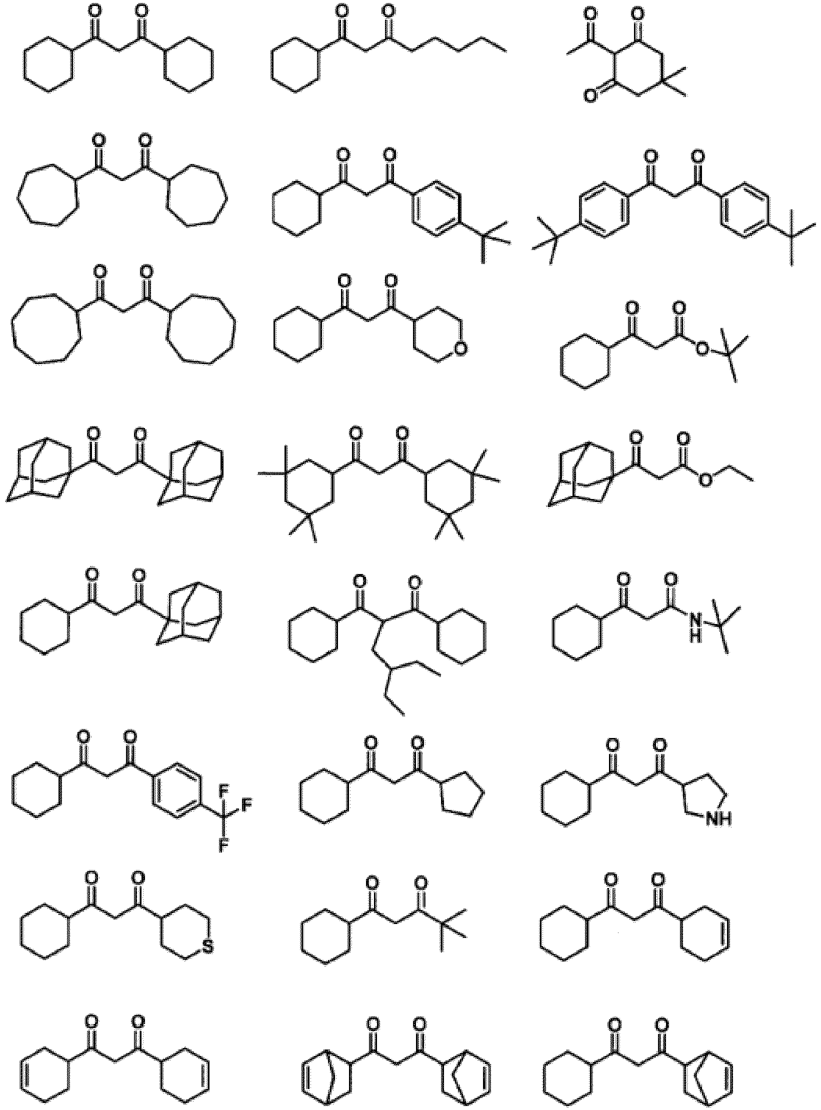

The amount of the component (C) in the color conversion composition of the present invention can be selected depending on the molar extinction coefficient, fluorescence quantum yield, and absorption intensity at the excitation wavelength of the compound and the thickness and transmittance of the film formed. Here, the amount of the component (C) in the case where two or more components (C) are contained means the total amount thereof. The amount of the component (C) is preferably 1.0 × 10⁻⁵ parts by weight or more, more preferably 1.0 × 10⁻⁴ parts by weight or more, and still more preferably 1.0 × 10⁻³ parts by weight or more, per 100 parts by weight of the component (B), in view of further improving the chromaticity durability. On the other hand, the amount of the component (C) is preferably 1 part by weight or less, more preferably 1.0 × 10⁻¹ parts by weight or less, and still more preferably 1.0 × 10⁻² parts by weight or less, per 100 parts by weight of the component (B), in view of improving the quantum yield.

### <Other Additives>

In addition to the component (A), component (B), and component (C), the color conversion composition of the present invention may contain additives such as fillers, antioxidants, processing and heat stabilizers, light fastness stabilizers such as ultraviolet absorbers, dispersants and leveling agents for stabilizing the coated film, scattering agents, plasticizers, crosslinking agents such as epoxy compounds, curing agents such as amine, acid anhydride, and imidazole, pigments, and adhesion aids such as silane coupling agents as modifiers for the film surface.

Examples of the fillers include fumed silica, glass powder, quartz powder, and other particles, titanium oxide, zirconium oxide, barium titanate, zinc oxide, and silicone microparticles. Two or more of them may be contained.

Examples of the antioxidants include phenol antioxidants such as 2,6-di-tert-butyl-p-cresol and 2,6-di-tert-butyl-4-ethylphenol. Two or more of them may be contained.

Examples of the processing and heat stabilizers include phosphorus-based stabilizers such as tributyl phosphite, tricyclohexyl phosphite, triethylphosphine, and diphenylbutylphosphine. Two or more of them may be contained.

Examples of the light fastness stabilizers include benzotriazoles such as 2-(5-methyl-2-hydroxyphenyl)benzotriazole, and 2-[2-hydroxy-3,5-bis(α,α-dimethylbenzyl)phenyl]-2H-benzotriazole. Two or more of them may be contained.

The amount of the additives in the color conversion composition of the present invention can also be set depending on the molar extinction coefficient, fluorescence quantum yield, and absorption intensity at the excitation wavelength of the compound, and the thickness and transmittance of the film formed. The amount of the additives is preferably from 1.0 × 10⁻¹ parts by weight to 10 parts by weight per 100 parts by weight of the component (B).

### <Solvent>

The color conversion composition of the present invention may further contain a solvent. Preferably, the solvent can adjust the viscosity of a resin in a flowing state, and does not excessively affect the emission from a luminescent substance and the durability. The solvent may be, for example, water, 2-propanol, ethanol, toluene, methyl ethyl ketone, methyl isobutyl ketone, cyclohexanone, hexane, acetone, ethyl acetate, butyl acetate, terpineol, Texanol, Methyl Cellosolve, Ethyl Cellosolve, butyl carbitol, butyl carbitol acetate, 1-methoxy-2-propanol, or propylene glycol monomethyl ether acetate. Two or more of them may be contained. Especially among these solvents, ethyl acetate does not affect deterioration of the compound represented by Formula (1), leaves less residual solvent after drying and therefore, is suitably used.

The amount of the residual solvent after drying in a color conversion layer containing the color conversion composition of the present invention or a cured product thereof is preferably 3.0% by weight or less, more preferably 1.0% by weight or less, and still more preferably 0.5% by weight or less in view of further improving the durability of the color conversion film. When the amount of the residual solvent is 3.0% by weight or less, solvation of the component (C) by the solvent remaining in the color conversion layer is prevented, so that the probability of collision between the component (C) and singlet oxygen can be reduced. This can provide improved the effect of quenching singlet oxygen by the component (C), resulting in further improved durability of the color conversion film, and thus is preferred.

The amount of the residual solvent is preferably 0.01% by weight or more, more preferably 0.05% by weight or more, and still more preferably 0.1% by weight or more, in view of improving the quantum yield of the color conversion film. When the amount of the residual solvent is 0.01% by weight or more, proximity between the component (A) and the component (C) through intermolecular forces can be prevented, so that the probability of collision between the component (A) and the component (C) can be reduced. As a result, reduction of the quantum yield of the color conversion sheet caused by transfer of excitation energy of the component (A) to the component (C) molecule can be prevented.

The amount of the residual solvent in the color conversion layer can be measured by gas chromatography. First, 20 mg of the composition that forms the color conversion layer is weighed, and dissolved in 2 mL of an organic solvent to prepare a sample for measuring the amount of the residual solvent. For preparation of the sample for measuring the amount of the residual solvent, a different organic solvent from the organic solvent remaining in the color conversion layer is used. For example, xylene, N-methylpyrrolidone (NMP), and anisole can be suitably used. The organic solvent remaining in the color conversion layer can be identified by GC/MS measurement. Then, measurement can be done using a measuring machine GC-2010 manufactured by Shimadzu Corporation under the following conditions:
Detector: FID
Column used: CP-Select 624 CB
Detector temperature: 280°C
Carrier gas: He
Carrier gas: flow rate of 6 mL/min
Temperature rising condition: held at 40°C for 4 minutes, rose to 260°C at a rising rate of 8 °C/min, and then held for 16 minutes.

### <Production Method of Color Conversion Composition>

One example of the method of producing the color conversion composition of the present invention will be described below. The above-described components (A) to (C), and as necessary additives, solvents, and the like can be mixed so that a predetermined composition is achieved, and then homogeneously mixed or kneaded using a stirrer/kneader to obtain a color conversion composition. Examples of the stirrer/kneader include homogenizers, rotation-revolution stirrers, three-roll mills, ball mills, planetary ball mills, and beads mills. After mixing or dispersing, or in the process of mixing or dispersing, defoaming is also preferably performed under a vacuum or reduced-pressure condition. In addition, it may also be possible to mix specific components in advance or apply a treatment such as aging. The solvent may be removed by an evaporator to give a desired solid content concentration.

### <Color Conversion Film>

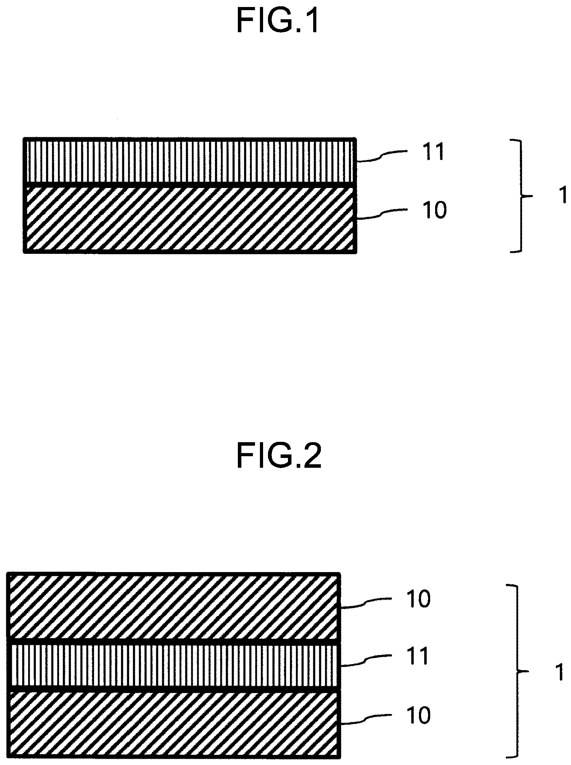

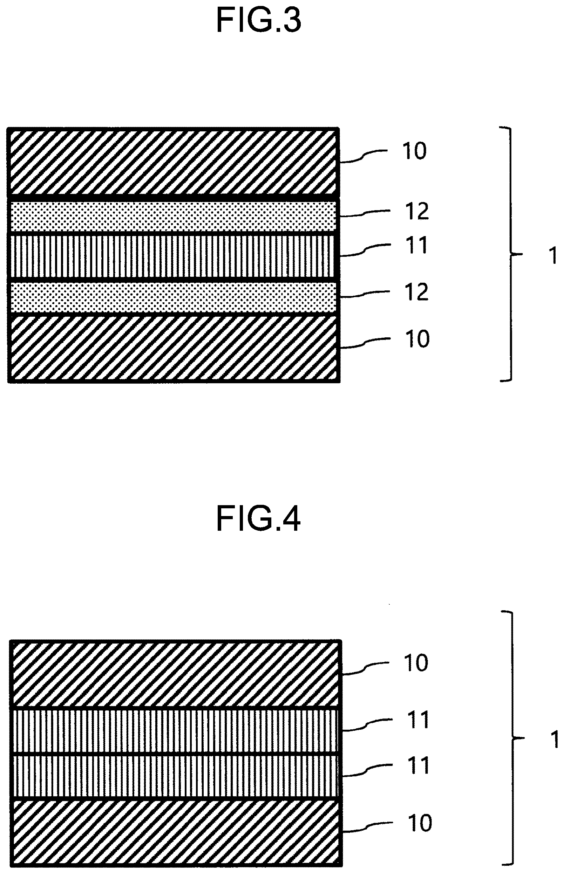

The color conversion film of the present invention comprises the above-described color conversion composition and/or a cured product thereof. A color conversion layer containing the color conversion composition or a cured product thereof, and as necessary a substrate layer and a barrier film, may be contained. Two or more of these layers may be contained. Figs. 1 to 4 show schematic cross-sectional views illustrating embodiments of the color conversion film of the present invention as representative structural examples of the color conversion film. The color conversion film shown in Fig. 1 has a laminated structure of a substrate layer 10 and a color conversion layer 11. The color conversion film shown in Fig. 2 has a laminated structure in which a color conversion layer 11 is sandwiched between a plurality of substrate layers 10. The color conversion film shown in Fig. 3 has a laminated structure in which a color conversion layer 11 is sandwiched between a plurality of barrier films 12 and substrate layers 10. The color conversion film shown in Fig. 4 has a laminated structure in which a plurality of color conversion layers 11 is sandwiched between a plurality of substrate layers 10.

The thickness of the color conversion film is preferably from 30 to 300 µm. As used herein, the thickness of the color conversion film refers to the total thickness of all layers contained in the color conversion film, and refers to the film thickness (average film thickness) measured based on JIS K7130 (1999), Plastics-Film and sheeting-Determination of thickness, Measurement Method A, a method of measuring the thickness by mechanical scanning. When the thickness of the color conversion film is 30 µm or more, the toughness of the film can be improved. When the thickness is 300 µm or less, cracking can be prevented.

### (Substrate Layer)

The substrate layer may be, for example, glass or a resin film. The resin film is preferably a plastic film such as polyethylene terephthalate (PET), polyphenylene sulfide, polycarbonate, polypropylene, or polyimide. For the reason that separation of the film is facilitated, the surface of the substrate layer may be previously subjected to a release treatment. The thickness of the substrate layer is preferably from 38 to 3000 µm.

### (Color Conversion Layer)

The color conversion layer comprises the above-described color conversion composition or a cured product thereof. When a plurality of color conversion layers is included, the color conversion layers may be laminated directly or via an adhesive layer. The thickness of the color conversion layer is preferably from 30 to 100 µm.

### (Barrier Film)

The barrier film preferably prevents entry of oxygen, water, heat, and the like into the color conversion layer, and may have two or more barrier films. The light conversion layer may have barrier films on the both sides, or a barrier film on one side.

The film having gas barrier properties may be, for example, a film composed of an inorganic oxide such as silicon oxide, aluminum oxide, titanium oxide, tantalum oxide, zinc oxide, tin oxide, indium oxide, yttrium oxide, or magnesium oxide; an inorganic nitride such as silicon nitride, aluminum nitride, titanium nitride, or silicon carbide nitride; a metallic oxide thin film or a metal nitride thin film with another element added thereto; or a film composed of a resin such as polyvinylidene chloride, an acrylic resin, a silicone resin, a melamine resin, a urethane resin, a fluorine resin, or a polyvinyl alcohol resin, e.g., saponified vinyl acetate. Two or more of them may be contained. The film having a barrier function against water may be, for example, a film composed of a resin such as polyethylene, polypropylene, nylon, polyvinylidene chloride, a vinylidene chloride-vinyl chloride copolymer, a vinylidene chloride-acrylonitrile copolymer, a fluorine resin, or a polyvinyl alcohol resin, e.g., saponified vinyl acetate.

According to the function required, the color conversion film of the present invention may further have a light diffusion layer, an adhesive layer, and an auxiliary layer having an antireflection function, an antiglare function, an antireflection-antiglare function, a hardcoat function (anti-friction function), an antistatic function, an antifouling function, an electromagnetic wave shielding function, an infrared cutting function, an ultraviolet cutting function, a polarizing function, or a toning function.

### <Method of Producing Color Conversion Film>

One example of the method for producing the color conversion film of the present invention is described below. The color conversion composition prepared in the manner as described above was applied to a substrate, and dried to form a color conversion layer. When the binder resin is a thermosetting resin, the color conversion composition may be applied to a substrate, and then thermally cured to form a color conversion layer. When the binder resin is a photocurable resin, the color conversion composition may be applied to a substrate, and then photo-cured to form a color conversion layer.

The coating can be performed by means of a reverse roll coater, a blade coater, a slit die coater, a direct gravure coater, an offset gravure coater, a kiss coater, a natural roll coater, an air knife coater, a roll blade coater, a two-stream coater, a rod coater, a wire bar coater, an applicator, a dip coater, a curtain coater, a spin coater, a knife coater, or the like. In order to achieve thickness uniformity of the color conversion layer, the composition is preferably applied by means of a slit die coater, a comma coater, or a dip coater.

The color conversion layer can be dried using a general heating apparatus such as hot air drier or infrared drier. In this case, the heating temperature is preferably from 60 to 200°C, and the heating time period is preferably from 2 minutes to 4 hours. It is also possible to perform stepwise thermal curing by step-cure or other methods.

When the color conversion layer is formed by thermal curing, the heating apparatus may be, for example, a hot air oven. The heating conditions can be selected depending on the binder resin. For example, the heating temperature is preferably from 100°C to 300°C, and the heating time period is preferably from 1 minute to 2 hours.

When the color conversion layer is formed by photo-curing, high-energy light such as ultraviolet rays is preferably irradiated. The photoirradiation conditions can be selected depending on the binder resin. For example, the wavelength of the irradiated light is preferably from 200 nm to 500 nm, and the amount of irradiation is preferably from 10 mJ/cm² to 10 J/cm².

After preparing the color conversion layer, the substrate may be changed, as necessary. In this case, simple methods include, for example, methods of re-laminating the substrate by using a hot plate, and methods using a vacuum laminator or a dry film laminator.

### <Light Source Unit>

The light source unit of the present invention comprises at least a light source, and a color conversion composition or a color conversion film.

### <Light Source>

As for the type of the light source, any light source may be used as long as it emits light in the wavelength region where the mixed luminescent substance such as the compound represented by Formula (1) can absorb light. For example, any light source, including a fluorescent light source such as a hot cathode fluorescent lamp, a cold cathode fluorescent lamp, or an inorganic EL, an organic electroluminescence element light source, an LED light source, an incandescent light source, or sunlight can be utilized in principle. Among them, an LED is a suitable light source, and in display or lighting applications, a blue LED having a light source in the range of 430 to 500 nm is more suitable light source from the viewpoint that the color purity of blue light is enhanced.

The light source may have one emission peak or two or more emission peaks, and is preferably have one emission peak in order to increase the color purity. It is also possible to use arbitrary combination of a plurality of light sources with different emission peaks.

In the case where the light source unit of the present invention comprises the color conversion composition, the positions of the light source and the color conversion composition are not particularly limited, and the color conversion composition may be applied directly to the light source, or the color conversion composition may be applied to a film, glass, or the like. kept separate from the light source. In the case where the light source unit of the present invention comprises the color conversion composition, the positions of the light source and the color conversion film are not particularly limited, and the light source may be in close contact with the color conversion film, or may employ a remote phosphor system in which the light source is separated from the color conversion film. In addition, for the purpose of increasing the color purity, the unit may further comprise a color filter.

The light source unit of the present invention is useful for various light sources such as spatial lighting, backlighting, and the like, and specifically for display, lightning, interior, indicator and signboard applications, and is particularly suitable for use in display and lightning applications, in particular.

### <Compounds>

A compound having a structure represented by Formula (3) will be described in detail: 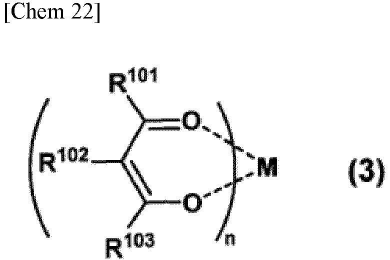 wherein,
each of R¹⁰¹ to R¹⁰³, which may be the same as or different from one another, is selected from a hydrogen atom, an alkyl group, a cycloalkyl group, a heterocyclic group, an alkenyl group, a cycloalkenyl group, an alkynyl group, a hydroxyl group, a thiol group, an alkoxy group, an alkylthio group, an aryl ether group, an aryl thioether group, an aryl group, a heteroaryl group, halogen, a cyano group, an aldehyde group, a carbonyl group, a carboxyl group, an oxycarbonyl group, a carbamoyl group, an amino group, a nitro group, a silyl group, a siloxanyl group, a boryl group, a phosphine oxide group, and a fused ring and an aliphatic ring each formed between adjacent substituents;
provided that the following conditions (A) and (B) are satisfied:
   Condition (A): one of R¹⁰¹ to R¹⁰³ is a cycloalkyl group (a) having a carbon number of 6 or more; and
   Condition (B): at least one of the others than condition (A) is selected from an aryl group, a cycloalkyl group (b), a cycloalkenyl group, an aliphatic heterocyclic group, and an alkyl group having a carbon number of 5 or more.

Examples of the cycloalkyl group (a) having a carbon number of 6 or more include the groups illustrated as the substituted or unsubstituted cycloalkyl group in the component (C) as described above.

The cycloalkyl group (b) is preferably a substituted or unsubstituted cycloalkyl group having a carbon number from 3 to 20. The cycloalkyl group (b) is more preferably a substituted or unsubstituted cycloalkyl group in which the carbon number is from 3 to 20, and the number of the carbons forming the ring structure of the cycloalkyl group is 3 or more. The cycloalkyl group (b) is still more preferably a substituted or unsubstituted cycloalkyl group in which the carbon number is from 5 to 20, and the number of the carbons forming the ring structure of the cycloalkyl group is 5 or more. The cycloalkyl group (b) is even still more preferably a substituted or unsubstituted cycloalkyl group in which the carbon number is from 6 to 20, and the number of the carbons forming the ring structure of the cycloalkyl group is 6 or more.

When the compound represented by Formula (3) satisfies the conditions (A) and (B), oxidation of R¹⁰¹ to R¹⁰³ due to oxygen can be prevented, and thus the stability of the compound according to Formula (3) against singlet oxygen is further improved, and the function as a singlet oxygen quencher is further improved. Since a cycloalkyl group having a carbon number of 6 or more is bulky, it can be introduced to at least one of R¹⁰¹ to R¹⁰³ to sterically protect the metal.

In addition, when the compound represented by Formula (3) satisfies the conditions (A) and (B), the interaction between the compounds represented by Formula (3) can be prevented, and aggregation of the compound represented by Formula (3) can be prevented.

When the compound represented by Formula (3) satisfies the condition (A), the metal M contained in Formula (3) can be sufficiently protected. As a result, the probability of collision with luminescent materials in the color conversion layer can be reduced, thereby preventing reduction of the quantum yield of luminescent materials and further improving the chromaticity durability of the color conversion film.

The compound represented by Formula (3) may also be a hydrate.

M is selected from the group consisting of Sc, V, V=O, Mn, Ni, Cu, Zr, O=Mo=O, and Ag.

n is an integer of 2 to 4. When n is 2, M is preferably Cu, V=O, Mn, or Ni. When n is 3, M is preferably V or Mn. When n is 4, M is preferably Zr. In particular, in Formula (3), it is more preferred that M is Cu and n is 2.

Preferred examples of the compound according to the present invention are shown below.

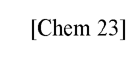

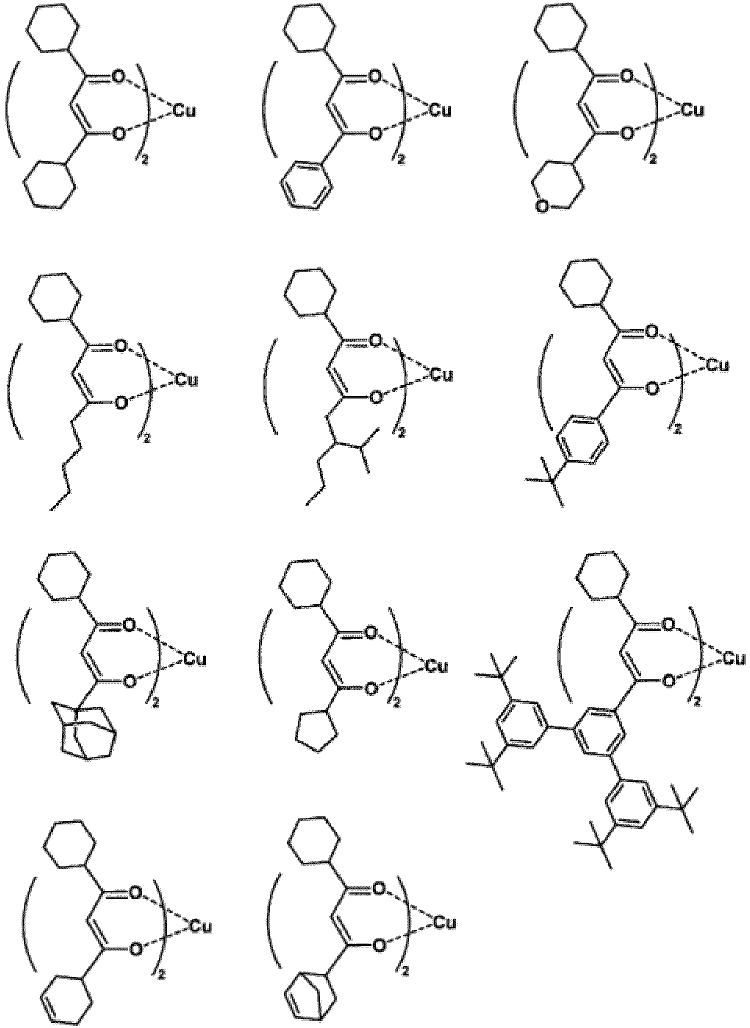

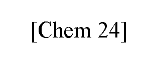

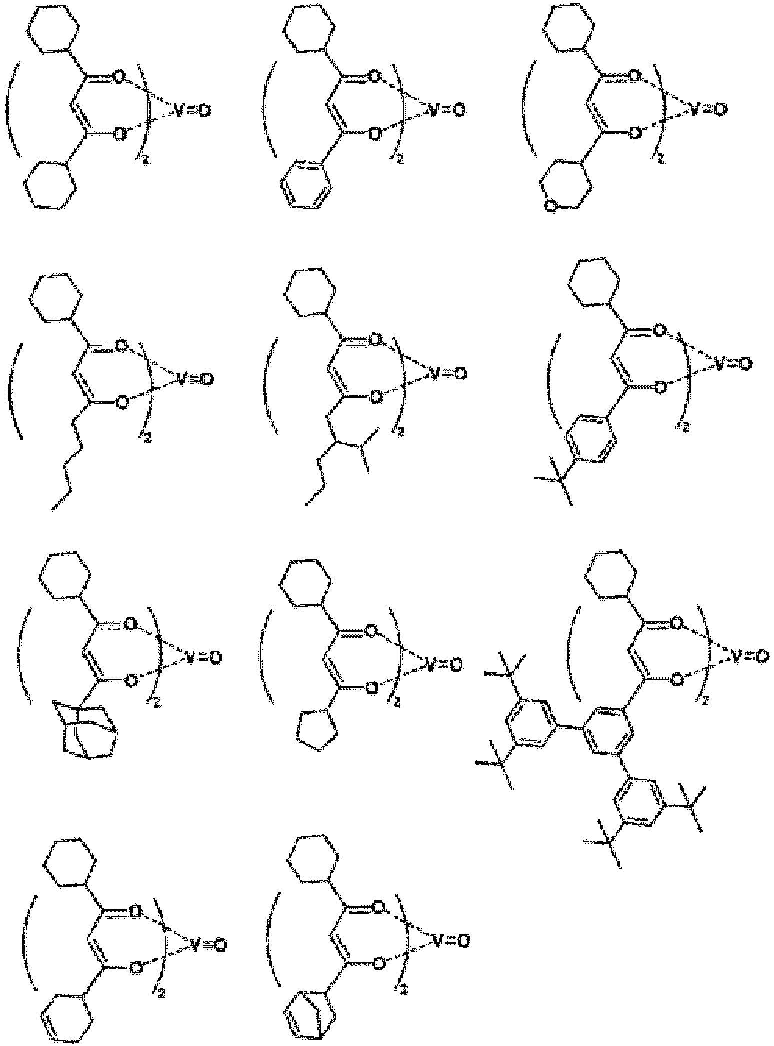

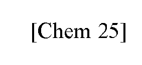

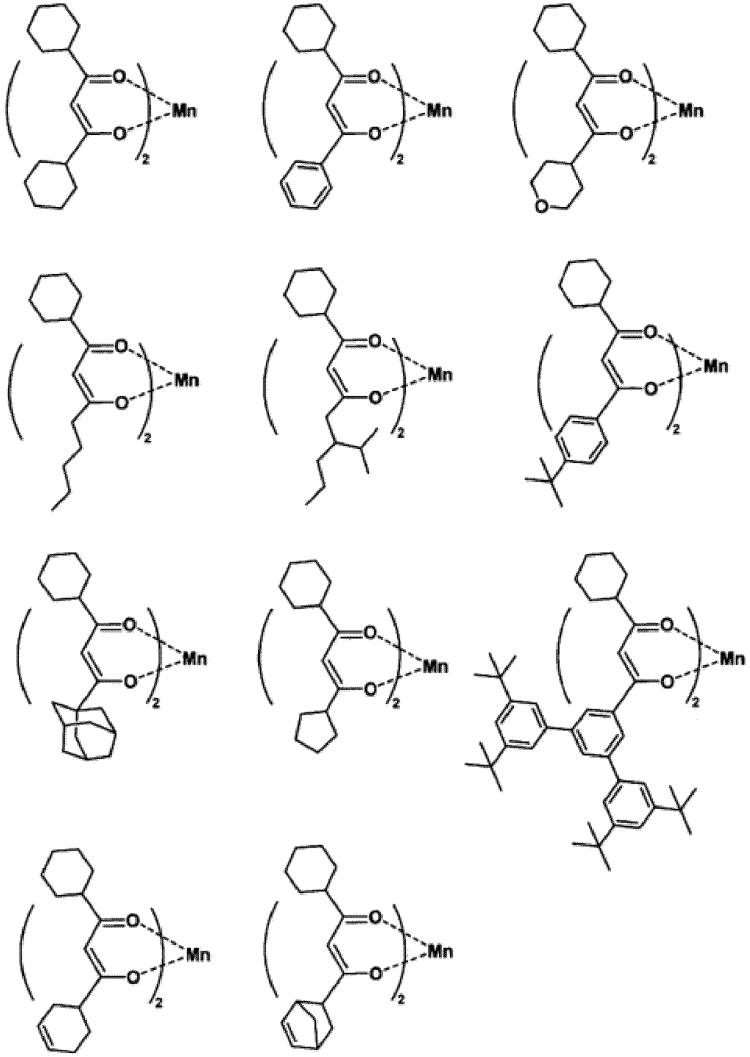

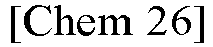

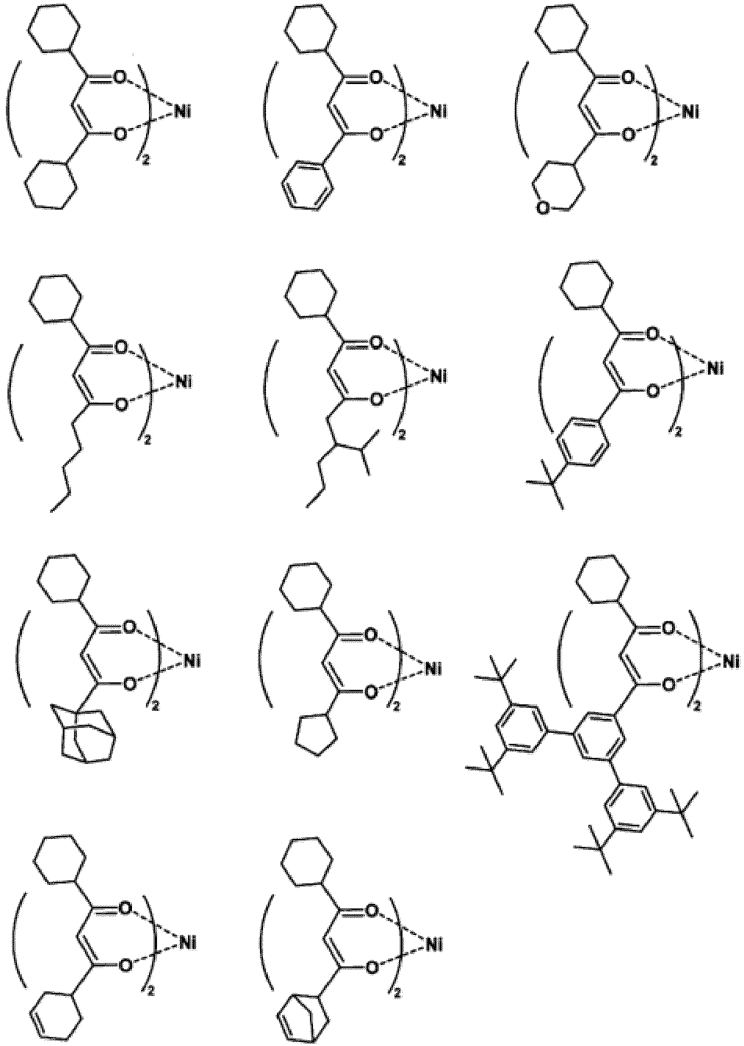

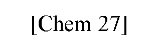

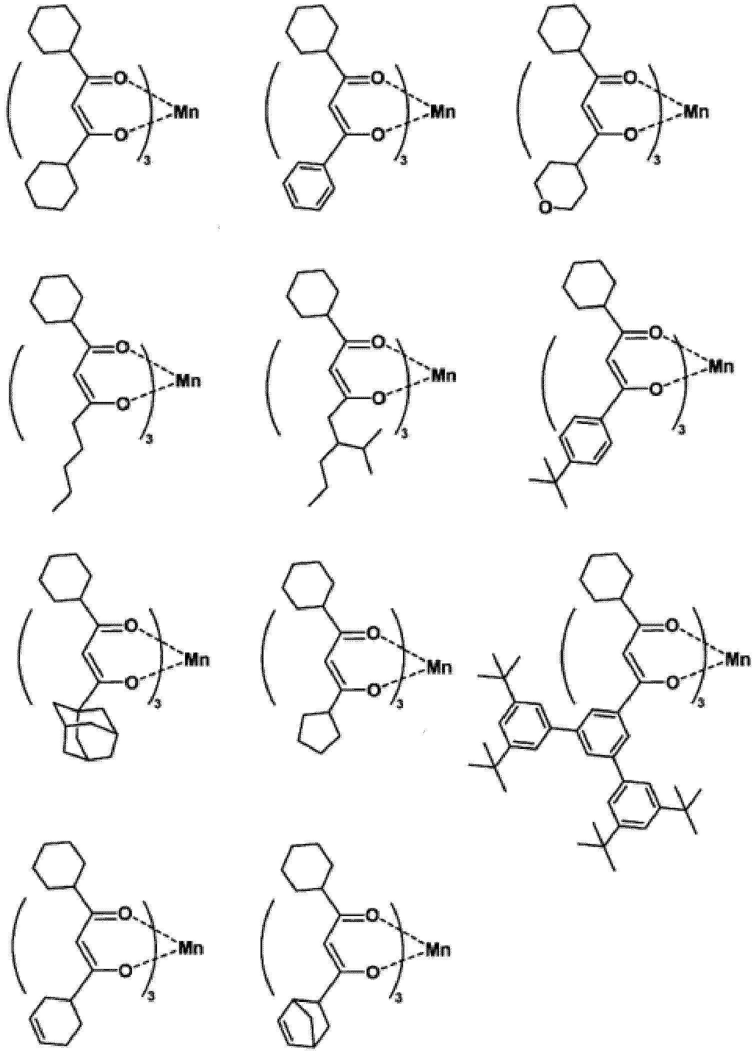

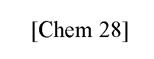

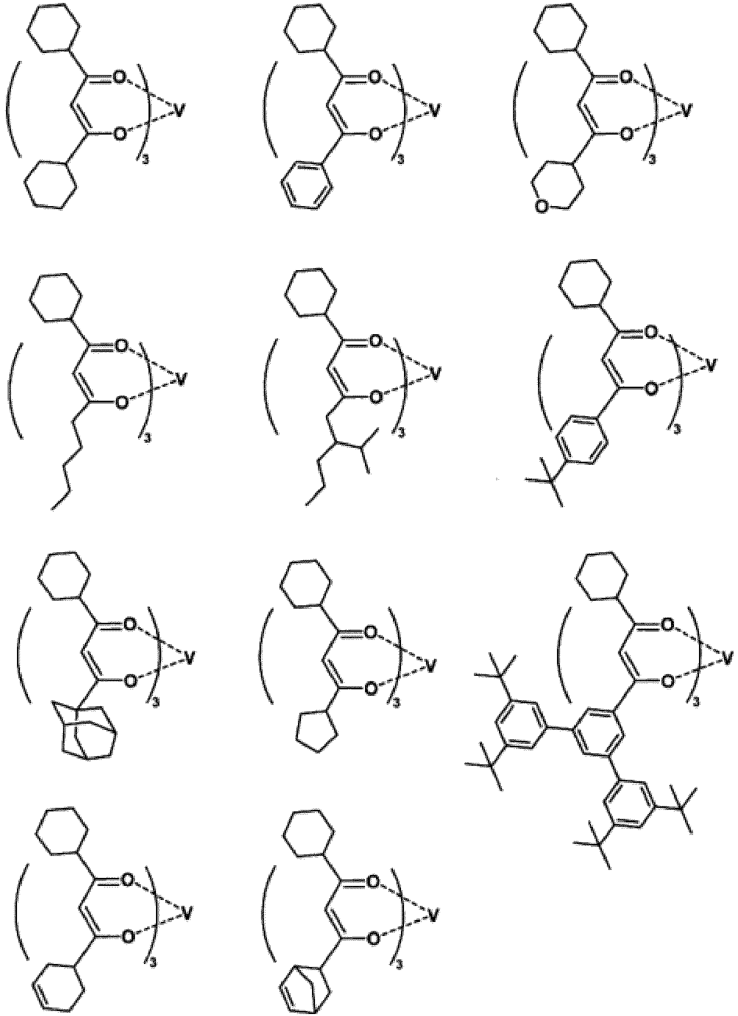

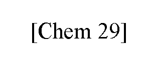

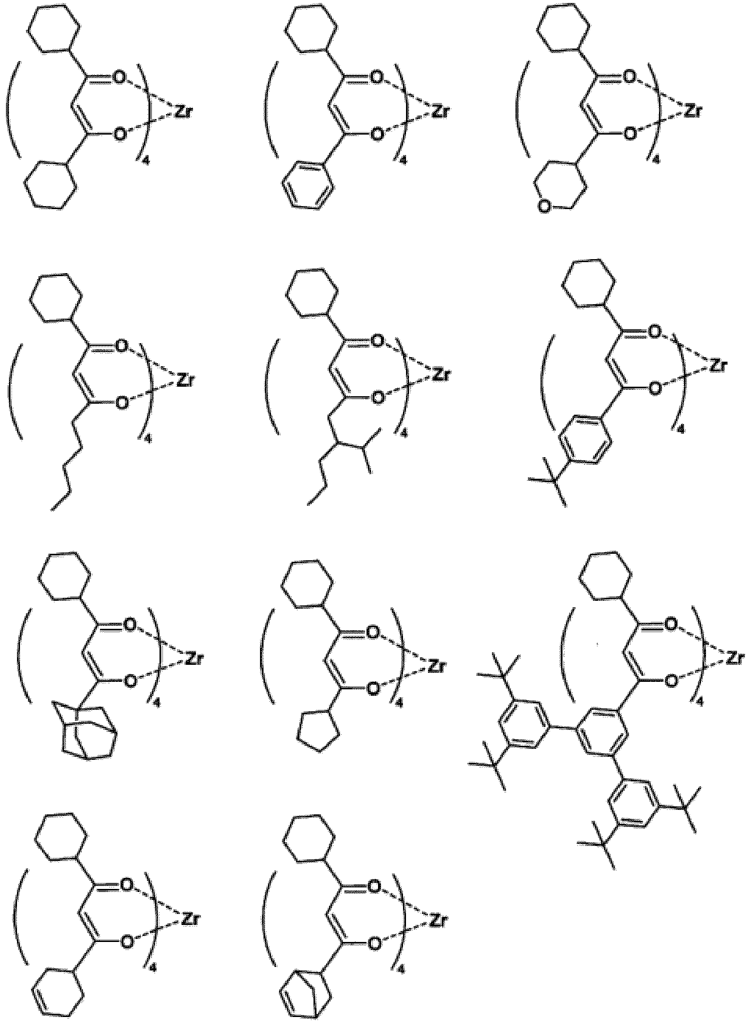

The compound represented by Formula (3) has a highly planar skeleton, and thus can be used as a catalyst or a singlet oxygen quencher. Especially, the compound represented by Formula (3) can efficiently absorb the excitation energy of singlet oxygen, and thus is preferably used as a singlet oxygen quencher in a color conversion film.

### Examples

The present invention is described below by referring to Examples, but the present invention is not limited by these Examples. First, evaluation methods in Examples will be described.

### <Evaluation of Chromaticity Durability>

A blue LED was lighted by flowing a current of 30 mA to a light emitting device with a color conversion film each prepared in Examples and Comparative Examples, and the blue LED (Model Number SMBB450H-1100, manufactured by Ushio Epitex Inc., emission peak wavelength: 450 nm) mounted therein, and measured for the initial chromaticity (x, y) by using a spectral radiance meter (CS-1000, manufactured by Konica Minolta, Inc.). The distance between each color conversion film and the blue LED element was set to be 3 cm. Then, after continuous irradiation of light from the blue LED element under an environment at 50°C for 1,000 hours, the chromaticity (x, y) was measured in the same manner, and the deviation (Δx, Δy) from the initial chromaticity was calculated to evaluate the chromaticity durability of the color conversion film.

### <Measurement of¹H-NMR>

¹H-NMR of the compound was measured with a deuterated chloroform solution by using superconducting FTNMR EX-270 (manufactured by JEOL Ltd.).

### <Measurement of Fluorescence Quantum Yield>

The color conversion films prepared in Examples and Comparative Examples were cut into 8 mm x 8 mm samples, which were then excited with an excitation light of 450 nm and analyzed for their fluorescence quantum yields using an absolute fluorescence quantum yield meter Quantaurus-QY manufactured by Hamamatsu Photonics K.K.

### <Measurement of Amount of Residual Solvent>

The amounts of residual solvent in green and red color conversion layers were measured by the following procedure. A green or red color conversion layer formed on a polyester film "LUMIRROR" (registered trademark) U48 (Toray Industries, Inc.; thickness: 50 µm) was separated from the polyester film, and then 20 mg of only the color conversion layer was weighed out. Next, the separated layer was dissolved in 2 mL of NMP to prepare a sample for measuring the amount of the residual solvent. Measurement was done using a measuring machine GC-2010 manufactured by Shimadzu Corporation under the following conditions:
Detector: FID
Column used: CP-Select 624 CB
Detector temperature: 280°C
Carrier gas: He
Carrier gas flow rate: 6 mL/min
Temperature rising condition: held at 40°C for 4 minutes, rose to 260°C at a rising rate of 8 °C/min, and then held for 16 minutes.

Materials used in Examples are shown below.

### <Luminescent materials, and Salts of Transition Metals and Organic Acids>

In the following Examples and Comparative Examples, Compounds G-1, G-4, R-1, R-4, and A-1 to A-9 are the compounds shown below.

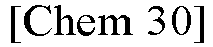

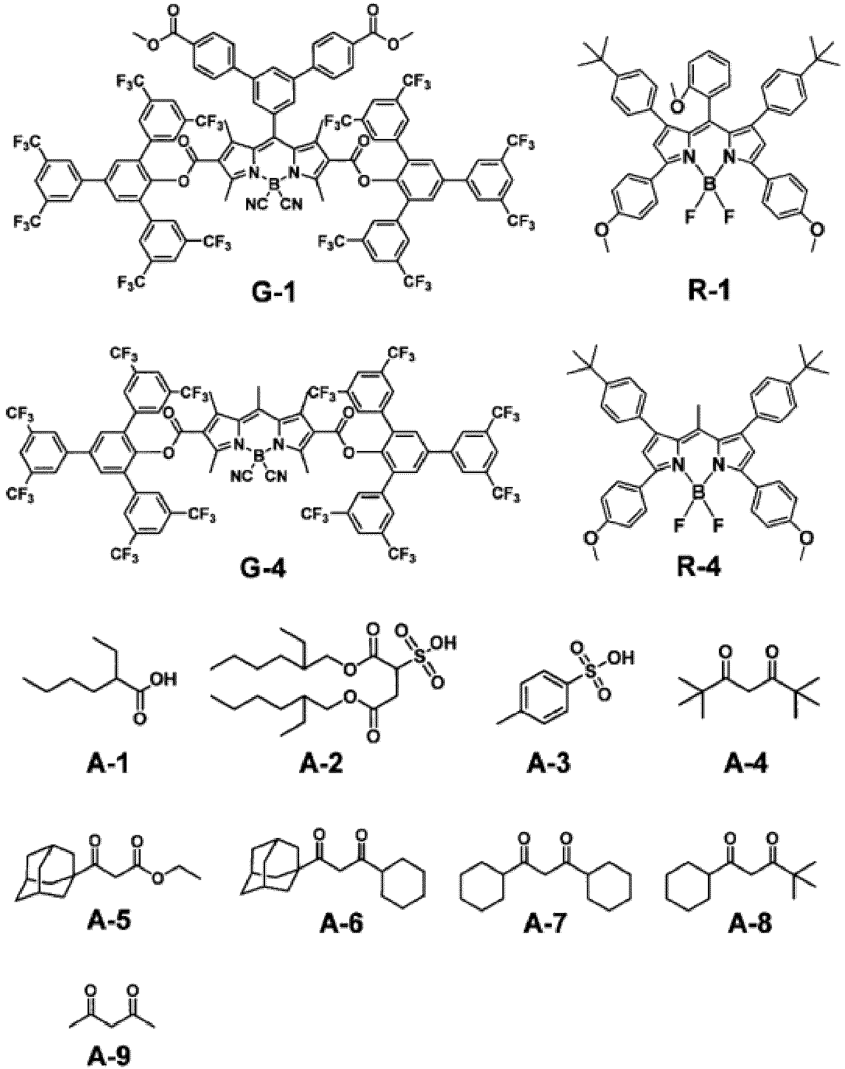

G-2: an organic luminescent material other than the compound represented by Formula (1) (coumarin 6 manufactured by Sigma-Aldrich Co. LLC);
G-3: a quantum dot manufactured by Sigma-Aldrich Co. LLC (Product No. 753777);
R-2: an organic luminescent material other than the compound represented by Formula (1) ("Lumogen" (registered trademark) F Red 300, manufactured by BASF SE);
R-3: a quantum dot manufactured by Sigma-Aldrich Co. LLC (Product No. 753882).

In Examples and Comparative Examples below, Q-1 to -15 are salts each of a combination of a transition metal ion and an organic acid anion shown in Table 1. X-1, X-2, and X-3 are the compounds shown below.

### (Synthesis Example 1)

### Synthesis Method of Compound Q-12

To a flask were added 7.4 g of potassium tert-butoxide, 5.0 g of cyclohexyl methyl ketone, and super dehydrated DMF (40 mL), and then 3.8 g of methyl cyclohexanecarboxylate was added by a small amount under a heating condition of 55°C followed by stirring for 2 hours. After cooling the internal temperature to 10°C or lower using an ice bath, a few drops of an aqueous solution of 10% by mass hydrochloric acid were added to neutralize the reaction solution, followed by addition of 60 mL of water and stirring for 10 minutes. The precipitated solids were removed by filtration, and the solids were washed with water. The obtained reaction product was purified by silica gel chromatography to obtain 2.3 g of Compound A-7.

¹H-NMR (CDCl₃, ppm): 15.70 (br, 1H), 5.52 (s, 1H), 2.17 (m, 2H), 1.84 (m, 8H), 1.71 (m, 2H), 1.35 (m, 10H.

To a flask were added 0.6 g of Compound A-7 and 5 mL of methanol, and a few drops of an aqueous solution of 10% by mass potassium were added to adjust the pH into 10, followed by stirring at room temperature for 10 minutes. A reaction solution obtained by dissolving 0.26 g of copper(II) acetate hydrate in 6.5 mL of pure water was added dropwise, followed by stirring at room temperature for 5 hours. The precipitated solids were removed by filtration, and the solids were washed with water to obtain 0.5 g of Compound Q-12.

Other compounds other than the described above can also easily be synthesized by changing various raw materials such as the ketone raw material and methyl carboxylate raw material.

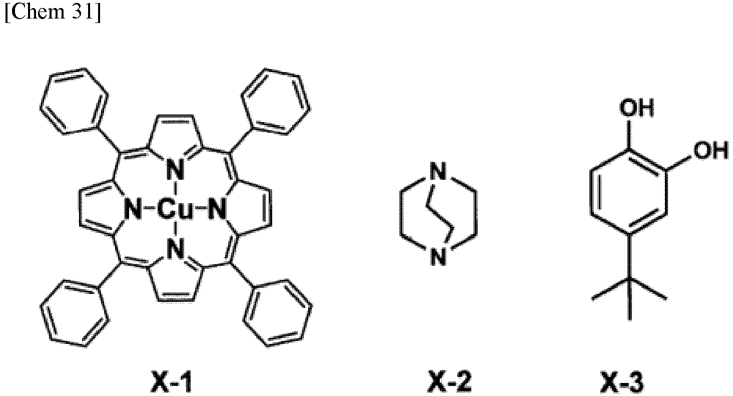

**[Table 1]**

| | transition metal | organic acid |
|---|---|---|
| Q-1 | Ni²⁺ | A-1 |
| Q-2 | Ni²⁺ | A-2 |
| Q-3 | Ni²⁺ | A-3 |
| Q-4 | Nd³⁺ | A-1 |
| Q-5 | Co²⁺ | A-1 |
| Q-6 | Cu²⁺ | A-1 |
| Q-7 | Cu²⁺ | A-2 |
| Q-8 | Cu²⁺ | A-3 |
| Q-9 | Cu²⁺ | A-4 |
| Q-10 | Cu²⁺ | A-5 |
| Q-11 | Cu²⁺ | A-6 |
| Q-12 | Cu²⁺ | A-7 |
| Q-13 | Cu²⁺ | A-8 |
| Q-14 | Nd³⁺ | A-9 |
| Q-15 | Sm³⁺ | A-9 |

### <Resin>

A polymethyl methacrylate resin BR-85 (manufactured by Mitsubishi Chemical Corporation) (glass transition temperature: 105°C) was used as a binder resin for the color conversion layer.

A polyester resin "Vylon" (registered trademark) 630 (Toyobo Co., Ltd.) was used as a resin for the adhesive layer.

### (Example 1)

0.40 parts by weight of Compound G-1, 0.003 parts by weight of Compound Q-4, and 300 parts by weight of ethyl acetate as a solvent were mixed per 100 parts by weight of a binder resin (BR-85), and the mixture was stirred and defoamed at 1,000 rpm for 20 minutes by using a planetary stirring/defoaming device, "MAZERUSTAR" (registered trademark) KK-400 (manufactured by Kurabo Industries Ltd.), to obtain a green color conversion composition as a resin liquid for preparation of a green color conversion layer.

Next, 0.08 parts by weight of Compound R-1, 0.003 parts by weight of Compound Q-4, and 300 parts by weight of ethyl acetate as a solvent were mixed per 100 parts by weight of a binder resin (BR-85), and the mixture was stirred and defoamed at 1,000 rpm for 20 minutes by using a planetary stirring/defoaming device, "MAZERUSTAR" KK-400 (manufactured by Kurabo Industries Ltd.), to obtain a red color conversion composition as a resin liquid for preparation of a red color conversion layer.

Next, 300 parts by weight of ethyl acetate as a solvent was mixed with 100 parts by weight of "Vylon" 630 as a resin, and the mixture was stirred and defoamed at 300 rpm for 20 minutes by using a planetary stirring/defoaming device, "MAZERUSTAR" KK-400 (manufactured by Kurabo Industries Ltd.), to obtain a resin composition for adhesive layer.

Next, the green color conversion composition was applied on a polyester film "LUMIRROR" (registered trademark) U48 (Toray Industries, Inc.; thickness: 50 µm) using a slit die coater, and heated and dried at 120°C for 20 minutes to form a green color conversion layer having a mean film thickness of 20 µm.

Similarly, the red color conversion composition was applied to a light diffusion film "Chemicalmat" 125PW (Kimoto Co., Ltd.; thickness: 138 µm) on the side of the PET substrate layer using a slit die coater, and heated and dried at 120°C for 20 minutes to form a red color conversion layer having a mean film thickness of 20 µm.

Similarly, the resin composition for adhesive layer was applied to the red color conversion layer formed on the PET substrate layer side of the light diffusion film "Chemicalmat" 125PW (Kimoto Co., Ltd.; thickness: 138 µm) using a slit die coater, and heated and dried at 120°C for 20 minutes to form an adhesive layer having a mean film thickness of 10 µm.

Next, the two units were thermally laminated so that the green color conversion layer and the adhesive layer were directly laminated, to prepared a color conversion film having a structure of "substrate layer/green color conversion layer/adhesive layer/red color conversion layer/light diffusion film."

Color conversion of blue light was performed using the prepared color conversion film. As a result, when only the green light emission region was extracted, green light emission showing a peak wavelength of 529 nm and providing an emission spectrum with a half-value width at the peak wavelength of 27 nm was obtained, whereas when only the red light emission region was extracted, red light emission showing a peak wavelength of 635 nm and providing an emission spectrum with a half-value width at the peak wavelength of 50 nm was obtained.

Measurement of the fluorescence quantum yield and evaluation of the chromaticity durability of the color conversion film were performed in the same manner as described above.

### (Examples 2 to 5, 16, 25, 34, 43, and 54, and Comparative Examples 1 to 7)

Color conversion films were prepared in the same manner as Example 1 except that the type and amount of the component (C) added were as shown in Table 2. In Comparative Example 1, the component (C) was not added. In Comparative Examples 2 to 7, the component (C) was not added, and Q-1, Q-2, Q-3, X-1, X-2, and X-3 were added as other additives, respectively. Measurement of the fluorescence quantum yield and evaluation of the chromaticity durability of the color conversion film prepared in Examples and Comparative Examples were performed. The results are shown in Table 2. The results from Example 1 are also shown in Table 2.

**[Table 2]**

| | Example 1 | Example 2 | Example 3 | Example 4 | Example 5 | Example 16 | Example 25 | Example 34 | Example 43 | Example 54 | Comparative Example 1 | Comparative Example 2 | Comparative Example 3 | Comparative Example 4 | Comparative Example 5 | Comparative Example 6 | Comparativ e Example 7 |
|---|---|---|---|---|---|---|---|---|---|---|---|---|---|---|---|---|---|
| Green luminescent material | G-1 | G-1 | G-1 | G-1 | G-1 | G-1 | G-1 | G-1 | G-1 | G-1 | G-1 | G-1 | G-1 | G-1 | G-1 | G-1 | G-1 |
| Red luminescent material | R-1 | R-1 | R-1 | R-1 | R-1 | R-1 | R-1 | R-1 | R-1 | R-1 | R-1 | R-1 | R-1 | R-1 | R-1 | R-1 | R-1 |
| Component (C) | Q-4 | Q-5 | Q-6 | Q-7 | Q-8 | Q-9 | Q-10 | Q-11 | Q-12 | Q-13 | no | no | no | no | no | no | no |
| Other additives | no | no | no | no | no | no | no | no | no | no | no | Q-1 | Q-2 | Q-3 | X-1 | X-2 | X-3 |

| Amount of component (C) and other additives (*1) | 3.0 × 10⁻³ parts by weight | 3.0 × 10⁻³ parts by weight | 3.0 × 10⁻³ parts by weight | 3.0 × 10⁻³ parts by weight | 3.0 × 10⁻³ parts by weight | 3.0 × 10⁻³ parts by weight | 3.0 × 10⁻³ parts by weight | 3.0 × 10⁻³ parts by weight | 3.0 × 10⁻³ parts by weight | 3.0 × 10⁻³ parts by weight | - | 3.0 ×10⁻³ parts by weight | 3.0 ×10⁻³ parts by weight | 3.0 × 10⁻³ parts by weight | 3.0 × 10⁻³ parts by weight | 3.0 × 10⁻¹ parts by weight | 3.0 × 10⁻³ parts by weight |
|---|---|---|---|---|---|---|---|---|---|---|---|---|---|---|---|---|---|
| Ffluorescence quantum yield of color conversion film | 92% | 92% | 92% | 92% | 92% | 92% | 92% | 92% | 92% | 92% | 92% | 88% | 88% | 88% | 63% | 80% | 85% |
| Cchange in chromaticity (Δx) | 0.013 | 0.013 | 0.008 | 0.010 | 0.012 | 0.006 | 0.007 | 0.007 | 0.007 | 0.007 | 0.020 | 0.020 | 0.020 | 0.020 | 0.022 | 0.022 | 0.030 |
| Cchange in chromaticity (Δy) | 0.026 | 0.026 | 0.016 | 0.020 | 0.024 | 0.012 | 0.014 | 0.014 | 0.014 | 0.014 | 0.040 | 0.040 | 0.040 | 0.040 | 0.044 | 0.044 | 0.060 |

| | | | | | | | | | | | | | | | | | |
|---|---|---|---|---|---|---|---|---|---|---|---|---|---|---|---|---|---|
| (*1) Parts by weight per 100 parts by weight of component (B) | | | | | | | | | | | | | | | | | |

As compared to Comparative Example 1 without addition of the component (C), Examples 1 to 5, 16, 25, 34, 43, and 54 showed smaller chromaticity changes (Δx, Δy), indicating improved durability. Comparison among Examples 1 to 3 demonstrates that the durability was best improved when the transition metal ion was Cu²⁺. Comparison among Examples 3 to 5 demonstrates that the durability was further improved when the organic acid component was A-1. Furthermore, Comparison among Examples 3 to 5, 16, 25, 34, 43, and 54 demonstrates that the durability was further improved when the organic acid component was A-4. As compared to Comparative Examples 1 to 4 in which the transition metal ion was Ni²⁺, it is demonstrated that Examples 1 to 5 showed improved durability against light. Furthermore, Comparative Examples 5 to 7 without use of the component (C) and each with addition of X-1, X-2, or X-3 as another additive showed no improvement in the durability against light, and reduced quantum yield.

### (Examples 6 to 13, 17 to 24, 26 to 33, 35 to 42, 44 to 51, and 55 to 76)

Color conversion films were prepared in the same manner as Example 1 except that the type and amount of the component (C) added were as shown in Tables 3 to 10. Measurement of the fluorescence quantum yield and evaluation of the chromaticity durability of the color conversion film prepared in Examples and Comparative Examples were performed. The results are shown in Tables 3 to 10. The results from Examples 3, 16, 25, 34, 43, and 54 are again shown in Tables 3, 4, 5, 6, 7 and 8, respectively.

**[Table 3]**

| | Example 6 | Example 7 | Example 8 | Example 9 | Example 3 | Example 10 | Example 11 | Example 12 | Example 13 |
|---|---|---|---|---|---|---|---|---|---|
| Green luminescent material | G-1 | G-1 | G-1 | G-1 | G-1 | G-1 | G-1 | G-1 | G-1 |
| Red luminescent material | R-1 | R-1 | R-1 | R-1 | R-1 | R-1 | R-1 | R-1 | R-1 |
| Component (C) | Q-6 | Q-6 | Q-6 | Q-6 | Q-6 | Q-6 | Q-6 | Q-6 | Q-6 |
| Amount of component (C) (*1) | 3.0 × 10⁻⁶ parts by weight | 1.0 × 10⁻⁵ parts by weight | 1.0 × 10⁻⁴ parts by weight | 1.0 × 10⁻³ parts by weight | 3.0 × 10⁻³ parts by weight | 1.0 × 10⁻² parts by weight | 1.0 × 10⁻¹ parts by weight | 1.0 part by weight | 3.0 parts by weight |
| Fluorescence quantum yield of color conversion film | 92% | 92% | 92% | 92% | 92% | 90% | 84% | 70% | 40% |
| Change in chromaticity (Δx) | 0.018 | 0.015 | 0.013 | 0.010 | 0.008 | 0.007 | 0.005 | 0.004 | 0.004 |
| Change in chromaticity (Δy) | 0.036 | 0.030 | 0.026 | 0.020 | 0.016 | 0.014 | 0.010 | 0.008 | 0.008 |

| | | | | | | | | | |
|---|---|---|---|---|---|---|---|---|---|
| (* 1) Parts by weight per 100 parts by weight of component (B) | | | | | | | | | |

**[Table 4]**

| | Example 17 | Example 18 | Example 19 | Example 20 | Example 16 | Example 21 | Example 22 | Example 23 | Example 24 |
|---|---|---|---|---|---|---|---|---|---|
| Green luminescent material | G-1 | G-1 | G-1 | G-1 | G-1 | G-1 | G-1 | G-1 | G-1 |
| Red luminescent material | R-1 | R-1 | R-1 | R-1 | R-1 | R-1 | R-1 | R-1 | R-1 |
| Component (C) | Q-9 | Q-9 | Q-9 | Q-9 | Q-9 | Q-9 | Q-9 | Q-9 | Q-9 |
| Amount of component (C) (*1) | 3.0 × 10⁻⁶ parts by weight | 1.0 × 10⁻⁵ parts by weight | 1.0 × 10⁻⁴ parts by weight | 1.0 × 10⁻³ parts by weight | 3.0 × 10⁻³ parts by weight | 1.0 × 10⁻² parts by weight | 1.0 × 10⁻¹ parts by weight | 1.0 part by weight | 3.0 parts by weight |
| Fluorescence quantum yield of color conversion film | 92% | 92% | 92% | 92% | 92% | 92% | 90% | 81% | 63% |
| Change in chromaticity (Δx) | 0.014 | 0.012 | 0.010 | 0.008 | 0.006 | 0.005 | 0.004 | 0.003 | 0.003 |
| Change in chromaticity (Δy) | 0.028 | 0.024 | 0.020 | 0.016 | 0.012 | 0.010 | 0.008 | 0.006 | 0.006 |

| | | | | | | | | | |
|---|---|---|---|---|---|---|---|---|---|
| (* 1) Parts by weight per 100 parts by weight of component (B) | | | | | | | | | |

**[Table 5]**

| | Example 26 | Example27 | Example28 | Example29 | Example 25 | Example 30 | Example 31 | Example 32 | Example 33 |
|---|---|---|---|---|---|---|---|---|---|
| Green luminescent material | G-1 | G-1 | G-1 | G-1 | G-1 | G-1 | G-1 | G-1 | G-1 |
| Red luminescent material | R-1 | R-1 | R-1 | R-1 | R-1 | R-1 | R-1 | R-1 | R-1 |
| Component (C) | Q-10 | Q-10 | Q-10 | Q-10 | Q-10 | Q-10 | Q-10 | Q-10 | Q-10 |
| Amount of component (C) (*1) | 3.0 × 10⁻⁶ parts by weight | 1.0 × 10⁻⁵ parts by weight | 1.0 × 10⁻⁴ parts by weight | 1.0 × 10⁻³ parts by weight | 3.0 × 10⁻³ parts by weight | 1.0 × 10⁻² parts by weight | 1.0 × 10⁻¹ parts by weight | 1.0 part by weight | 3.0 parts by weight |
| Fluorescence quantum yield of color conversion film | 92% | 92% | 92% | 92% | 92% | 92% | 91% | 84% | 65% |
| Change in chromaticity (Δx) | 0.015 | 0.013 | 0.011 | 0.009 | 0.007 | 0.006 | 0.005 | 0.004 | 0.003 |
| Change in chromaticity (Δy) | 0.030 | 0.026 | 0.022 | 0.018 | 0.014 | 0.012 | 0.010 | 0.008 | 0.006 |

| | | | | | | | | | |
|---|---|---|---|---|---|---|---|---|---|
| (* 1) Parts by weight per 100 parts by weight of component (B) | | | | | | | | | |

**[Table 6]**

| | Example 35 | Example 36 | Example 37 | Example 38 | Example 34 | Example 39 | Example 40 | Example 41 | Example 42 |
|---|---|---|---|---|---|---|---|---|---|
| Green luminescent material | G-1 | G-1 | G-1 | G-1 | G-1 | G-1 | G-1 | G-1 | G-1 |
| Red luminescent material | R-1 | R-1 | R-1 | R-1 | R-1 | R-1 | R-1 | R-1 | R-1 |
| Component (C) | Q-11 | Q-11 | Q-11 | Q-11 | Q-11 | Q-11 | Q-11 | Q-11 | Q-11 |
| Amount of component (C) (*1) | 3.0 × 10⁻⁶ parts by weight | 1.0 × 10⁻⁵ parts by weight | 1.0 × 10⁻⁴ parts by weight | 1.0 × 10⁻³ parts by weight | 3.0 × 10⁻³ parts by weight | 1.0 × 10⁻² parts by weight | 1.0 × 10⁻¹ parts by weight | 1.0 part by weight | 3.0 parts by weight |
| Fluorescence quantum yield of color conversion film | 92% | 92% | 92% | 92% | 92% | 92% | 92% | 88% | 75% |
| Change in chromaticity (Δx) | 0.015 | 0.012 | 0.010 | 0.009 | 0.007 | 0.005 | 0.004 | 0.003 | 0.003 |
| Change in chromaticity (Δy) | 0.030 | 0.024 | 0.020 | 0.018 | 0.014 | 0.010 | 0.008 | 0.006 | 0.006 |

| | | | | | | | | | |
|---|---|---|---|---|---|---|---|---|---|
| (* 1) Parts by weight per 100 parts by weight of component (B) | | | | | | | | | |

**[Table 7]**

| | Example 44 | Example45 | Example 46 | Example47 | Example 43 | Example 48 | Example49 | Example 50 | Example 51 |
|---|---|---|---|---|---|---|---|---|---|
| Green luminescent material | G-1 | G-1 | G-1 | G-1 | G-1 | G-1 | G-1 | G-1 | G-1 |
| Red luminescent material | R-1 | R-1 | R-1 | R-1 | R-1 | R-1 | R-1 | R-1 | R-1 |
| Component (C) | Q-12 | Q-12 | Q-12 | Q-12 | Q-12 | Q-12 | Q-12 | Q-12 | Q-12 |
| Amount of component (C) (*1) | 3.0 × 10⁻⁶ parts by weight | 1.0 × 10⁻⁵ parts by weight | 1.0 × 10⁻⁴ parts by weight | 1.0 × 10⁻³ parts by weight | 3.0 × 10⁻³ parts by weight | 1.0 × 10⁻² parts by weight | 1.0 × 10⁻¹ parts by weight | 1.0 part by weight | 3.0 parts by weight |
| Fluorescence quantum yield of color conversion film | 92% | 92% | 92% | 92% | 92% | 92% | 92% | 87% | 73% |
| Change in chromaticity (Δx) | 0.015 | 0.012 | 0.010 | 0.008 | 0.007 | 0.005 | 0.004 | 0.003 | 0.003 |
| Change in chromaticity (Δy) | 0.030 | 0.024 | 0.020 | 0.016 | 0.014 | 0.010 | 0.008 | 0.006 | 0.006 |

| | | | | | | | | | |
|---|---|---|---|---|---|---|---|---|---|
| (* 1) Parts by weight per 100 parts by weight of component (B) | | | | | | | | | |

**[Table 8]**

| | Example 55 | Example 56 | Example 57 | Example 58 | Example 54 | Example 59 | Example 60 | Example 61 | Example 62 |
|---|---|---|---|---|---|---|---|---|---|
| Green luminescent material | G-1 | G-1 | G-1 | G-1 | G-1 | G-1 | G-1 | G-1 | G-1 |
| Red luminescent material | R-1 | R-1 | R-1 | R-1 | R-1 | R-1 | R-1 | R-1 | R-1 |
| Component (C) | Q-13 | Q-13 | Q-13 | Q-13 | Q-13 | Q-13 | Q-13 | Q-13 | Q-13 |
| Amount of component (C) (*1) | 3.0 × 10⁻⁶ parts by weight | 1.0 × 10⁻⁵ parts by weight | 1.0 × 10⁻⁴ parts by weight | 1.0 × 10⁻³ parts by weight | 3.0 × 10⁻³ parts by weight | 1.0 × 10⁻² parts by weight | 1.0 × 10⁻¹ parts by weight | 1.0 part by weight | 3.0 parts by weight |
| Fluorescence quantum yield of color conversion film | 92% | 92% | 92% | 92% | 92% | 92% | 91% | 85% | 68% |
| Change in chromaticity (Δx) | 0.015 | 0.013 | 0.011 | 0.009 | 0.007 | 0.006 | 0.005 | 0.004 | 0.003 |
| Change in chromaticity (Δy) | 0.030 | 0.026 | 0.022 | 0.018 | 0.014 | 0.012 | 0.010 | 0.008 | 0.006 |

| | | | | | | | | | |
|---|---|---|---|---|---|---|---|---|---|
| (* 1) Parts by weight per 100 parts by weight of component (B) | | | | | | | | | |

**[Table 9]**

| | Example 63 | Example64 | Example65 | Example 66 | Example 67 | Example 68 | Example69 |
|---|---|---|---|---|---|---|---|
| Green luminescent material | G-1 | G-1 | G-1 | G-1 | G-1 | G-1 | G-1 |
| Red luminescent material | R-1 | R-1 | R-1 | R-1 | R-1 | R-1 | R-1 |
| Component (C) | Q-14 | Q-14 | Q-14 | Q-14 | Q-14 | Q-14 | Q-14 |
| Amount of component (C) (*1) | 3.0 × 10⁻³ parts by weight | 1.0 × 10⁻² parts by weight | 3.0 × 10⁻² parts by weight | 5.0 × 10⁻² parts by weight | 1.0 × 10⁻¹ parts by weight | 1.0 part by weight | 3.0 parts by weight |
| Fluorescence quantum yield of color conversion film | 92% | 92% | 92% | 92% | 92% | 89% | 81% |
| Change in chromaticity (Δx) | 0.007 | 0.006 | 0.005 | 0.004 | 0.004 | 0.003 | 0.003 |
| Change in chromaticity (Δy) | 0.014 | 0.012 | 0.010 | 0.008 | 0.008 | 0.006 | 0.006 |

| | | | | | | | |
|---|---|---|---|---|---|---|---|
| (* 1) Parts by weight per 100 parts by weight of component (B) | | | | | | | |

**[Table 10]**

| | Example 70 | Example71 | Example 72 | Example 73 | Example74 | Example 75 | Example76 |
|---|---|---|---|---|---|---|---|
| Green luminescent material | G-1 | G-1 | G-1 | G-1 | G-1 | G-1 | G-1 |
| Red luminescent material | R-1 | R-1 | R-1 | R-1 | R-1 | R-1 | R-1 |
| Component (C) | Q-15 | Q-15 | Q-15 | Q-15 | Q-15 | Q-15 | Q-15 |
| Amount of component (C) (*1) | 3.0 × 10⁻³ parts by weight | 1.0 × 10⁻² parts by weight | 3.0 × 10⁻² parts by weight | 5.0 × 10⁻² parts by weight | 1.0 × 10⁻¹ parts by weight | 1.0 part by weight | 3.0 parts by weight |
| Fluorescence quantum yield of color conversion film | 92% | 92% | 92% | 92% | 92% | 89% | 81% |
| Change in chromaticity (Δx) | 0.007 | 0.006 | 0.005 | 0.004 | 0.004 | 0.003 | 0.003 |
| Change in chromaticity (Δy) | 0.014 | 0.012 | 0.010 | 0.008 | 0.008 | 0.006 | 0.006 |

| | | | | | | | |
|---|---|---|---|---|---|---|---|
| (* 1) Parts by weight per 100 parts by weight of component (B) | | | | | | | |

It was found that a higher amount of the component (C) added resulted in more improvement in the durability, but when the amount added was 1 part by weight or more, the effect of improving the durability was not changed. In addition, a lower amount added tended to result in more improvement in the fluorescence quantum yield. Furthermore, it was also found that when the transition metal constituting the component (C) was a lanthanoid, even an increase of the amount added was unlikely to reduce the quantum yield.

### (Example 14, 15, 52, 53, and 77, Comparative Examples 8 and 9)

Color conversion films were prepared in the same manner as Example 1 except that the type of the component (A), and the type and the amount of the component (C) added were as shown in Table 11. Measurement of the fluorescence quantum yield and evaluation of the chromaticity durability of the color conversion film prepared in Examples and Comparative Examples were performed. The results are shown in Table 11. The results from Examples 3 and 43 are again shown in Table 11. Examples 14 and 15, as compared to Comparative Examples 8 and 9, showed smaller chromaticity changes (Δx, Δy), indicating improved durability. In addition, comparison of Examples 14 and 15 to Example 3 demonstrated that use of the compound represented by Formula (1) resulted in further improved durability. Examples 52 and 53, as compared to Comparative Examples 8 and 9, showed smaller chromaticity changes (Δx, Δy), indicating improved durability. In addition, comparison of Examples 52 and 53 to Example 43 demonstrated that use of the compound represented by Formula (1) resulted in further improved durability. Furthermore, comparison of Example 3 to Example 77 demonstrated that when X was C-R⁷ and R⁷ was a group represented by Formula (2) in the compound represented by Formula (1), reduction of the quantum yield can be further prevented.

**[Table 11]**

| | Example 3 | Example 14 | Example 15 | Example 43 | Example 52 | Example 53 | Example 77 | Comparaative Example 8 | Comparative Example 9 |
|---|---|---|---|---|---|---|---|---|---|
| Green luminescent material | G-1 | G-2 | G-3 | G-1 | G-2 | G-3 | G-4 | G-2 | G-3 |
| Red luminescent material | R-1 | R-2 | R-3 | R-1 | R-2 | R-3 | R-4 | R-2 | R-3 |
| Component (C) | Q-6 | Q-6 | Q-6 | Q-11 | Q-11 | Q-11 | Q-6 | no | no |

| Amount of component (C) (*1) | 3.0 × 10⁻³ parts by weight | 3.0 × 10⁻³ parts by weight | 3.0 × 10⁻³ parts by weight | 3.0 × 10⁻³ parts by weight | 3.0 × 10⁻³ parts by weight | 3.0 × 10⁻³ parts by weight | 3.0 × 10⁻³ parts by weight | - | - |
|---|---|---|---|---|---|---|---|---|---|
| Fluorescence quantum yield of color conversion film | 92% | 85% | 85% | 92% | 85% | 85% | 80% | 85% | 85% |
| Change in chromaticity (Δx) | 0.008 | 0.014 | 0.014 | 0.007 | 0.012 | 0.012 | 0.008 | 0.025 | 0.020 |
| Change in chromaticity (Δy) | 0.016 | 0.028 | 0.028 | 0.014 | 0.024 | 0.024 | 0.016 | 0.050 | 0.040 |

| | | | | | | | | | |
|---|---|---|---|---|---|---|---|---|---|
| (* 1) Parts by weight per 100 parts by weight of component (B) | | | | | | | | | |

### (Examples 78 to 83)

Color conversion films were prepared in the same manner as Example 1 except that the type and amount of the component (C) added were as shown in Table 12. Measurement of the fluorescence quantum yield and evaluation of the chromaticity durability of the color conversion film prepared in Examples and Comparative Examples were performed. The results are shown in Table 12. The results from Example 21 are again shown. As compared to Example 21 using only one component (C), Examples 79 to 82, comprising at least first and second components (C); wherein the transition metal constituting the first component (C) was selected from the group consisting of Sc, V, Mn, Fe, Co, Cu, Y, Zr, Mo, and Ag, and the transition metal constituting the second component (C) was a lanthanoid; and wherein the amount (w1) of the first component (C) and the amount (w2) of the second component (C) satisfy the relationship of w1 ≤ w2, showed more improved durability.

**[Table 12]**

| | Example 78 | Example 79 | Example 80 | Example 81 | Example 82 | Example 83 | Example 21 |
|---|---|---|---|---|---|---|---|
| Green luminescent material | G-1 | G-1 | G-1 | G-1 | G-1 | G-1 | G-1 |
| Red luminescent material | R-1 | R-1 | R-1 | R-1 | R-1 | R-1 | R-1 |
| First component (C) | Q-9 | Q-9 | Q-9 | Q-9 | Q-9 | Q-9 | Q-9 |
| Amount of first component (C) (*1) | 1.0 × 10⁻² parts by weight | 1.0 × 10⁻² parts by weight | 1.0 × 10⁻² parts by weight | 1.0 × 10⁻² parts by weight | 1.0 × 10⁻² parts by weight | 1.0 × 10⁻² parts by weight | 1.0 × 10⁻² parts by weight |
| Second component (C) | Q-14 | Q-14 | Q-14 | Q-14 | Q-14 | Q-14 | - |
| Amount of second component (C) (*1) | 3.0 × 10⁻³ parts by weight | 1.0 × 10⁻² parts by weight | 3.0 × 10⁻² parts by weight | 5.0 × 10⁻² parts by weight | 1.0 × 10⁻¹ parts by weight | 1.0 part by weight | - |
| Fluorescence quantum yield of color conversion film | 92% | 92% | 92% | 92% | 91% | 88% | 92% |
| Change in chromaticity (Δx) | 0.005 | 0.003 | 0.002 | 0.001 | 0.001 | 0.001 | 0.005 |
| Change in chromaticity (Δy) | 0.010 | 0.006 | 0.004 | 0.002 | 0.002 | 0.002 | 0.010 |

| | | | | | | | |
|---|---|---|---|---|---|---|---|
| (* 1) Parts by weight per 100 parts by weight of component (B) | | | | | | | |

### (Examples 84 to 90)

Color conversion films were prepared in the same manner as Example 21 except that the drying temperature and time period in preparation of the color conversion layer were as shown in Table 13. Measurement of the amount of residual solvent in the color conversion film, measurement of the fluorescence quantum yield, and evaluation of the chromaticity durability of the color conversion film prepared in Examples and Comparative Examples were performed. The results are shown in Table 13. The results from Example 21 are again shown. It was found that a lower amount of the residual solvent in the color conversion layer resulted in more improvement in the durability. It was also found that when the amount of residual solvent in the color conversion layer is 0.02% by weight or less, the fluorescence quantum yield was reduced.

**[Table 13]**

| | Example84 | Example 21 | Example 85 | Example 86 | Example 87 | Example 88 | Example 89 | Example90 |
|---|---|---|---|---|---|---|---|---|
| Drying temperature (common between green layer / red layer) | 110°C | 120°C | 120°C | 130°C | 130°C | 130°C | 140°C | 150°C |
| Drying time period (common between green layer / red layer) | 20 min | 20 min | 30 min | 20 min | 30 min | 60 min | 20 min | 30 min |
| Amount of solvent remaining in green color conversion layer (weight%) | 3% | 1% | 0.5% | 0.1% | 0.05% | 0.02% | 0.01% | 0.001% |
| Amount of solvent remaining in red color conversion layer (weight%) | 3% | 1% | 0.5% | 0.1% | 0.05% | 0.02% | 0.01% | 0.001% |
| Fluorescence quantum yield of color conversion film | 92% | 92% | 92% | 92% | 91% | 88% | 85% | 78% |
| Change in chromaticity (Δx) | 0.006 | 0.005 | 0.003 | 0.003 | 0.003 | 0.003 | 0.003 | 0.003 |
| Change in chromaticity (Δy) | 0.012 | 0.010 | 0.006 | 0.006 | 0.006 | 0.006 | 0.006 | 0.006 |

### (Examples 91 to 95)

Color conversion films were prepared in the same manner as Example 1 except that the type and amount of the component (A) added, and the type and the amount of the component (C) added were as shown in Table 14. The component (A) compounds used are shown below. Measurement of the fluorescence quantum yield and evaluation of the chromaticity durability of the color conversion film prepared in Examples and Comparative Examples were performed. The results are shown in Table 14. These Examples demonstrate that the effect of improving the durability by addition of Q-9 is maintained, whereas the obtained fluorescence quantum yields differed. In other words, Example 93 using G-7 represented by Formula (11) as a compound that emits delayed fluorescence showed more improved fluorescence quantum yield, and Examples 94 and 95 using G-8 and G-9 represented by Formula (12) showed still more improved fluorescence quantum yield. This reflects the result of prevention of the electronic interaction with the component (C) due to the effect of sterically protecting the boron atom that is the central atom as discussed herein.

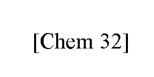

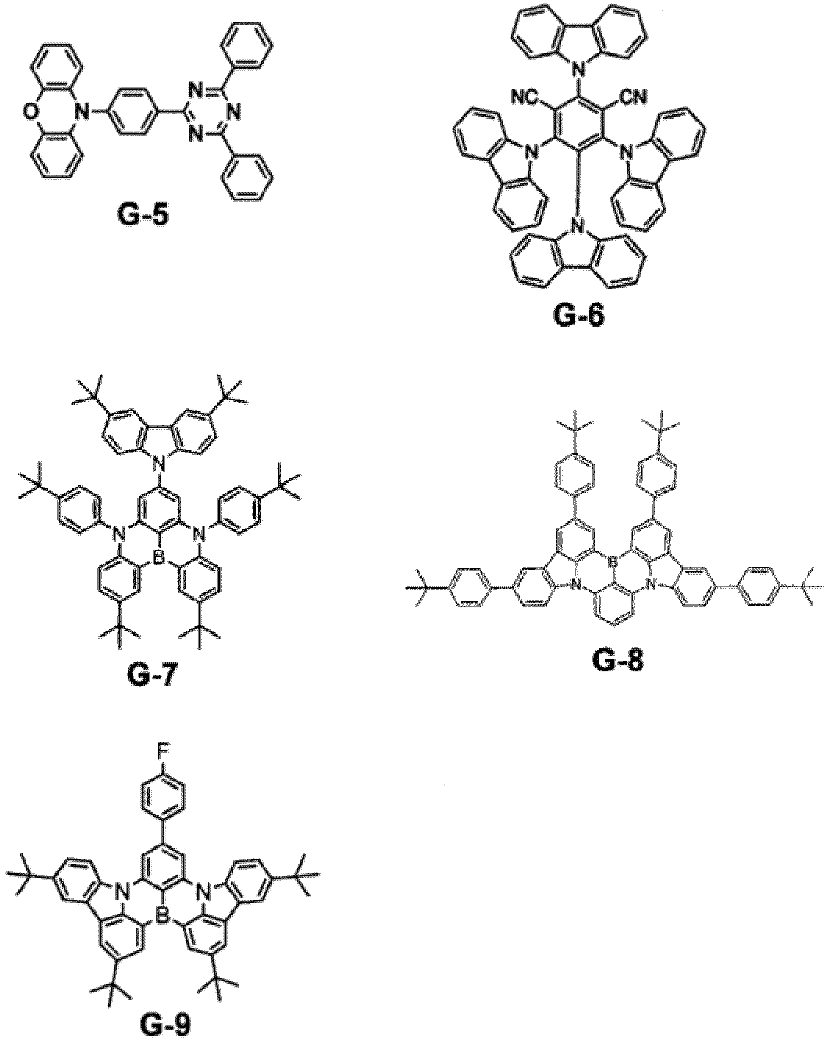

**[Table 14]**

| | Example 91 | Example 92 | Example93 | Example 94 | Example 95 |
|---|---|---|---|---|---|
| Green luminescent material | G-5 | G-6 | G-7 | G-8 | G-9 |
| Red luminescent material | R-1 | R-1 | R-1 | R-1 | R-1 |
| Component (C) | Q-9 | Q-9 | Q-9 | Q-9 | Q-9 |
| Amount of component (C) (*1) | 1.0 × 10⁻² parts by weight | 1.0 × 10⁻² parts by weight | 1.0 × 10⁻² parts by weight | 1.0 × 10⁻² parts by weight | 1.0 × 10⁻² parts by weight |
| Fluorescence quantum yield of color conversion film | 85% | 86% | 89% | 92% | 92% |
| Change in chromaticity (Δx) | 0.005 | 0.005 | 0.005 | 0.005 | 0.005 |
| Change in chromaticity (Δy) | 0.010 | 0.010 | 0.010 | 0.010 | 0.010 |

| | | | | | |
|---|---|---|---|---|---|
| (* 1) Parts by weight per 100 parts by weight of component (B) | | | | | |

### Reference Signs List

- 1: Color Conversion Film
- 10: Substrate Layer
- 11: Color Conversion Layer
- 12: Barrier Film

## Claims

1. A color conversion composition, comprising the following component (A), component (B), and component (C):
Component (A): a luminescent material,
Component (B): a binder resin, and
Component (C): a salt of an organic acid and at least one transition metal selected from the group consisting of Sc, V, Mn, Fe, Co, Cu, Y, Zr, Mo, Ag, and lanthanoids,
wherein the organic acid constituting the component (C) is an acid having an ethylhexyl group and/or ethylhexanoic acid OR wherein the organic acid constituting the component (C) is a β-diketone.

2. The color conversion composition according to claim 1, wherein the β-diketone has a cycloalkyl group, and
wherein the β-diketone preferably has at least two cycloalkyl groups.

3. The color conversion composition according to claim 2, wherein the cycloalkyl group is selected from the group consisting of a cyclohexyl group, a cycloheptyl group, a cyclooctyl group, a norbornyl group, and an adamantyl group.

4. The color conversion composition according to any one of claims 1 to 3, wherein the transition metal constituting the component (C) is Cu.

5. The color conversion composition according to claim 4, wherein the oxidation number of Cu constituting the component (C) is +2.

6. The color conversion composition according to any one of claims 1 to 5, wherein the transition metal constituting the component (C) is Nd or Sm, and its oxidation number is +3.

7. The color conversion composition according to any one of claims 1 to 6, comprising two or more of the components (C).

8. The color conversion composition according to claim 7, comprising at least a first component (C) and a second component (C),
wherein the transition metal constituting the first component (C) is selected from the group consisting of Sc, V, Mn, Fe, Co, Cu, Y, Zr, Mo, and Ag; and
wherein the transition metal constituting the second component (C) is a lanthanoid.

9. The color conversion composition according to any one of claims 1 to 8, wherein the amount of the component (C) is from 1.0 × 10⁻⁵ parts by weight to 1 part by weight per 100 parts by weight of the component (B).

10. The color conversion composition according to claim 8, wherein the amount (w1) of the first component (C) and the amount (w2) of the second component (C) satisfy the relationship of w1 ≤ w2.

11. The color conversion composition according to any one of claims 1 to 10, wherein the luminescent material is an organic luminescent material.

12. The color conversion composition according to any one of claims 1 to 11, wherein the component (A) contains a compound represented by the following Formula (1): 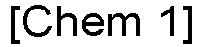 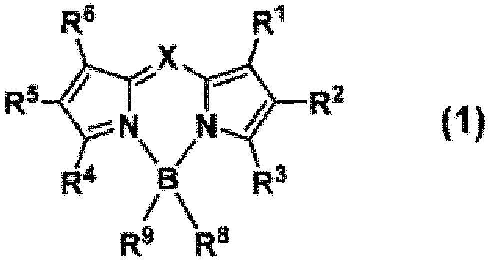 wherein,
X is C-R⁷ or N; and
each of R¹ to R⁹, which may be the same as or different from one another, is selected from a hydrogen atom, an alkyl group, a cycloalkyl group, a heterocyclic group, an alkenyl group, a cycloalkenyl group, an alkynyl group, a hydroxyl group, a thiol group, an alkoxy group, an alkylthio group, an aryl ether group, an aryl thioether group, an aryl group, a heteroaryl group, a halogen, a cyano group, an aldehyde group, a carbonyl group, a carboxyl group, an oxycarbonyl group, a carbamoyl group, an amino group, a nitro group, a silyl group, a siloxanyl group, a boryl group, a phosphine oxide group, and a fused ring and an aliphatic ring each formed between adjacent substituents.

13. The color conversion composition according to claim 12, wherein in Formula (1), X is C-R⁷; and R⁷ is a group represented by the following Formula (2): 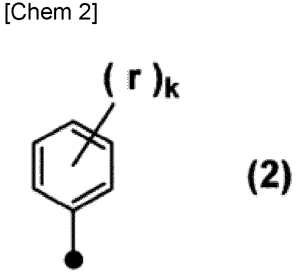 wherein,
r is selected from the group consisting of a hydrogen atom, an alkyl group, a cycloalkyl group, a heterocyclic group, an alkenyl group, a cycloalkenyl group, an alkynyl group, a hydroxyl group, a thiol group, an alkoxy group, an alkylthio group, an aryl ether group, an aryl thioether group, an aryl group, a heteroaryl group, a halogen, a cyano group, an aldehyde group, a carbonyl group, a carboxyl group, an oxycarbonyl group, a carbamoyl group, an amino group, a nitro group, a silyl group, a siloxanyl group, a boryl group, and a phosphine oxide group;
k is an integer from 1 to 3; and
when k is 2 or more, r may be the same as or different from one another.

14. The color conversion composition according to any one of claims 1 to 11, wherein the component (A) is a compound that emits delayed fluorescence.

15. The color conversion composition according to claim 14, wherein the compound that emits delayed fluorescence is a compound represented by the following Formula (11): 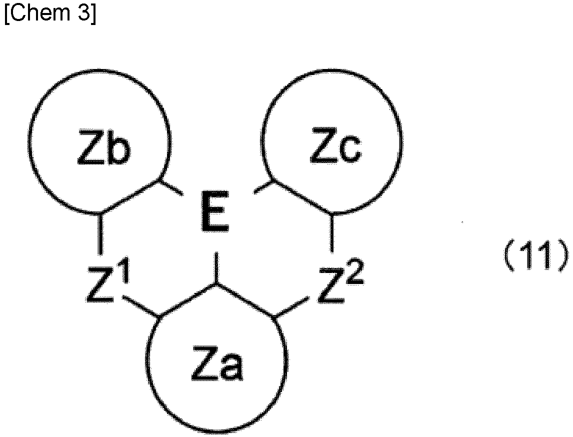 wherein,
each of the ring Za, the ring Zb, and the ring Zc independently is a substituted or unsubstituted aryl ring having a ring-forming carbon number of 6 to 30, or a substituted or unsubstituted heteroaryl ring having a ring-forming carbon number of 6 to 30;
each of Z¹ and Z² independently is an oxygen atom, NRa (a nitrogen atom having a substituent Ra), or a sulfur atom;
when Z¹ is NRa, Ra may or may not be bonded to the ring Za or the ring Zb to form a ring; and when Z² is NRa, Ra may or may not be bonded to the ring Za or the ring Zc to form a ring;
each Ra independently is a substituted or unsubstituted aryl group, a substituted or unsubstituted heteroaryl group, or a substituted or unsubstituted alkyl group;
E is a boron atom, a phosphorus atom, SiRb (a silicon atom having a substituent Rb), P=O, or P=S; and
each Rb independently is a substituted or unsubstituted aryl group, a substituted or unsubstituted heteroaryl group, or a substituted or unsubstituted alkyl group.

16. The color conversion composition according to any one of claims 1 to 15, wherein the component (A) contains at least one of the following luminescent materials (a) and (b):
(a) a luminescent material that emits light having a peak wavelength observed in the region of 500 to 580 nm by use of excitation light having a wavelength of 430 to 500 nm, and
(b) a luminescent material that emits light having a peak wavelength observed in the region of 580 to 750 nm upon being excited by either one or both of excitation light having a wavelength of 430 to 500 nm and light emitted by the luminescent material (a).

17. A color conversion film comprising the color conversion composition according to any one of claims 1 to 16, or a cured product thereof.

18. The color conversion film according to claim 17, the amount of a solvent contained in the color conversion composition or the cured product thereof is from 0.01% by weight to 3.0% by weight.

19. A light source unit comprising a light source, and the color conversion composition according to any one of claims 1 to 16 or the color conversion film according to claim 20 or 21.

20. The light source unit according to claim 19, wherein the light source is a light-emitting diode having a maximum light emission in the range of 430 nm to 500 nm.

21. A display comprising the light source unit according to claim 19 or 20.

22. A lighting comprising the light source unit according to claim 19 or 20.

23. A compound having a structure represented by the following Formula (3): 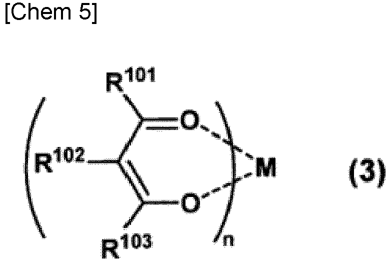 wherein,
each of R¹⁰¹ to R¹⁰³, which may be the same as or different from one another, is selected from a hydrogen atom, an alkyl group, a cycloalkyl group, a heterocyclic group, an alkenyl group, a cycloalkenyl group, an alkynyl group, a hydroxyl group, a thiol group, an alkoxy group, an alkylthio group, an aryl ether group, an aryl thioether group, an aryl group, a heteroaryl group, a halogen, a cyano group, an aldehyde group, a carbonyl group, a carboxyl group, an oxycarbonyl group, a carbamoyl group, an amino group, a nitro group, a silyl group, a siloxanyl group, a boryl group, a phosphine oxide group, and a fused ring and an aliphatic ring each formed between adjacent substituents;
provided that the following conditions (A) and (B) are satisfied:
Condition (A): one of R¹⁰¹ to R¹⁰³ is a cycloalkyl group (a) having a carbon number of 6 or more; and
Condition (B): at least one of the others than condition (A) is selected from an aryl group, a cycloalkyl group, a cycloalkenyl group, an aliphatic heterocyclic group, and an alkyl group having a carbon number of 5 or more;
M is selected from the group consisting of Sc, V, V=O, Mn, Ni, Cu, Zr, O=Mo=O, and Ag; and
n is an integer of 2 to 4.

24. The compound according to claim 23, wherein in Formula (3) M is Cu, and n is 2.

## Patentansprüche

1. Farbumwandlungszusammensetzung, umfassend die folgende Komponente (A), Komponente (B) und Komponente (C):
Komponente (A): ein lumineszierendes Material,
Komponente (B): ein Bindemittelharz und
Komponente (C): ein Salz einer organischen Säure und mindestens eines Übergangsmetalls, ausgewählt aus der Gruppe, bestehend aus Sc, V, Mn, Fe, Co, Cu, Y, Zr, Mo, Ag und Lanthanoiden,
wobei die organische Säure, die die Komponente (C) bildet, eine Säure mit einer Ethylhexylgruppe und/oder Ethylhexansäure ist oder wobei die organische Säure, die die Komponente (C) bildet, ein β-Diketon ist.

2. Farbumwandlungszusammensetzung nach Anspruch 1, wobei das β-Diketon eine Cycloalkylgruppe aufweist und
wobei das β-Diketon vorzugsweise mindestens zwei Cycloalkylgruppen aufweist.

3. Farbumwandlungszusammensetzung nach Anspruch 2, wobei die Cycloalkylgruppe ausgewählt ist aus der Gruppe, bestehend aus einer Cyclohexylgruppe, einer Cycloheptylgruppe, einer Cyclooctylgruppe, einer Norbornylgruppe und einer Adamantylgruppe.

4. Farbumwandlungszusammensetzung nach einem der Ansprüche 1 bis 3, wobei das Übergangsmetall, das die Komponente (C) bildet, Cu ist.

5. Farbumwandlungszusammensetzung nach Anspruch 4, wobei die Oxidationszahl von Cu, das die Komponente (C) bildet, +2 ist.

6. Farbumwandlungszusammensetzung nach einem der Ansprüche 1 bis 5, wobei das Übergangsmetall, das die Komponente (C) bildet, Nd oder Sm ist und seine Oxidationszahl +3 ist.

7. Farbumwandlungszusammensetzung nach einem der Ansprüche 1 bis 6, umfassend zwei oder mehr der Komponenten (C).

8. Farbumwandlungszusammensetzung nach Anspruch 7, umfassend mindestens eine erste Komponente (C) und eine zweite Komponente (C),
wobei das Übergangsmetall, das die erste Komponente (C) bildet, ausgewählt ist aus der Gruppe, bestehend aus Sc, V, Mn, Fe, Co, Cu, Y, Zr, Mo und Ag; und
wobei das Übergangsmetall, das die zweite Komponente (C) bildet, ein Lanthanoid ist.

9. Farbumwandlungszusammensetzung nach einem der Ansprüche 1 bis 8, wobei die Menge der Komponente (C) von 1,0 x 10⁻⁵ Gewichtsteile bis 1 Gewichtsteil pro 100 Gewichtsteile der Komponente (B) beträgt.

10. Farbumwandlungszusammensetzung nach Anspruch 8, wobei die Menge (w1) der ersten Komponente (C) und die Menge (w2) der zweiten Komponente (C) die Beziehung w1 ≤ w2 erfüllen.

11. Farbumwandlungszusammensetzung nach einem der Ansprüche 1 bis 10, wobei das lumineszierende Material ein organisches lumineszierendes Material ist.

12. Farbumwandlungszusammensetzung nach einem der Ansprüche 1 bis 11, wobei die Komponente (A) eine durch die folgende Formel (1) dargestellte Verbindung enthält: 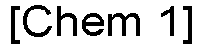 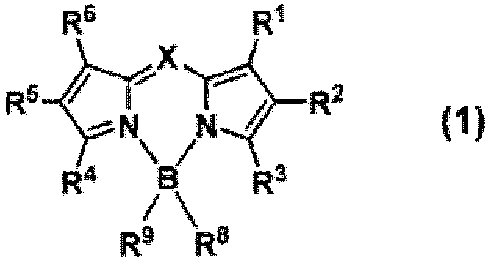 wobei
X C-R⁷ oder N ist; und
jedes von R¹ bis R⁹ , die gleich oder voneinander verschieden sein können, ausgewählt ist aus einem Wasserstoffatom, einer Alkylgruppe, einer Cycloalkylgruppe, einer heterocyclischen Gruppe, einer Alkenylgruppe, einer Cycloalkenylgruppe, einer Alkinylgruppe, einer Hydroxylgruppe, einer Thiolgruppe, einer Alkoxygruppe, einer Alkylthiogruppe, einer Arylethergruppe, einer Arylthioethergruppe, einer Arylgruppe, einer Heteroarylgruppe, einem Halogen, einer Cyanogruppe, einer Aldehydgruppe, einer Carbonylgruppe, einer Carboxylgruppe, einer Oxycarbonylgruppe, einer Carbamoylgruppe, einer Aminogruppe, einer Nitrogruppe, einer Silylgruppe, einer Siloxanylgruppe, einer Borylgruppe, einer Phosphinoxidgruppe und einem kondensierten Ring und einem aliphatischen Ring, die jeweils zwischen benachbarten Substituenten gebildet sind.

13. Farbumwandlungszusammensetzung nach Anspruch 12, wobei in Formel (1) X C-R⁷ ist; und R⁷ eine durch die folgende Formel (2) dargestellte Gruppe ist: 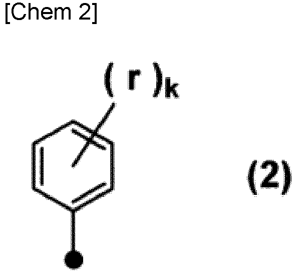 wobei
r ausgewählt ist aus der Gruppe, bestehend aus einem Wasserstoffatom, einer Alkylgruppe, einer Cycloalkylgruppe, einer heterocyclischen Gruppe, einer Alkenylgruppe, einer Cycloalkenylgruppe, einer Alkinylgruppe, einer Hydroxylgruppe, einer Thiolgruppe, einer Alkoxygruppe, einer Alkylthiogruppe, einer Arylethergruppe, einer Arylthioethergruppe, einer Arylgruppe, einer Heteroarylgruppe, einem Halogen, einer Cyanogruppe, einer Aldehydgruppe, einer Carbonylgruppe, einer Carboxylgruppe, einer Oxycarbonylgruppe, einer Carbamoylgruppe, einer Aminogruppe, einer Nitrogruppe, einer Silylgruppe, einer Siloxanylgruppe, einer Borylgruppe und einer Phosphinoxidgruppe;
k eine ganze Zahl von 1 bis 3 ist; und
wenn k 2 oder mehr ist, r gleich oder voneinander verschieden sein können.

14. Farbumwandlungszusammensetzung nach einem der Ansprüche 1 bis 11, wobei die Komponente (A) eine Verbindung ist, die verzögerte Fluoreszenz emittiert.

15. Farbumwandlungszusammensetzung nach Anspruch 14, wobei die Verbindung, die verzögerte Fluoreszenz emittiert, eine durch die folgende Formel (11) dargestellte Verbindung ist: 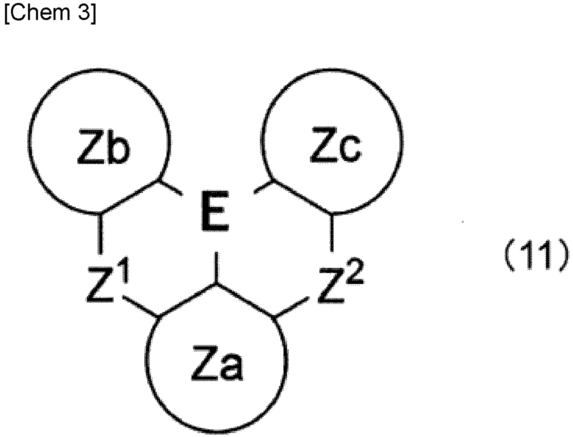 wobei
jeder von dem Ring Za, dem Ring Zb und dem Ring Zc unabhängig ein substituierter oder unsubstituierter Arylring mit einer ringbildenden Kohlenstoffzahl von 6 bis 30 oder ein substituierter oder unsubstituierter Heteroarylring mit einer ringbildenden Kohlenstoffzahl von 6 bis 30 ist;
jedes von Z¹ und Z² unabhängig ein Sauerstoffatom, NRa (ein Stickstoffatom mit einem Substituenten Ra) oder ein Schwefelatom ist;
wenn Z¹ NRa ist, Ra an den Ring Za oder den Ring Zb gebunden sein kann oder nicht, um einen Ring zu bilden; und wenn Z² NRa ist, Ra an den Ring Za oder den Ring Zc gebunden sein kann oder nicht, um einen Ring zu bilden;
jedes Ra unabhängig eine substituierte oder unsubstituierte Arylgruppe, eine substituierte oder unsubstituierte Heteroarylgruppe oder eine substituierte oder unsubstituierte Alkylgruppe ist;
E ein Boratom, ein Phosphoratom, SiRb (ein Siliciumatom mit einem Substituenten Rb), P=O oder P=S ist; und
jedes Rb unabhängig eine substituierte oder unsubstituierte Arylgruppe, eine substituierte oder unsubstituierte Heteroarylgruppe oder eine substituierte oder unsubstituierte Alkylgruppe ist.

16. Farbumwandlungszusammensetzung nach einem der Ansprüche 1 bis 15, wobei die Komponente (A) mindestens eines der folgenden lumineszierenden Materialien (a) und (b) enthält:
(a) ein lumineszierendes Material, das Licht mit einer Peakwellenlänge emittiert, die im Bereich von 500 bis 580 nm unter Verwendung von Anregungslicht mit einer Wellenlänge von 430 bis 500 nm beobachtet wird, und
(b) ein lumineszierendes Material, das Licht mit einer Peakwellenlänge emittiert, die im Bereich von 580 bis 750 nm beobachtet wird, wenn es durch entweder eines oder beide von Anregungslicht mit einer Wellenlänge von 430 bis 500 nm und von dem lumineszierenden Material (a) emittiertem Licht angeregt wird.

17. Farbumwandlungsfilm, umfassend die Farbumwandlungszusammensetzung nach einem der Ansprüche 1 bis 16 oder ein gehärtetes Produkt davon.

18. Farbumwandlungsfilm nach Anspruch 17, wobei die Menge eines Lösungsmittels, das in der Farbumwandlungszusammensetzung oder dem gehärteten Produkt davon enthalten ist, von 0,01 Gew.-% bis 3,0 Gew.-% beträgt.

19. Lichtquelleneinheit, umfassend eine Lichtquelle und die Farbumwandlungszusammensetzung nach einem der Ansprüche 1 bis 16 oder den Farbumwandlungsfilm nach Anspruch 20 oder 21.

20. Lichtquelleneinheit nach Anspruch 19, wobei die Lichtquelle eine Leuchtdiode mit einer maximalen Lichtemission im Bereich von 430 nm bis 500 nm ist.

21. Display, umfassend die Lichtquelleneinheit nach Anspruch 19 oder 20.

22. Beleuchtung, umfassend die Lichtquelleneinheit nach Anspruch 19 oder 20.

23. Verbindung mit einer durch die folgende Formel (3) dargestellten Struktur: 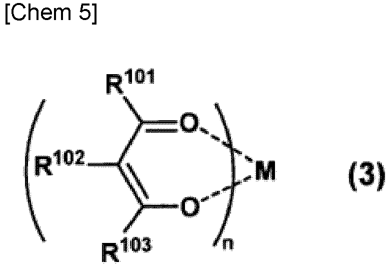 wobei
jedes von R¹⁰¹ bis R¹⁰³ , die gleich oder voneinander verschieden sein können, ausgewählt ist aus einem Wasserstoffatom, einer Alkylgruppe, einer Cycloalkylgruppe, einer heterocyclischen Gruppe, einer Alkenylgruppe, einer Cycloalkenylgruppe, einer Alkinylgruppe, einer Hydroxylgruppe, einer Thiolgruppe, einer Alkoxygruppe, einer Alkylthiogruppe, einer Arylethergruppe, einer Arylthioethergruppe, einer Arylgruppe, einer Heteroarylgruppe, einem Halogen, einer Cyanogruppe, einer Aldehydgruppe, einer Carbonylgruppe, einer Carboxylgruppe, einer Oxycarbonylgruppe, einer Carbamoylgruppe, einer Aminogruppe, einer Nitrogruppe, einer Silylgruppe, einer Siloxanylgruppe, einer Borylgruppe, einer Phosphinoxidgruppe und einem kondensierten Ring und einem aliphatischen Ring, die jeweils zwischen benachbarten Substituenten gebildet sind;
mit der Maßgabe, dass die folgenden Bedingungen (A) und (B) erfüllt sind:
Bedingung (A): eines von R¹⁰¹ bis R¹⁰³ ist eine Cycloalkylgruppe (a) mit einer Kohlenstoffzahl von 6 oder mehr; und
Bedingung (B): mindestens eines der anderen als Bedingung (A) ist ausgewählt aus einer Arylgruppe, einer Cycloalkylgruppe, einer Cycloalkenylgruppe, einer aliphatischen heterocyclischen Gruppe und einer Alkylgruppe mit einer Kohlenstoffzahl von 5 oder mehr;
M ist ausgewählt aus der Gruppe, bestehend aus Sc, V, V=O, Mn, Ni, Cu, Zr, O=Mo=O und Ag; und
n ist eine ganze Zahl von 2 bis 4.

24. Verbindung nach Anspruch 23, wobei in Formel (3) M Cu ist und n 2 ist.

## Revendications

1. Composition de conversion de couleur, comprenant le composant (A), le composant (B) et le composant (C) suivants :
Composant (A) : un matériau luminescent,
Composant (B) : une résine liante, et
Composant (C) : un sel d'un acide organique et d'au moins un métal de transition choisi dans le groupe constitué par Sc, V, Mn, Fe, Co, Cu, Y, Zr, Mo, Ag et les lanthanides,
dans laquelle l'acide organique constituant le composant (C) est un acide ayant un groupe éthylhexyle et/ou l'acide éthylhexanoïque ou dans laquelle l'acide organique constituant le composant (C) est une β-dicétone.

2. Composition de conversion de couleur selon la revendication 1, dans laquelle la β-dicétone a un groupe cycloalkyle, et
dans laquelle la β-dicétone a de préférence au moins deux groupes cycloalkyle.

3. Composition de conversion de couleur selon la revendication 2, dans laquelle le groupe cycloalkyle est choisi dans le groupe constitué par un groupe cyclohexyle, un groupe cycloheptyle, un groupe cyclooctyle, un groupe norbornyle et un groupe adamantyle.

4. Composition de conversion de couleur selon l'une quelconque des revendications 1 à 3, dans laquelle le métal de transition constituant le composant (C) est Cu.

5. Composition de conversion de couleur selon la revendication 4, dans laquelle le nombre d'oxydation de Cu constituant le composant (C) est +2.

6. Composition de conversion de couleur selon l'une quelconque des revendications 1 à 5, dans laquelle le métal de transition constituant le composant (C) est Nd ou Sm, et son nombre d'oxydation est +3.

7. Composition de conversion de couleur selon l'une quelconque des revendications 1 à 6, comprenant deux ou plus des composants (C).

8. Composition de conversion de couleur selon la revendication 7, comprenant au moins un premier composant (C) et un second composant (C),
dans laquelle le métal de transition constituant le premier composant (C) est choisi dans le groupe constitué par Sc, V, Mn, Fe, Co, Cu, Y, Zr, Mo et Ag ; et
dans laquelle le métal de transition constituant le second composant (C) est un lanthanide.

9. Composition de conversion de couleur selon l'une quelconque des revendications 1 à 8, dans laquelle la quantité du composant (C) est de 1,0 x 10⁻⁵ parties en poids à 1 partie en poids pour 100 parties en poids du composant (B).

10. Composition de conversion de couleur selon la revendication 8, dans laquelle la quantité (w1) du premier composant (C) et la quantité (w2) du second composant (C) satisfont la relation w1 ≤ w2.

11. Composition de conversion de couleur selon l'une quelconque des revendications 1 à 10, dans laquelle le matériau luminescent est un matériau luminescent organique.

12. Composition de conversion de couleur selon l'une quelconque des revendications 1 à 11, dans laquelle le composant (A) contient un composé représenté par la formule (1) suivante : 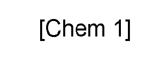 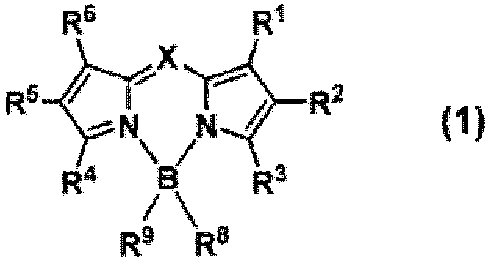 dans laquelle,
X est C-R⁷ ou N ; et
chacun de R¹ à R⁹, qui peuvent être identiques ou différents les uns des autres, est choisi parmi un atome d'hydrogène, un groupe alkyle, un groupe cycloalkyle, un groupe hétérocyclique, un groupe alcényle, un groupe cycloalcényle, un groupe alcynyle, un groupe hydroxyle, un groupe thiol, un groupe alcoxy, un groupe alkylthio, un groupe aryléther, un groupe arylthioéther, un groupe aryle, un groupe hétéroaryle, un halogène, un groupe cyano, un groupe aldéhyde, un groupe carbonyle, un groupe carboxyle, un groupe oxycarbonyle, un groupe carbamoyle, un groupe amino, un groupe nitro, un groupe silyle, un groupe siloxanyle, un groupe boryle, un groupe oxyde de phosphine, et un cycle condensé et un cycle aliphatique formés chacun entre des substituants adjacents.

13. Composition de conversion de couleur selon la revendication 12, dans laquelle, dans la formule (1), X est C-R⁷ ; et R⁷ est un groupe représenté par la formule (2) suivante : 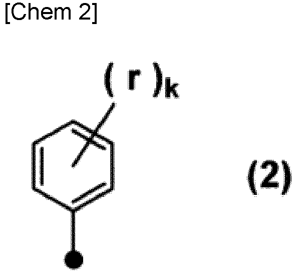 dans laquelle,
r est choisi dans le groupe constitué par un atome d'hydrogène, un groupe alkyle, un groupe cycloalkyle, un groupe hétérocyclique, un groupe alcényle, un groupe cycloalcényle, un groupe alcynyle, un groupe hydroxyle, un groupe thiol, un groupe alcoxy, un groupe alkylthio, un groupe aryléther, un groupe arylthioéther, un groupe aryle, un groupe hétéroaryle, un halogène, un groupe cyano, un groupe aldéhyde, un groupe carbonyle, un groupe carboxyle, un groupe oxycarbonyle, un groupe carbamoyle, un groupe amino, un groupe nitro, un groupe silyle, un groupe siloxanyle, un groupe boryle et un groupe oxyde de phosphine ;
k est un nombre entier de 1 à 3 ; et
lorsque k vaut 2 ou plus, les r peuvent être identiques ou différents les uns des autres.

14. Composition de conversion de couleur selon l'une quelconque des revendications 1 à 11, dans laquelle le composant (A) est un composé qui émet une fluorescence retardée.

15. Composition de conversion de couleur selon la revendication 14, dans laquelle le composé qui émet une fluorescence retardée est un composé représenté par la formule (11) suivante : 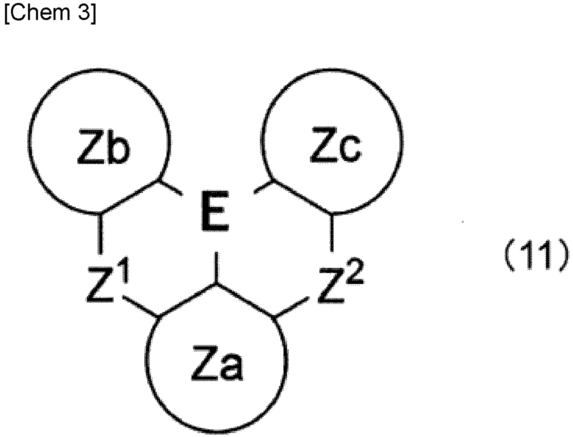 dans laquelle,
chacun du cycle Za, du cycle Zb et du cycle Zc est indépendamment un cycle aryle substitué ou non substitué ayant un nombre d'atomes de carbone formant un cycle de 6 à 30, ou un cycle hétéroaryle substitué ou non substitué ayant un nombre d'atomes de carbone formant un cycle de 6 à 30 ;
chacun de Z¹ et Z² est indépendamment un atome d'oxygène, NRa (un atome d'azote ayant un substituant Ra), ou un atome de soufre ;
lorsque Z¹ est NRa, Ra peut ou ne peut pas être lié au cycle Za ou au cycle Zb pour former un cycle ; et lorsque Z² est NRa, Ra peut ou ne peut pas être lié au cycle Za ou au cycle Zc pour former un cycle ;
chaque Ra est indépendamment un groupe aryle substitué ou non substitué, un groupe hétéroaryle substitué ou non substitué, ou un groupe alkyle substitué ou non substitué ;
E est un atome de bore, un atome de phosphore, SiRb (un atome de silicium ayant un substituant Rb), P=O, ou P=S ; et
chaque Rb est indépendamment un groupe aryle substitué ou non substitué, un groupe hétéroaryle substitué ou non substitué, ou un groupe alkyle substitué ou non substitué.

16. Composition de conversion de couleur selon l'une quelconque des revendications 1 à 15, dans laquelle le composant (A) contient au moins l'un des matériaux luminescents (a) et (b) suivants :
(a) un matériau luminescent qui émet une lumière ayant une longueur d'onde de crête observée dans la région de 500 à 580 nm en utilisant une lumière d'excitation ayant une longueur d'onde de 430 à 500 nm, et
(b) un matériau luminescent qui émet une lumière ayant une longueur d'onde de crête observée dans la région de 580 à 750 nm lorsqu'il est excité par l'une ou les deux parmi une lumière d'excitation ayant une longueur d'onde de 430 à 500 nm et une lumière émise par le matériau luminescent (a).

17. Film de conversion de couleur comprenant la composition de conversion de couleur selon l'une quelconque des revendications 1 à 16, ou un produit durci de celle-ci.

18. Film de conversion de couleur selon la revendication 17, la quantité d'un solvant contenu dans la composition de conversion de couleur ou le produit durci de celle-ci est de 0,01 % en poids à 3,0 % en poids.

19. Unité de source de lumière comprenant une source de lumière, et la composition de conversion de couleur selon l'une quelconque des revendications 1 à 16 ou le film de conversion de couleur selon la revendication 20 ou 21.

20. Unité de source de lumière selon la revendication 19, dans laquelle la source de lumière est une diode électroluminescente ayant une émission de lumière maximale dans la plage de 430 nm à 500 nm.

21. Affichage comprenant l'unité de source de lumière selon la revendication 19 ou 20.

22. Éclairage comprenant l'unité de source de lumière selon la revendication 19 ou 20.

23. Composé ayant une structure représentée par la formule (3) suivante : 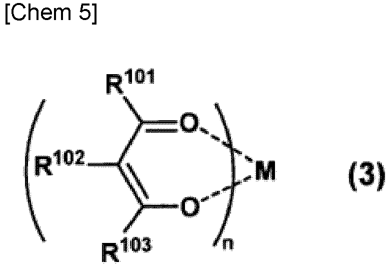 dans laquelle,
chacun de R¹⁰¹ à R^{103,} qui peuvent être identiques ou différents les uns des autres, est choisi parmi un atome d'hydrogène, un groupe alkyle, un groupe cycloalkyle, un groupe hétérocyclique, un groupe alcényle, un groupe cycloalcényle, un groupe alcynyle, un groupe hydroxyle, un groupe thiol, un groupe alcoxy, un groupe alkylthio, un groupe aryléther, un groupe arylthioéther, un groupe aryle, un groupe hétéroaryle, un halogène, un groupe cyano, un groupe aldéhyde, un groupe carbonyle, un groupe carboxyle, un groupe oxycarbonyle, un groupe carbamoyle, un groupe amino, un groupe nitro, un groupe silyle, un groupe siloxanyle, un groupe boryle, un groupe oxyde de phosphine, et un cycle condensé et un cycle aliphatique formés chacun entre des substituants adjacents ;
à condition que les conditions (A) et (B) suivantes soient satisfaites :
condition (A) : l'un de R¹⁰¹ à R¹⁰³ est un groupe cycloalkyle (a) ayant un nombre d'atomes de carbone de 6 ou plus ; et
condition (B) : au moins l'un des autres que la condition (A) est choisi parmi un groupe aryle, un groupe cycloalkyle, un groupe cycloalcényle, un groupe hétérocyclique aliphatique et un groupe alkyle ayant un nombre d'atomes de carbone de 5 ou plus ;
M est choisi dans le groupe constitué par Sc, V, V=O, Mn, Ni, Cu, Zr, O=Mo=O et Ag ; et
n est un nombre entier de 2 à 4.

24. Composé selon la revendication 23, dans lequel, dans la formule (3), M est Cu et n vaut 2.
